# EUROPEAN PATENT APPLICATION

(11) **EP 4 851 226 A1**
(43) Date of publication of application: **09.12.2026**
(21) Application number: 25752268.0
(22) Date of filing: 07.02.2025
(51) Int. Cl.: C08G 77/04, C07F 7/18, C08K 3/10, C08L 83/04, C09K 3/18, G02B 1/12, G02B 1/14

(54) **COMPOSITION CONTAINING SILANE COMPOUND**

(30) Priority: 09.02.2024 JP 2024018826
(71) Applicant: DAIKIN INDUSTRIES, LTD., Osaka-shi, Osaka 530-0001 (JP)
(72) Inventor: TAKANO, Shinya, Osaka-Shi, Osaka 530-0001 (JP); HARA, Manami, Osaka-Shi, Osaka 530-0001 (JP); NOMURA, Takashi, Osaka-Shi, Osaka 530-0001 (JP)
(74) Representative: Hoffmann Eitle
(86) International application number: PCT/JP2025/004148
(87) International publication number: WO 2025/170045

(57) **Abstract**

An object of the present disclosure is to provide a composition that can allow a surface-treating layer favorable in abrasion durability to be realized.

A composition comprising a silane compound and a transition metal, wherein
the silane compound comprises one, or two or more of compounds selected from the following formula (1) or (2):

R^{A1}_{α}-X^{A}-R^{Si}_{β} (1)

R^{Si}_{γ}-X^{A}-R^{A2}-X^{A}-R^{Si}_{γ} (2)

wherein
R^{A1} represents a monovalent group comprising one or more Si atoms to which neither a hydroxyl group nor a hydrolyzable group is directly bonded, or a hydrocarbon group,
R^{A2} each independently represents a divalent group comprising one or more Si atoms to which neither a hydroxyl group nor a hydrolyzable group is directly bonded,
R^{Si} represents a monovalent group comprising a Si atom to which a hydroxyl group or a hydrolyzable group is bonded,
X^{A} represents a single bond, or a di- to decavalent group,
α represents an integer of 1 to 9,
β represents an integer of 1 to 9, and
y represents an integer of 1 to 9; and
a content of the transition metal is 0.001 mol or more and 2.00 mol or less based on 100 mol of the silane compound.

## Description

### Technical Field

The present disclosure relates to a composition comprising a silane compound.

### Background Art

Certain types of silane compounds are known to be capable of providing excellent water- and oil-repellency when used in surface treatment of a substrate (Patent Literature 1).

### Citation List

### Patent Literature

Patent Literature 1: WO 2015/087903

### Summary of Invention

### Technical Problem

An object of the present disclosure is to provide a composition that can allow a surface-treating layer favorable in abrasion durability to be realized.

### Solution to Problem

The present disclosure comprises the following embodiments.
[1] A composition comprising a silane compound and a transition metal, wherein
   the silane compound comprises one, or two or more of compounds selected from the following formula (1) or (2):

   R^{A1}_{α}-X^{A}-R^{Si}_{β} (1)

   R^{Si}_{γ}-X^{A}-R^{A2}-X^{A}-R^{Si}_{γ} (2)

   wherein
   R^{A1} represents a monovalent group comprising one or more Si atoms to which neither a hydroxyl group nor a hydrolyzable group is directly bonded, or a hydrocarbon group,
   R^{A2} each independently represents a divalent group comprising one or more Si atoms to which neither a hydroxyl group nor a hydrolyzable group is directly bonded,
   R^{Si} represents a monovalent group comprising a Si atom to which a hydroxyl group or a hydrolyzable group is bonded,
   X^{A} represents a single bond, or a di- to decavalent group,
   α represents an integer of 1 to 9,
   β represents an integer of 1 to 9, and
   γ represents an integer of 1 to 9; and
   a content of the transition metal is 0.001 mol or more and 2.00 mol or less based on 100 mol of the silane compound.
[2] The composition according to [1], wherein the silane compound comprises a compound in which R^{A1} is a group represented by the following formula (A1), (A2), (A3), (A4), (A5) or (A6):

   R^{1a}-R^{S}-SiR^{2a}₂- (A1)

   R^{3a}-X^{1a}- (A2)

   R^{7a}-[(SiR^{8a}_{2O})ₙ-SiR^{8a}₂]ₙₐ- (A3)

   R^{11a}-(R^{S})γ1-(SiR^{12a}₂)_{γ2}-R^{Ar}- (A4)

   R^{13a}-(SiR^{14a}2O)ₙ-SiR^{14a}₂- (A5)

   R^{17a}-R^{S}-(SiR^{18a}₂)ₛ- (A6)

   wherein, in the formula (A1),
   R^{1a} represents a hydrocarbon group,
   R^{2a} represents a hydrocarbon group,
   R^{S} is each independently a group represented by the following formula: 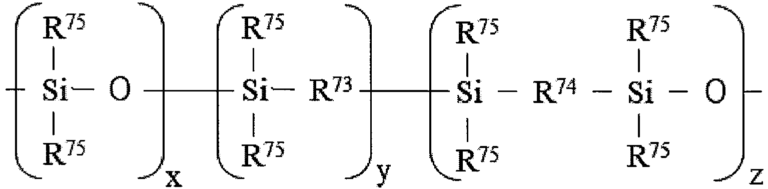 (wherein
   R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
      R⁷⁶ is each independently a C₁₋₆ alkylene group,
      R⁷⁷ is each independently an optionally substituted arylene group,
      R⁷⁸ is each independently a single bond or a C₁₋₆ alkylene group,
      R⁷⁹ is each independently a single bond or an oxygen atom,
   R⁷⁵ is each independently a hydrocarbon group,
   x is an integer of 0 to 500,
   y is an integer of 0 to 500,
   z is an integer of 0 to 500,
   x + y + z is 1 or more, and
   the occurrence order of the respective repeating units enclosed in parentheses provided with x, y, or z is not limited in the formula);
   in the formula (A2),
   R^{3a} represents R^{4a}-O-CO-, R^{4a}-CO-O-, R^{4a}-O-C(=O)-O-, R^{4a}-NR-CO-, R^{4a}-CO-NR-, R^{4a}-OCO-NR^{5a}- , R^{4a}-NR^{5a}-COO-, R^{4a}-NR^{5a}-CO-NR^{5a}-, CH₂=CH-, NHR^{5a}-, CR^{5a}₃-, CHR^{6a}- or a halogen atom,
   R^{4a} represents a hydrogen atom, a C₁₋₆ alkyl group, or an oxyalkylene-comprising group having 1 to 30 carbon atoms,
   R^{5a} represents a hydrogen atom or a C₁₋₆ alkyl group,
   R^{6a} represents a halogen atom, and
   X^{1a} represents an alkylene group having 12 or more carbon atoms;
   in the formula (A3),
   R^{7a} each independently represents a C₁₋₁₂ alkyl group, or the following group A or group B,
   the group A and the group B are each a group represented by the following formula:

      R⁵¹ₙₐR⁵²₃₋ₙₐSi-(O)_{z}- (A)

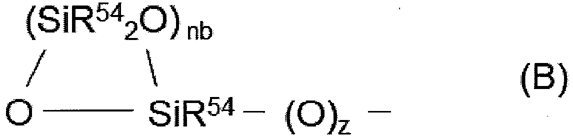

      wherein
   R⁵¹ is each independently a group represented by -(R⁶¹-SiR⁵³₂)ₘₐ-R⁵³,
      R⁶¹ is each independently an oxygen atom or a C₁₋₆ alkylene group,
      R⁵³ is each independently a hydrocarbon group or R^{51'},
         R^{51'} has the same meaning as R⁵¹,
      ma is each independently an integer of 1 to 5,
   provided that the number of R^{51'} in R⁵¹ is 20 or less,
   R⁵² is each independently a hydrocarbon group,
   na is an integer of 1 to 3,
   R⁵⁴ is each independently a hydrocarbon group,
   nb is an integer of 1 to 5, and
   z is 0 or 1;
   R^{8a} is each independently a C₁₋₁₂ alkyl group,
   n is 1 to 1,500, and
   na is each independently 0 or 1;
   in the formula (A4),
   R^{11a} represents a monovalent group comprising one or more Si atoms to which neither a hydroxyl group nor a hydrolyzable group is directly bonded, or a hydrocarbon group,
   R^{S} has the same meaning as above,
   R^{12a} represents a hydrocarbon group,
   R^{Ar} represents a divalent aromatic hydrocarbon group,
   γ1 is 0 or 1, and
   γ2 is 0 or 1;
   in the formula (A5),
   R^{13a} represents a C₁₋₁₂ alkyl group,
   R^{14a} each independently represents a C₁₋₁₂ alkyl group, and
   n is an integer of 1 to 1,500; and
   in the formula (A6),
   R^{17a} is a hydrocarbon group, or R^{18a}ₙₐ₁R^{19a}₃₋ₙₐ₁Si-(O)_{z}-,
      R^{18a} is a group represented by R^{21a}-(SiR^{21a}₂-R^{20a})ₘₐ₁-,
      R^{20a} is an oxygen atom, or a C₁₋₆ alkylene group,
      R^{21a} is a hydrocarbon group or R^{18a'},
      R^{18a'} has the same meaning as R^{18a},
      ma1 is each independently an integer of 1 to 5,
      provided that the number of R^{18a'} in R^{18a} is 20 or less,
   R^{19a} is each independently a hydrocarbon group,
   na1 is an integer of 1 to 3,
   z is 0 or 1,
   s is 0 or 1, and
   R^{S} has the same meaning as above.
[3] The composition according to [1] or [2], wherein the silane compound comprises a compound in which R^{A1} is an alkyl group having 7 or more carbon atoms.
[4] The composition according to any one of [1] to [3], wherein
   X^{A} is a di- to decavalent group comprising a partial structure selected from a single bond, a C₁₋₆₀ alkylene group, -CO-, -COO-, -OCO-, -NR⁴¹-, -CONR⁴¹-, - NR⁴¹CO-, -OCONR⁴¹-, -NR⁴¹COO-, -NR⁴¹-CO-NR⁴¹-, -O-, -S-, -CON= or R^{S},
      R⁴¹ is a hydrogen atom, an oxyalkylene-containing group or a C₁₋₆ alkyl group, and
      R^{S} is a group represented by the following formula: 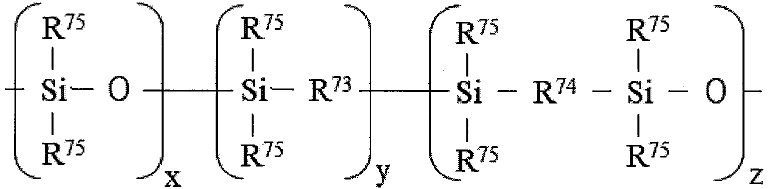 wherein
   R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
      R⁷⁶ is each independently a C₁₋₆ alkylene group,
      R⁷⁷ is each independently an optionally substituted arylene group,
      R⁷⁸ is each independently a single bond or a C₁₋₆ alkylene group,
      R⁷⁹ is each independently a single bond or an oxygen atom,
   R⁷⁵ is each independently a hydrocarbon group,
   x is an integer of 0 to 500,
   y is an integer of 0 to 500,
   z is an integer of 0 to 500,
   x + y + z is 1 or more, and
   the occurrence order of the respective repeating units enclosed in parentheses provided with x, y, or z is not limited in the formula.
[5] The composition according to any one of [1] to [4], wherein X^{A} is a group represented by the following formula:

   -(X¹²¹)ₐ₀-X¹¹⁰-[(X¹¹¹)ₐ₁-(X¹¹²)ₐ₂]-

   wherein
   X¹²¹ is -R¹⁶¹_{b1}R⁶²_{3-b1}C-, -R¹⁶³_{b2}R¹⁶⁴_{3-b2}Si-, or -R¹⁶⁵N-,
      R¹⁶¹ is each independently a single bond or a divalent organic group,
      R¹⁶² is a hydrogen atom or a monovalent organic group,
      R¹⁶³ is each independently a single bond or a divalent organic group,
      R¹⁶⁴ is a hydrogen atom or a monovalent organic group,
      R¹⁶¹ is each independently a single bond or a divalent organic group,
      b1 is 2 or 3,
      b2 is 2 or 3,
   X¹¹⁰ is a single bond or an alkylene group having 1 or more carbon atoms,
   X¹¹¹ is a single bond or a divalent organic group,
   X¹¹² is -CO-, -COO-, -OCO-, -NR⁴¹-, -CONR⁴¹-, -NR⁴¹CO-, -OCONR⁴¹-, - NR⁴¹COO-, -NR⁴¹-CO-NR⁴¹-, -O-, -S-, -CON= or R^{S},
      R⁴¹ is a hydrogen atom, an oxyalkylene-containing group or a C₁₋₆ alkyl group,
      R^{S} is a group represented by the following formula: 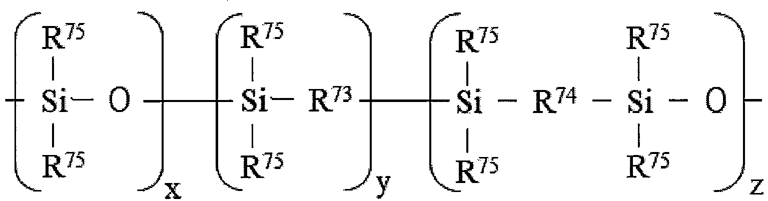 (wherein
   R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
      R⁷⁶ is each independently a C₁₋₆ alkylene group,
      R⁷⁷ is each independently an optionally substituted arylene group,
      R⁷⁸ is each independently a single bond or a C₁₋₆ alkylene group,
      R⁷⁹ is each independently a single bond or an oxygen atom,
   R⁷⁵ is each independently a hydrocarbon group,
   x is an integer of 0 to 500,
   y is an integer of 0 to 500,
   z is an integer of 0 to 500,
   x + y + z is 1 or more, and
   the occurrence order of the respective repeating units enclosed in parentheses provided with x, y, or z is not limited in the formula),
   a0 is 0 or 1,
   a1 is an integer of 1 to 5,
   a2 is an integer of 0 to 5, and
   the occurrence order of the respective repeating units enclosed in parentheses provided with a1 or a2 is not limited in the formula; or
   a group represented by formula (X^{A1}): 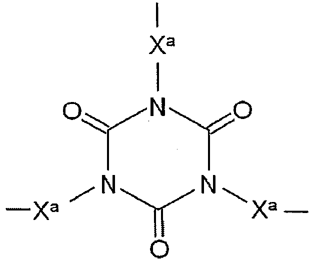 wherein X^{a} is each independently a single bond or a divalent linking group.
[6] The composition according to any one of [1] to [5], wherein R^{Si} is a group represented by the following formula (S1), (S2), (S3), (S4) or (S5):

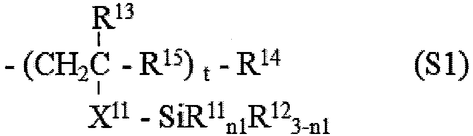

   -SiR¹¹ₙ₁R¹²₃₋ₙ₁ (S2)

   -SiR^{a1}ₖ₁R^{b1}ₗ₁R^{c1}ₘ₁ (S3)

   -CR^{d1}ₖ₂R^{e1}ₗ₂R^{f1}ₘ₂ (S4)

   -NR^{g1}R^{h1} (S5)

   wherein
   R¹¹ is each independently a hydroxyl group or a hydrolyzable group,
   R¹² is each independently a monovalent organic group,
   n1 is each independently an integer of 0 to 3 for each (SiR¹¹ₙ₁R¹²₃₋ₙ₁) unit,
   X¹¹ is each independently a single bond or a divalent organic group,
   R¹³ is each independently a hydrogen atom or a monovalent organic group,
   t is each independently an integer of 2 or more,
   R¹⁴ is each independently a hydrogen atom, a halogen atom or -X¹¹-SiR¹¹ₙ₁R¹²₃₋ₙ₁,
   R¹⁵ is each independently a single bond, an oxygen atom, an alkylene group having 1 to 6 carbon atoms or an alkyleneoxy group having 1 to 6 carbon atoms,
   R^{a1} is each independently -Z¹-SiR²¹ₚ₁R²²_{q1}R²³ᵣ₁;
   Z¹ is each independently a divalent organic group,
   R²¹ is each independently -Z^{1'}-SiR^{21'}_{p1'}R^{22'}_{q1'}R^{23'}_{r1'};
   R²² is each independently a hydroxyl group or a hydrolyzable group,
   R²³ is each independently a monovalent organic group,
   p1 is each independently an integer of 0 to 3,
   q1 is each independently an integer of 0 to 3,
   r1 is each independently an integer of 0 to 3,
   Z^{1'} is each independently a divalent organic group,
   R^{21'} is each independently -Z^{1"}-SiR^{22"}_{q1"}R^{23"}_{r1"};
   R^{22'} is each independently a hydroxyl group or a hydrolyzable group,
   R^{23'} is each independently a monovalent organic group,
   p1' is each independently an integer of 0 to 3,
   q1' is each independently an integer of 0 to 3,
   r1' is each independently an integer of 0 to 3,
   Z^{1"} is each independently a divalent organic group,
   R^{22"} is each independently a hydroxyl group or a hydrolyzable group,
   R^{23"} is each independently a monovalent organic group,
   q1^{"} is each independently an integer of 0 to 3,
   r1" is each independently an integer of 0 to 3,
   R^{b1} is each independently a hydroxyl group or a hydrolyzable group,
   R^{c1} is each independently a monovalent organic group,
   k1 is each independently an integer of 0 to 3,
   l1 is each independently an integer of 0 to 3,
   m1 is each independently an integer of 0 to 3,
   provided that, in the formula (S3), at least two Si atoms to which a hydroxyl group or a hydrolyzable group is bonded are present,
   R^{d1} is each independently -Z²-CR³¹ₚ₂R³²₉₂R³³ᵣ₂,
   Z² is each independently a single bond, an oxygen atom or a divalent organic group,
   R³¹ is each independently -Z^{2'}-CR³²'_{q2'}R^{33'}_{r2'},
   R³² is each independently -Z³-SiR³⁴ₙ₂R³⁵₃₋ₙ₂,
   R³³ is each independently a hydrogen atom, a hydroxyl group or a monovalent organic group,
   p2 is each independently an integer of 0 to 3,
   q2 is each independently an integer of 0 to 3,
   r2 is each independently an integer of 0 to 3,
   Z^{2'} is each independently a single bond, an oxygen atom or a divalent organic group,
   R^{32'} is each independently -Z³-SiR³⁴ₙ₂R³⁵₃₋ₙ₂,
   R^{33'} is each independently a hydrogen atom, a hydroxyl group or a monovalent organic group,
   q2' is each independently an integer of 0 to 3,
   r2' is each independently an integer of 0 to 3,
   Z³ is each independently a single bond, an oxygen atom or a divalent organic group;
   R³⁴ is each independently a hydroxyl group or a hydrolyzable group,
   R³⁵ is each independently a monovalent organic group,
   n2 is each independently an integer of 0 to 3,
   R^{e1} is each independently -Z³-SiR³⁴ₙ₂R³⁵₃₋ₙ₂,
   R^{f1} is each independently a hydrogen atom, a hydroxyl group or a monovalent organic group,
   k2 is each independently an integer of 0 to 3,
   l2 is each independently an integer of 0 to 3,
   m2 is each independently an integer of 0 to 3,
   provided that, in the formula (S4), at least two Si atoms to which a hydroxyl group or a hydrolyzable group is bonded are present,
   R^{g1} and R^{h1} are each independently -Z⁴-SiR^{l1}ₙ₁R^{l2}₃₋ₙ₁, -Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂, and
   Z⁴ is each independently a single bond, an oxygen atom or a divalent organic group,
   provided that, in the formula (S5), at least two Si atoms to which a hydroxyl group or a hydrolyzable group is bonded are present.
[7] The composition according to any one of [1] to [6], wherein the transition metal is comprised as a transition metal catalyst acting as a catalyst for hydrosilylation.
[8] The composition according to any one of [1] to [7], wherein the transition metal is comprised as one or more selected from a nickel compound, a palladium compound, a platinum compound, a rhodium compound, a ruthenium compound, a cobalt compound and an iron compound.
[9] The composition according to any one of [1] to [8], wherein the transition metal is comprised as a platinum compound.
[10] The composition according to any one of [1] to [10], wherein the silane compound comprises a compound selected from the following group:

   CH₃-[Si(CH₃)₂O]ₙ₁Si(CH₃)₂-(CH₂)_{H1}-C(=O)NHCH₂CH₂CH₂Si(OCH₃)₃

   CH₃CH₂CH₂CH₂-[Si(CH₃)₂O]ₙ₁Si(CH₃)₂-(CH₂)_{H1}-C(=O)NHCH₂CH₂CH₂Si(OCH₃)₃

   [(CH₃)₃SiO)₂(CH₃)Si-O-[Si(CH₃)₂O]ₙ₁Si(CH₃)₂-(CH₂)_{H1}- C(=O)NHCH₂CH₂CH₂Si(OCH₃)₃

   [(CH₃)₃SiO)]₃Si-O-[Si(CH₃)₂O]ₙ₁Si(CH₃)₂-(CH₂)_{H1}- C(=O)NHCH₂CH₂CH₂Si(OCH₃)₃

   CH₃-[Si(CH₃)₂O]ₙ₁Si(CH₃)₂-(CH₂)_{H1}-O-(CH₂)_{H2}-C(=O)NHCH₂CH₂CH₂Si(OCH₃)₃

   CH₃CH₂CH₂CH₂-[Si(CH₃)₂O]ₙ₁Si(CH₃)₂-(CH₂)_{H1}-O-(CH₂)_{H2}- C(=O)NHCH₂CH₂CH₂Si(OCH₃)₃

   CH₃-[Si(CH₃)₂O]ₙ₁Si(CH₃)₂-(CH₂)_{H1}-Si(OCH₃)₃

   CH₃CH₂CH₂CH₂-[Si(CH₃)₂O]ₙ₁Si(CH₃)₂-(CH₂)_{H1}-Si(OCH₃)₃

   [(CH₃)₃SiO)]₂(CH₃)Si-O-[Si(CH₃)₂O]ₙ₁Si(CH₃)₂-(CH₂)_{H1}-Si(OCH₃)₃

   [(CH₃)₃SiO)]₃Si-O-[Si(CH₃)₂O]ₙ₁Si(CH₃)₂-(CH₂)_{H1}-Si(OCH₃)₃

   CH₃-[Si(CH₃)₂O]ₙ₁Si(CH₃)₂-(CH₂)_{H1}-C(=O)NHCH₂CH[CH₂CH₂CH₂Si(OCH₃)₃]₂

   CH₃CH₂CH₂CH₂-[Si(CH₃)₂O]ₙ₁Si(CH₃)₂-(CH₂)_{H1}- C(=O)NHCH₂CH[CH₂CH₂CH₂Si(OCH₃)₃]₂

   [(CH₃)₃SiO)]₂(CH₃)Si-O-[Si(CH₃)₂O]ₙ₁Si(CH₃)₂-(CH₂)_{H1}- C(=O)NHCH₂CH[CH₂CH₂CH₂Si(OCH₃)₃]₂

   [(CH₃)₃SiO)]₃Si-O-[Si(CH₃)₂O]ₙ₁Si(CH₃)₂-(CH₂)_{H1}- C(=O)NHCH₂CH₁CH₂CH₂CH₂Si(OCH₃)₃]₂

   CH₃-[Si(CH₃)₂O]ₙ₁Si(CH₃)₂-(CH₂)_{H1}-O-(CH₂)_{H2}- C(=O)NHCH₂CH[CH₂CH₂CH₂Si(OCH₃)₃]₂

   CH₃CH₂CH₂CH₂-[Si(CH₃)2O]ₙ₁Si(CH₃)₂-(CH₂)_{H1}-O-(CH₂)_{H2}- C(=O)NHCH₂CH[CH₂CH₂CH₂Si(OCH₃)₃]₂

   CH₃-[Si(CH₃)₂O]ₙ₁Si(CH₃)₂-(CH₂)_{H1}-CH[CH₂CH₂CH₂Si(OCH₃)₃]₂

   CH₃CH₂CH₂CH₂-[Si(CH₃)₂O]ₙ₁Si(CH₃)₂-(CH₂)_{H1}-CH[CH₂CH₂CH₂Si(OCH₃)₃]₂

   [(CH₃)₃SiO)]₂(CH₃)Si-O-[Si(CH₃)₂O]ₙ₁Si(CH₃)₂-(CH₂)_{H1}- CH[CH₂CH₂CH₂Si(OCH₃)₃]₂

   [(CH₃)₃SiO)₃Si-O-[Si(CH₃)₂O]ₙ₁Si(CH₃)₂-(CH₂)_{H1}-CH[CH₂CH₂CH₂Si(OCH₃)₃]₂

   CH₃-[Si(CH₃)₂O]ₙ₁Si(CH₃)₂-(CH₂)_{H1}-

   C(=O)NHCH₂CH[CH₂CH₂CH₂CH₂CH₂CH₂CH₂CH₂CH₂CH₂CH₂Si(OCH₃)₃]₂

   CH₃CH₂CH₂CH₂-[Si(CH₃)₂O]ₙ₁Si(CH₃)₂-(CH₂)_{H1}-

   C(=O)NHCH₂CH[CH₂CH₂CH₂CH₂CH₂CH₂CH₂CH₂CH₂CH₂CH₂Si(OCH₃)₃]₂

   [(CH₃)₃SiO)]₂(CH₃)Si-O-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂

   [(CH₃)₃SiO)]₃Si-O-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂

   CH₃-[Si(CH₃)₂O]ₙ₁Si(CH₃)₂-(CH₂)_{H1}-O-(CH₂)_{H2}- C(=O)NHCH₂CH[CH₂CH₂CH₂CH₂CH₂CH₂CH₂CH₂CH₂CH₂CH₂Si(OCH₃)₃]₂

   CH₃CH₂CH₂CH₂-[Si(CH₃)₂O]ₙ₁Si(CH₃)₂-(CH₂)_{H1}-O-(CH₂)_{H2}- C(=O)NHCH₂CH[CH₂CH₂CH₂CH₂CH₂CH₂CH₂CH₂CH₂CH₂CH₂Si(OCH₃)₃]₂

   CH₃-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

   CH₃CH₂CH₂CH₂-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

   [(CH₃)₃SiO)]₂(CH₃)Si-O-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

   [(CH₃)₃SiO)]₃Si-O-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

   CH₃-[Si(CH₃)₂O]ₙ₁Si(CH₃)₂-(CH₂)_{H1}-C(=O)N[CH₂CH₂CH₂Si(OCH₃)₃]₂

   CH₃CH₂CH₂CH₂-[Si(CH₃)₂O]ₙ₁Si(CH₃)₂-(CH₂)_{H1}-C(=O)N[CH₂CH₂CH₂Si(OCH₃)₃]₂

   [(CH₃)₃SiO)]₂(CH₃)Si-O-[Si(CH₃)₂O]ₙ₁Si(CH₃)₂-(CH₂)_{H1}- C(=O)N[CH₂CH₂CH₂Si(OCH₃)₃]₂

   [(CH₃)₃SiO)1₃Si-O-[Si(CH₃)₂0],ₗ Si(CH₃)₂-(CH₂)_{Hl}- C(=O)N[CH₂CH₂CH₂Si(OCH₃)₃]₂

   CH₃-[SiCCH₃)₂O]ₙ₁Si(CH₃)₂-(CH₂)_{H1}-O-(CH₂)_{H2}-C(=O)N[CH₂CH₂CH₂Si(OCH₃)₃]₂

   CH₃CH₂CH₂CH₂-[Si(CH₃)₂O]ₙ₁Si(CH₃)₂-(CH₂)_{H1}-O-(CH₂)_{H2}- C(=O)N[CH₂CH₂CH₂Si(OCH₃)₃]₂

   CH₃-[Si(CH₃)₂O]ₙ₁Si(CH₃)₂-(CH₂)_{H1}-N[CH₂CH₂CH₂Si(OCH₃)₃]₂

   CH₃CH₂CH₂CH₂-[Si(CH₃)₂O]ₙ₁Si(CH₃)₂-(CH₂)_{H1}-N[CH₂CH₂CH₂Si(OCH₃)₃]₂

   [(CH₃)₃SiO)]₂(CH₃)Si-O-[Si(CH₃)₂O]ₙ₁Si(CH₃)₂-(CH₂)_{H1}- N[CH₂CH₂CH₂Si(OCH₃)₃]₂

   [(CH₃)₃SiO)]₃Si-O-[Si(CH₃)₂O]ₙ₁Si(CH₃)₂-(CH₂)_{H1}-N[CH₂CH₂CH₂Si(OCH₃)₃]₂

   CH₃-[Si(CH₃)₂O]ₙ₁Si(CH₃)₂-(CH₂)_{H1}-C(=O)NHCH₂C[CH₂CH₂CH₂Si(OCH₃)₃]₃

   CH₃CH₂CH₂CH₂-[Si(CH₃)₂O]ₙ₁Si(CH₃)₂-(CH₂)_{H1}- C(=O)NHCH₂C[CH₂CH₂CH₂Si(OCH₃)₃]₃

   [(CH₃)₃SiO)]₂(CH₃)Si-O-[Si(CH₃)₂O]ₙ₁Si(CH₃)₂-(CH₂)_{H1}- C(=O)NHCH₂C[CH₂CH₂CH₂Si(OCH₃)₃]₃

   [(CH₃)₃SiO)]₃Si-O-[Si(CH₃)₂O]ₙ₁Si(CH₃)₂-(CH₂)_{H1}- C(=O)NHCH₂C[CH₂CH₂CH₂Si(OCH₃)₃]₃

   CH₃-[Si(CH₃)₂O]ₙ₁Si(CH₃)₂-(CH₂)_{H1}-O-(CH₂)_{H2}- C(=O)NHCH₂C[CH₂CH₂CH₂Si(OCH₃)₃]₃

   CH₃CH₂CH₂CH₂-[Si(CH₃)₂O]ₙ₁Si(CH₃)₂-(CH₂)_{H1}-O-(CH₂)_{H2}- C(=O)NHCH₂C[CH₂CH₂CH₂Si(OCH₃)₃]₃

   CH₃-[Si(CH₃)₂O]ₙ₁Si(CH₃)₂-(CH₂)_{H1}-C[CH₂CH₂CH₂Si(OCH₃)₃]₃

   CH₃CH₂CH₂CH₂-[Si(CH₃)₂O]ₙ₁Si(CH₃)₂-(CH₂)_{H1}-C[CH₂CH₂CH₂Si(OCH₃)₃]₃

   [(CH₃)₃SiO)]₂(CH₃)Si-O-[Si(CH₃)₂O]ₙ₁Si(CH₃)₂-(CH₂)_{H1}- C[CH₂CH₂CH₂Si(OCH₃)₃]₃

   [(CH₃)₃SiO)₃Si-O-[Si(CH₃)₂O]ₙ₁Si(CH₃)₂-(CH₂)_{H1}-C[CH₂CH₂CH₂Si(OCH₃)₃]₃

   [(CH₃)₃SiO)]₂(CH₃)Si-(CH₂)_{H1}-C(=O)NHCH₂CH₂CH₂Si(OCH₃)₃

   [(CH₃)₃SiO)]₃Si-(CH₂)_{H1}-C(=O)NHCH₂CH₂CH₂Si(OCH₃)₃

   [(CH₃)₃SiO)]₂(CH₃)Si-(CH₂)_{H1}-Si(OCH₃)₃

   [(CH₃)₃SiO)]₃Si-(CH₂)_{H1}-Si(OCH₃)₃

   [(CH₃)₃SiO)]₂(CH₃)Si-(CH₂)_{H1}-C(=O)NHCH₂CH[CH₂CH₂CH₂Si(OCH₃)₃]₂

   [(CH₃)₃SiO)]₃Si-(CH₂)_{H1}-C(=O)NHCH₂CH[CH₂CH₂CH₂Si(OCH₃)₃]₂

   [(CH₃)₃SiO)]₂(CH₃)Si-(CH₂)_{H1}-CH[CH₂CH₂CH₂Si(OCH₃)₃]₂

   [(CH₃)₃SiO)]₃Si-(CH₂)_{H1}-CH[CH₂CH₂CH₂Si(OCH₃)₃]₂

   [(CH₃)₃SiO)]₂(CH₃)Si-(CH₂)_{H1}- C(=O)NHCH₂CH[CH₂CH₂CH₂CH₂CH₂CH₂CH₂CH₂CH₂CH₂CH₂Si(OCH₃)₃]₂

   [(CH₃)₃SiO)]₃Si-(CH₂)_{H1}- C(=O)NHCH₂CH[CH₂CH₂CH₂CH₂CH₂CH₂CH₂CH₂CH₂CH₂CH₂Si(OCH₃)₃]₂

   [(CH₃)₃SiO)]₂(CH₃)Si-(CH₂)_{H1}- CH[CH₂CH₂CH₂CH₂CH₂CH₂CH₂CH₂CH₂CH₂CH₂Si(OCH₃)₃]₂

   [(CH₃)₃SiO)]₃Si-(CH₂)_{H1}- CH[CH₂CH₂CH₂CH₂CH₂CH₂CH₂CH₂CH₂CH₂CH₂Si(OCH₃)₃]₂

   [(CH₃)₃SiO)]₂(CH₃)Si-(CH₂)_{H1}-C(=O)N[CH₂CH₂CH₂Si(OCH₃)₃]₂

   [(CH₃)₃SiO)₃Si-(CH₂)_{H1}-C(=O)N[CH₂CH₂CH₂Si(OCH₃)₃]₂

   [(CH₃)₃SiO)]₂(CH₃)Si-(CH₂)_{H1}-N[CH₂CH₂CH₂Si(OCH₃)₃]₂

   [(CH₃)₃SiO)]₃Si-(CH₂)_{H1}-N[CH₂CH₂CH₂Si(OCH₃)₃]₂

   [(CH₃)₃SiO)]₂(CH₃)Si-(CH₂)_{H1}-C(=O)NHCH₂C[CH₂CH₂CH₂Si(OCH₃)₃]₃

   [(CH₃)₃SiO)]₃Si-(CH₂)_{H1}-C(=O)NHCH₂C[CH₂CH₂CH₂Si(OCH₃)₃]₃

   [(CH₃)₃SiO)]₂(CH₃)Si-(CH₂)_{H1}-C[CH₂CH₂CH₂Si(OCH₃)₃]₃

   [(CH₃)₃SiO)₃Si-(CH₂)_{H1}-C[CH₁CH₁CH₁Si(OCH₃)₃]₃

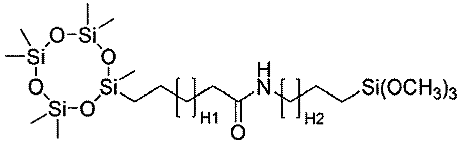

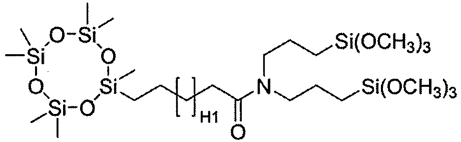

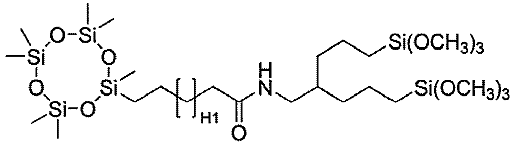

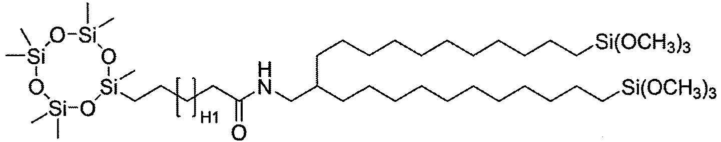

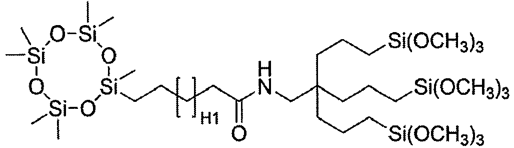

   CH₃CH₂CH₂CH₂-[Si(CH₃)₂O]ₙ₁Si(CH₃)₂-(CH₂)_{H1}-O-(CH₂)_{H2}- C(CH₂CH₃)[CH₂OC(=O)NHCH₂CH₂CH₂Si(OCH₃)₃]₂

   CH₃-[Si(CH₃)₂O]ₙ₁Si(CH₃)₂-(CH₂)_{H1}-O-(CH₂)_{H2}- C(CH₂CH₃)[CH₂OC(=O)NHCH₂CH₂CH₂Si(OCH₃)₃]₂

   CH₃CH₂CH₂CH₂-[Si(CH₃)₂O]ₙ₁Si(CH₃)₂-(CH₂)_{H1}-O-(CH₂)H₂- C(CH₂CH₃)[CH₂OC(=O)NHCH₂CH₂OC(=O)CH(CH₃)CH₂Si(OCH₃)₃]₂

   CH₃-[Si(CH₃)₂O]ₙ₁Si(CH₃)₂-(CH₂)_{H1}-O-(CH₂)_{H2}- C(CH₂CH₃)[CH₂OC(=O)NHCH₂CH₂OC(=O)CH(CH₃)CH₂Si(OCH₃)₃]₂

   CH₃CH₂CH₂CH₂-[Si(CH₃)₂O]ₙ₁Si(CH₃)₂--(CH₂)_{H1}-O-(CH₂)_{H2}- C[CH₂OC(=O)NHCH₂CH₂CH₂Si(OCH₃)₃]₃

   CH₃-[(Si(CH₃)₂O)]ₙ₁Si(CH₃)₂-(CH₂)_{H1}-O-(CH₂)_{H2}- C[CH₂OC(=O)NHCH₂CH₂CH₂Si(OCH₃)₃]₃

   [CH₃CH₂CH₂CH₂-[(Si(CH₃)₂O)]ₙ₁Si(CH₃)₂-(CH₂)_{H1}-O-(CH₂)_{H2}-]₂- C[CH₂OC(=O)NHCH₂CH₂CH₂Si(OCH₃)₃]₂

   [CH₃-[(Si(CH₃)₂O)]ₙ₁Si(CH₃)₂-(CH₂)_{H1}-O-(CH₂)_{H2}-]₂- C[CH₂OC(=O)NHCH₂CH₂CH₂Si(OCH₃)₃]₂

   CH₃CH₂CH₂CH₂-[Si(CH₃)₂O]ₙ₁Si(CH₃)₂-(CH₂)_{H1}-O-(CH₂)_{H2}- OC(=O)NHCH₂CH₂CH₂Si(OCH₃)₃

   CH₃-[Si(CH₃)₂O]ₙ₁Si(CH₃)₂-(CH₂)_{H1}-O-(CH₂)_{H2}-OC(=O)NHCH₂CH₂CH₂Si(OCH₃)₃

   CH₃CH₂CH₂CH₂-[Si(CH₃)₂O]ₙ₁Si(CH₃)₂-(CH₂)_{H1}-O-(CH₂)_{H2}- OC(=O)NHCH₂CH₂OC(=O)CH(CH₃)CH₂Si(OCH₃)₃

   CH₃-[Si(CH₃)₂O]ₙ₁Si(CH₃)₂-(CH₂)_{H1}-O-(CH₂)_{H2}-

   OC(=O)NHCH₂CH₂OC(=O)CH(CH₃)CH₂Si(OCH₃)₃

   [CH₃CH₂CH₂CH₂-[Si(CH₃)₂O]ₙ₁Si(CH₃)₂-(CH₂)_{H1}-O-(CH₂)_{H2}-]₃C- CH₂OC(=O)NHCH₂CH₂CH₂Si(OCH₃)₃

   [CH₃-[Si(CH₃)₂O]ₙ₁Si(CH₃)₂-(CH₂)_{H1}-O-(CH₂)_{H2}-]₃C- CH₂OC(=O)NHCH₂CH₂CH₂Si(OCH₃)₃

   [CH₃CH₂CH₂CH₂-[(Si(CH₃)₂O)]ₙ₁Si(CH₃)₂-(CH₂)_{H1}-O- (CH₂)_{H2}-]₂C(CH₂CH₃)[CH₂OC(=O)NHCH₂CH₂CH₂Si(OCH₃)₃]

   [CH₃-[(Si(CH₃)₂O)]ₙ₁Si(CH₃)₂-(CH₂)_{H1}-O- (CH₂)_{H2}-]C(CH₂CH₃)[CH₂OC(=O)NHCH₂CH₂CH₂Si(OCH₃)₃]

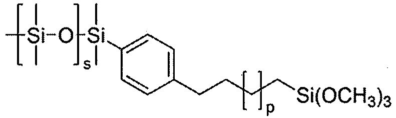

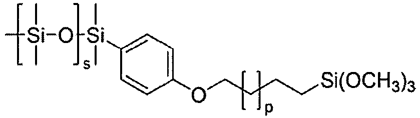

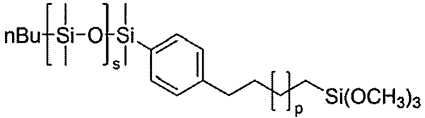

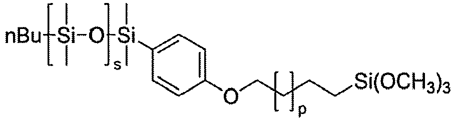

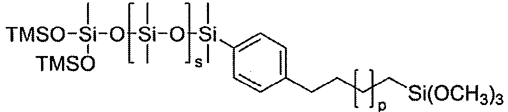

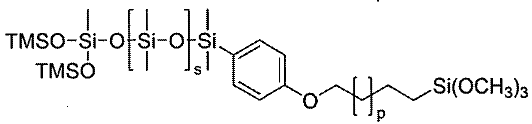

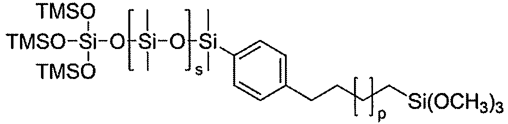

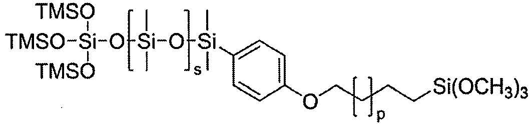

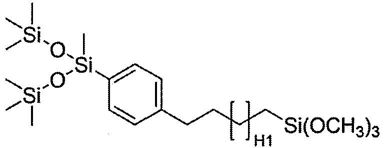

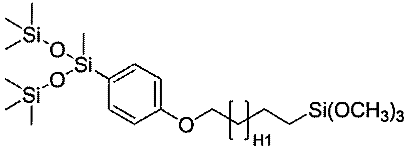

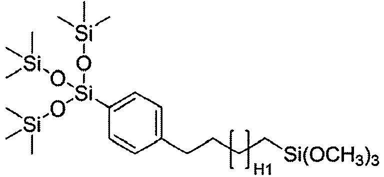

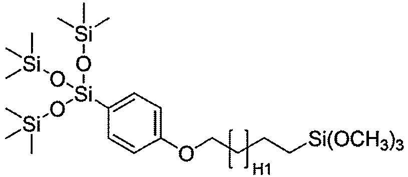

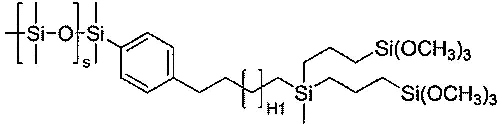

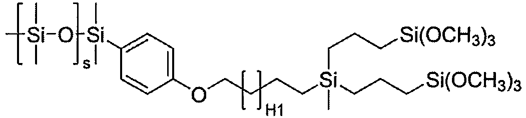

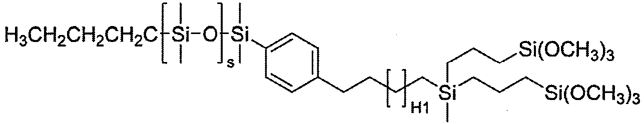

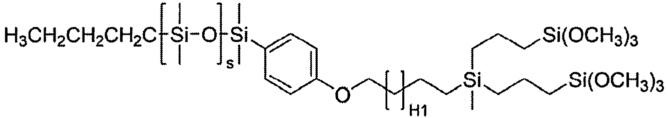

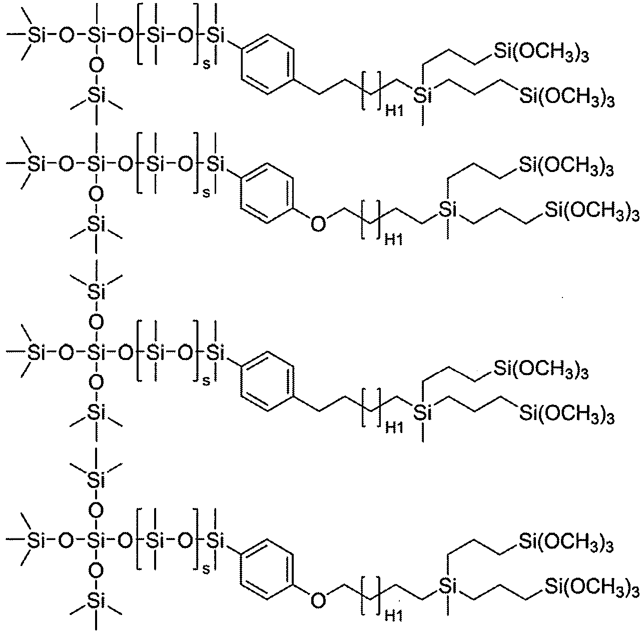

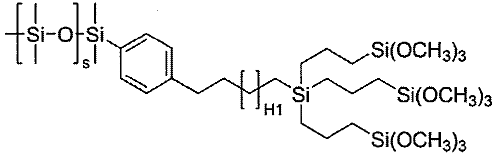

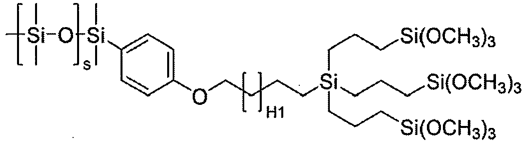

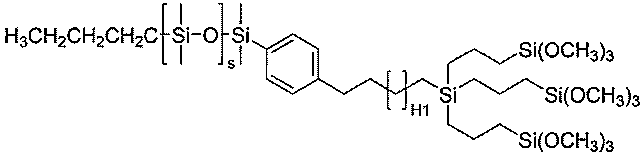

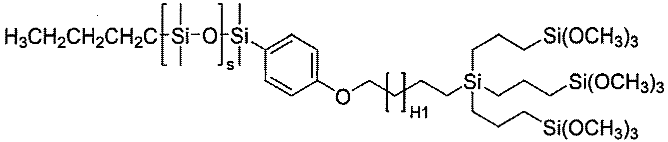

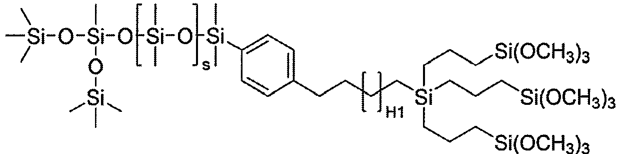

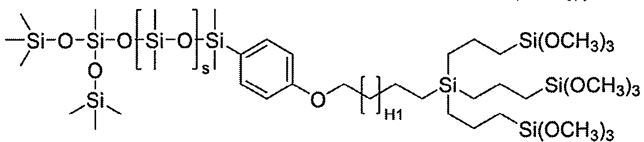

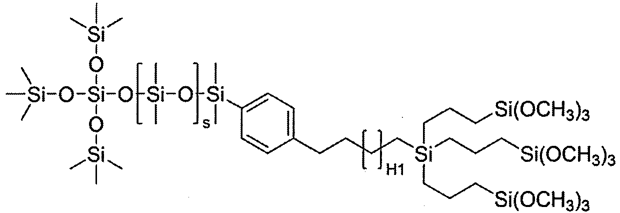

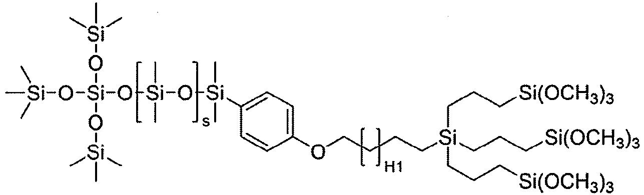

   wherein TMS represents a trimethylsilyl group, n1 and s are each independently 0 to 150, and p, H1 and H2 are each independently 1 to 50.
[11] The composition according to [10], wherein
   n1 and s are each independently 0 or 1,
   p and H1 are each independently 8 to 40, and
   H2 is each independently an integer of 1 to 10.
[12] The composition according to [10], wherein
   n1 and s are each independently 5 to 100,
   p and H1 are each independently 8 to 40, and
   H2 is each independently an integer of 1 to 10.
[13] The composition according to any one of [1] to [12], wherein the silane compound comprises a compound selected from the following group, wherein n is each independently 10 to 80:

   (CH₃CH₂CH₂CH₂Si(CH₃)₂-(OSi(CH₃)₂)ₙ-CH₂CH₂Si(CH₂CH₂CH₂Si(OCH₃)₃)₃

   (CH₃)₃Si-(OSi(CH₃)₂)ₙ-(CH₂)₁₀-CONH-CH₂C{CH₂CH₂CH₂Si(OCH₃)₃}₃

   (CH₃)₃Si-(OSi(CH₃)₂)ₙ-(CH₂)₂₂-CONH-CH₂CH[CH₂CH₂CH₂Si(OCH₃)₃]₂

   (CH₃CH₂CH₂CH₂Si(CH₃)₂-(OSi(CH₃)₂)ₙ-(CH₂)₃-OCH₂-CONH- CH₂C{CH₂CH₂CH₂Si(OCH₃)₃}₃

   CH₃CH₂CH₂CH₂Si(CH₃)₂-(OSi(CH₃)₂)ₙ-(CH₂)₂₂-CONH-CH₂CH₂CH₂Si(OCH₃)₃

   (CH₃)₃Si-(OSi(CH₃)₂)ₙ-(CH₂)₁₀-CON{CH₂CH₂CH₂Si(OCH₃)₃}₂

   (CH₃)₃Si-(OSi(CH₃)₂)ₙ-(CH₂)₂₂-CON[CH₂CH₂CH₂Si(OCH₃)₃]₂

   (CH₃)₃Si-(OSi(CH₃)₂)ₙ-(CH₂)₂₂-CON[CH₂CH₂CH₂Si(OCH₃)₃]₂

   (CH₃)₃Si-(OSi(CH₃)₂)ₙ-(CH₂)₂₂-CON((CH₂)₃Si(OCH₃)₃)₂

   CH₃CH₂CH₂CH₂Si(CH₃)₂-(CH₂CH₂CH₂Si(CH₃)₂)ₙ-CH₂CH₂CH₂- Si(CH₂CH₂CH₂Si(OCH₃)₃)₃

   [(CH₃)₃SiO]₂CH₃Si-(OSi(CH₃)₂)ₙ-(CH₂)₂₂-CONH-CH₂CH[CH₂CH₂CH₂Si(OCH₃)₃]₂ 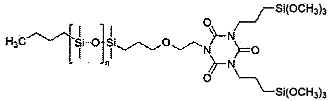 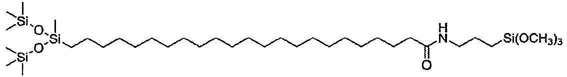 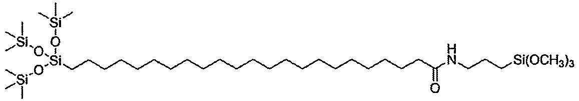 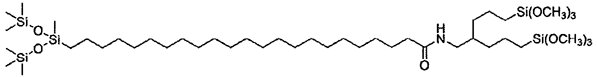 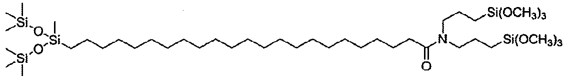 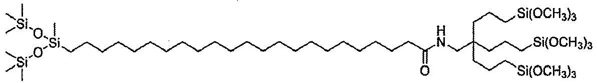 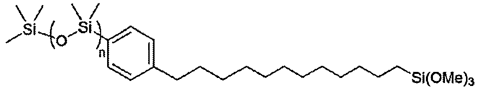 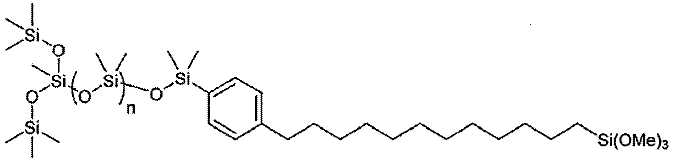 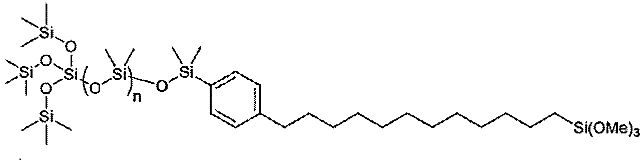 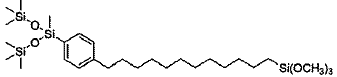 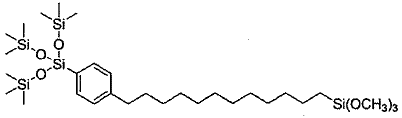
[14] The composition according to any one of [1] to [13], wherein the transition metal is comprised as a platinum(0)-1,3-divinyl-1,1,3,3-tetramethyldisiloxane complex.
[15] A surface-treating agent comprising the composition according to any one of [1] to [14].
[16] The surface-treating agent according to [15], comprising a condensate of the silane compound comprised in the composition according to any one of [1] to [14].
[17] The surface-treating agent according to [15] or [16], which is for vacuum deposition.
[18] The surface-treating agent according to [15] or [16], which is for wet coating.
[19] A pellet comprising the surface-treating agent according to any one of [15] to [18].
[20] An article comprising a substrate and a layer on the substrate, wherein the layer is formed from the surface-treating agent according to any one of [15] to [18].
[21] The article according to [20], comprising, between the substrate and the aforementioned layer, a silicon oxide-containing intermediate layer.
[22] The article according to [21], wherein the intermediate layer comprises an alkali metal atom.
[23] The article according to [22], wherein the alkali metal atom is at least partially sodium atom.
[24] The article according to any one of [20] to [23], which is an optical member.
[25] The article according to any one of [20] to [24], which is a display.

### Advantageous Effect of Invention

The composition of the present disclosure can allow a surface-treating layer favorable in abrasion durability to be realized.

### Description of Embodiments

The term "monovalent organic group" as used herein refers to a carbon-containing monovalent group. The monovalent organic group is not limited, and may be a hydrocarbon group or a derivative thereof. The derivative of a hydrocarbon group refers to a group that has one or more of N, O, S, Si, amide, sulfonyl, siloxane, carbonyl, carbonyloxy, and the like at the terminal or in the molecular chain of the hydrocarbon group. The term simply referred to as an "organic group" means a monovalent organic group. The term "divalent organic group" refers to a carbon-containing divalent group. The divalent organic group may be, for example, a divalent group obtained by further removing one hydrogen atom from the organic group. Similarly, an organic group having a valence of 3 or more refers to a group obtained by removing a predetermined number of hydrogen atoms from an organic group.

The "hydrocarbon group" as used herein refers to a group comprising carbon and hydrogen and a group in which a hydrogen atom is removed from the hydrocarbon. Examples of the hydrocarbon group include, but are not limited to, C₁₋₃₀ hydrocarbon groups, such as an aliphatic hydrocarbon group and an aromatic hydrocarbon group. The "aliphatic hydrocarbon group" may be either linear, branched, or cyclic, and may be either saturated or unsaturated. The hydrocarbon group may comprise one or more ring structures. The hydrocarbon group may be substituted with one or more substituents.

Examples of the substituent of the "hydrocarbon group" as used herein include, but are not limited to, a halogen atom; and one or more groups selected from a C₁₋₆ alkyl group, a C₂₋₆ alkenyl group, a C₂₋₆ alkynyl group, a C₃₋₁₀ cycloalkyl group, a C₃₋₁₀ unsaturated cycloalkyl group, a 5- to 10-membered heterocyclyl group, a 5- to 10-membered unsaturated heterocyclyl group, a C₆₋₁₀ aryl group, and a 5- to 10-membered heteroaryl group each optionally substituted with one or more halogen atoms.

The "hydrolyzable group" as used herein refers to a group that can undergo a hydrolysis reaction, i.e., refers to a group that can be removed from the main backbone of the compound by a hydrolysis reaction. Examples of the hydrolyzable group include -OR^{h}, -OCOR^{h}, -O-N=CR^{h}₂, -NR^{h}₂, -NHR^{h}, -NCO, halogen (in these formulae, R^{h} represents a substituted or unsubstituted alkyl group having 1 to 4 carbon atoms), and -OR^{h} (i.e., an alkoxy group) is preferable. Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable.

The term "arylene group" as used herein refers to a divalent aromatic group. The arylene group may be a monocyclic aromatic group or may be a polycyclic aromatic group. The arylene group is, for example, a divalent mono- to tricyclic aromatic group, and specific examples include the following divalent group obtained by removing two hydrogen atoms from benzene, naphthalene, anthracene, fluorene, or phenanthrene. The arylene group may be substituted with one or more substituents. The binding position is not limited.

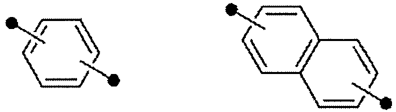

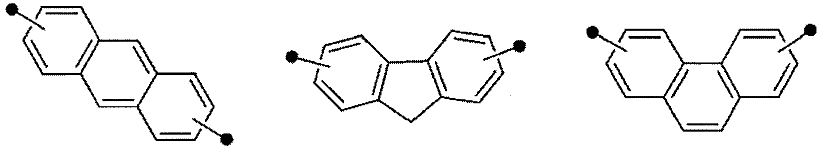

The composition of the present disclosure comprises a silane compound and a transition metal, wherein
the silane compound comprises one, or two or more of compounds selected from the following formula (1) or (2):

R^{A1}_{α}-X^{A}-R^{Si}_{β}, (1)

R^{Si}_{γ}-X^{A}-R^{A2}-X^{A}-R^{Si}_{γ} (2)

wherein
R^{A1} represents a monovalent group comprising one or more Si atoms to which neither a hydroxyl group nor a hydrolyzable group is directly bonded, or a hydrocarbon group,
R^{A2} each independently represents a divalent group comprising one or more Si atoms to which neither a hydroxyl group nor a hydrolyzable group is directly bonded,
R^{Si} represents a monovalent group comprising a Si atom to which a hydroxyl group or a hydrolyzable group is bonded,
X^{A} represents a single bond, or a di- to decavalent group,
α represents an integer of 1 to 9,
β represents an integer of 1 to 9, and
γ represents an integer of 1 to 9.

The composition of the present disclosure can allow a surface-treating layer favorable in abrasion durability to be provided. While the present disclosure should not be interpreted to be limited to any particular theory, the reason why the composition of the present disclosure can exert such an effect is considered as follows. That is, the composition of the present disclosure comprises, in addition to a specified silane compound, a transition metal. Therefore, it is considered that, when such a composition is used to form a surface-treating layer, a hydrolysis reaction of a hydrolyzable silyl group in the silane compound to a silanol group, and a dehydrative condensation reaction between the silanol group and a substrate surface can sufficiently progress, and it is considered that, even if the surface-treating layer is repeatedly abraded, excellent durability that hardly causes the surface-treating layer to be degraded in properties thereof is obtained. It is considered that, as a result, the number of chemical bonds that can be formed between the surface-treating layer and the substrate can increase to result in an enhancement in abrasion durability.

R^{A1} represents a monovalent group comprising one or more Si atoms to which neither a hydroxyl group nor a hydrolyzable group is directly bonded, or a hydrocarbon group.

Examples of the monovalent group comprising one or more Si atoms to which neither a hydroxyl group nor a hydrolyzable group is directly bonded, represented by R^{A1}, include any group represented by the following formula (A1), (A2), (A3), (A4), (A5) or (A6):

R^{1a}-R^{S1}-SiR^{2a}₂- (A1)

R^{3a}-X^{1a}- (A2)

R^{7a}-[(SiR^{8a}₂O)ₙ-SiR^{8a}₂]ₙₐ- (A3)

R^{11a}-(R^{S2})_{γ1}-(SiR^{12a}₂)_{γ2}-R^{Ar}- (A4)

R^{13a}-(SiR^{14a}₂O)ₙ-SiR^{14a}₂- (A5)

R^{17a}-R^{S}-(SiR^{18a}₂)ₛ- (A6)

wherein, in the formula (A1),
R^{1a} represents a hydrocarbon group,
R^{2a} represents a hydrocarbon group,
R^{S} is each independently a group represented by the following formula: 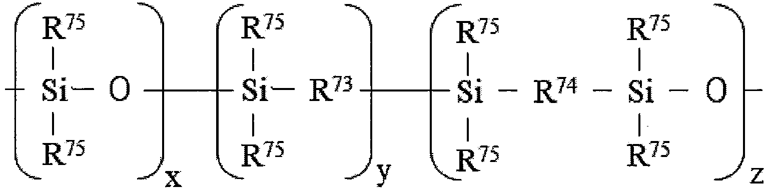 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted arylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula);
in the formula (A2),
R^{3a} represents R^{4a}-O-CO-, R^{4a}-CO-O-, R^{4a}-O-C(=O)-O-, R^{4a}-NR-CO-, R^{4a}-CO-NR-, R^{4a}-OCO-NR^{5a}-, R^{4a}-NR^{5a}-COO-, R^{4a}-NR^{5a}-CO-NR^{5a}-, CH₂=CH-, NHR^{5a}-, CR^{5a}₃-, CHR^{6a}- or a halogen atom,
R^{4a} represents a hydrogen atom, a C₁₋₆ alkyl group, or an oxyalkylene-containing group having 1 to 30 carbon atoms,
R^{5a} represents a hydrogen atom or a C₁₋₆ alkyl group,
R^{6a} represents a halogen atom, and
X^{1a} represents an alkylene group having 12 or more carbon atoms;
in the formula (A3),
R^{7a} each independently represents a C₁₋₁₂ alkyl group, or the following group A or group B,
the group A and the group B are each a group represented by the following formula:

   R⁵¹ₙₐR⁵²₃₋ₙₐSi-(O)_{z}- (A)

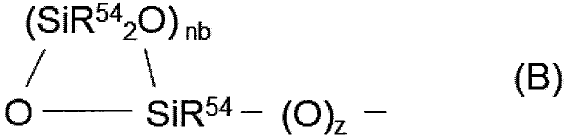

   wherein
R⁵¹ is each independently a group represented by -(R⁶¹-SiR⁵³₂)ₘₐ-R⁵³,
   R⁶¹ is each independently an oxygen atom or a C₁₋₆ alkylene group,
   R⁵³ is each independently a hydrocarbon group or R^{51'}
      R^{51'} has the same meaning as R⁵¹,
   ma is each independently an integer of 1 to 5,
provided that the number of R^{51'} in R⁵¹ is 20 or less,
R⁵² is each independently a hydrocarbon group,
na is an integer of 1 to 3,
R⁵⁴ is each independently a hydrocarbon group,
nb is an integer of 1 to 5, and
z is 0 or 1;
R^{8a} is each independently a C₁₋₁₂ alkyl group,
n is 1 to 1,500, and
na is each independently 0 or 1;
in the formula (A4),
R^{11a} represents a monovalent group comprising one or more Si atoms to which neither a hydroxyl group nor a hydrolyzable group is directly bonded, or a hydrocarbon group,
R^{S} has the same meaning as above,
R^{12a} represents a hydrocarbon group, and
R^{Ar} represents a divalent aromatic hydrocarbon group;
in the formula (A5),
R^{13a} represents a C₁₋₁₂ alkyl group,
R^{14a} each independently represents a C₁₋₁₂ alkyl group, and
n is an integer of 1 to 1,500; and
in the formula (A6),
R^{17a} is a hydrocarbon group, or R^{18a}ₙₐ₁R^{19a}₃₋ₙₐ₁Si-(O)_{z}-,
   R^{18a} is a group represented by R^{21a}-(SiR^{21a}₂-R^{20a})ₘₐ₁-,
   R^{20a} is an oxygen atom, or a C₁₋₆ alkylene group,
   R^{21a} is a hydrocarbon group or R^{18a'},
   R^{18a'} has the same meaning as R^{18a},
   ma1 is each independently an integer of 1 to 5,
   provided that the number of R^{18a'} in R^{18a} is 20 or less,
R^{19a} is each independently a hydrocarbon group,
na1 is an integer of 1 to 3,
z is 0 or 1,
s is 0 or 1, and
R^{S} has the same meaning as above. That is, the silane compound may comprise a compound in which R^{A1} is the formula (A1), (A2), (A3), (A4), (A5) or (A6).

R^{S} is each independently a group represented by the following formula: 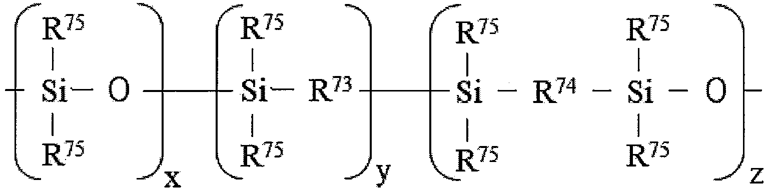 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted arylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula.

R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-, and is preferably a C₁₋₁₂ alkylene group or -R⁷⁶-O-R⁷⁶-.

In one embodiment, R⁷³ is a single bond.

In one embodiment, R⁷³ is a C₁₋₁₂ alkylene group, -R⁷⁶-O-R⁷⁶-, -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-, and is preferably a C₁₋₁₂ alkylene group or -R⁷⁶-O-R⁷⁶-.

R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-.

In one embodiment, R⁷⁴ is each independently a C₁₋₁₂ alkylene group, or -R⁷⁶-O-R⁷⁶-.

In another embodiment, R⁷⁴ is each independently -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-.

In one embodiment, R⁷³ is each independently a C₁₋₁₂ alkylene group or -R⁷⁶-O-R⁷⁶-, and R⁷⁴ is each independently a C₁₋₁₂ alkylene group or -R⁷⁶-O-R⁷⁶-,

In another embodiment, R⁷³ is each independently a C₁₋₁₂ alkylene group or - R⁷⁶-O-R⁷⁶-, and R⁷⁴ is each independently -R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-.

The C₁₋₁₂ alkylene group may be linear or may be branched. The C₁₋₁₂ alkylene group is preferably linear.

The C₁₋₁₂ alkylene group is preferably a C₂₋₈ alkylene group, and more preferably a C₂₋₆ alkylene group.

R⁷⁶ is each independently a C₁₋₆ alkylene group. The C₁₋₆ alkylene group may be linear or may be branched. The C₁₋₆ alkylene group is preferably linear.

The C₁₋₆ alkylene group is preferably a C₂₋₄ alkylene group, and more preferably a C₂₋₃ alkylene group.

In a preferable embodiment, in a group comprising a plurality of R⁷⁶, all R⁷⁶ are the same group.

R⁷⁷ is each independently an optionally substituted arylene group.

In one embodiment, R⁷⁷ is each independently

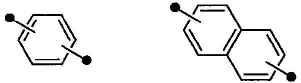

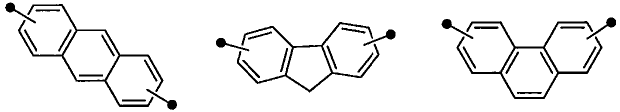

In one embodiment, R⁷⁷ is a phenylene group.

In another embodiment, R⁷⁷ is a naphthylene group.

The arylene group may have a substituent. The number of substituents is not limited, and is, for example, 1 to 4, and preferably 1 or 2.

In one embodiment, the phenylene group and the naphthylene group may have a substituent. The number of substituents is not limited, and is, for example, 1 to 4, and preferably 1 or 2. The substituted phenylene group is preferably 2,5-substituted phenylene.

The substituent with respect to the arylene group is each independently -R¹⁴¹-R¹⁴².

R¹⁴¹ is a single bond, an oxygen atom, or a sulfur atom, preferably a single bond or an oxygen atom, and more preferably an oxygen atom.

R¹⁴² is a C₁₋₁₂ alkyl group, -(O-R¹⁴³)ₚ, -R¹⁴⁴-R¹⁴⁵, or -R¹⁴⁴-OR¹⁴⁶, all of which are optionally substituted with a halogen.

The halogen is fluorine, chlorine, bromine, or iodine, and is preferably fluorine.

The C₁₋₁₂ alkyl group in R¹⁴² may be linear or may be branched.

R¹⁴³ is a C₁₋₆ alkylene group, and preferably a C₂₋₄ alkylene group. Such an alkylene group may be linear or may be branched.

R¹⁴⁴ is a C₁₋₁₂ alkylene group, and preferably a C₁₋₆ alkylene group. Such an alkylene group may be linear or may be branched.

R¹⁴⁵ is -CH=CH₂, or -OCOCH=CH₂.

R¹⁴⁶ is a hydrogen atom or a C₁₋₆ alkyl group. Such an alkyl group may be linear or may be branched. The C₁₋₆ alkyl group is preferably a C₁₋₃ alkyl group, more preferably a C₁₋₂ alkyl group, and even more preferably a methyl group.

R⁷⁸ is each independently a single bond or a C₁₋₆ alkylene group. Such a C₁₋₆ alkylene group may be linear or may be branched.

In one embodiment, R⁷⁸ is a single bond.

In another embodiment, R⁷⁸ is a C₁₋₆ alkylene group.

R⁷⁹ is each independently a single bond or an oxygen atom.

In one embodiment, R⁷⁹ is a single bond.

In another embodiment, R⁷⁹ is an oxygen atom.

R⁷⁵ is each independently a hydrocarbon group. Such a hydrocarbon group may be substituted.

R⁷⁵ is each independently preferably an unsubstituted hydrocarbon group, or a hydrocarbon group substituted with a halogen atom.

R⁷⁵ is, each independently, preferably a C₁₋₁₈ alkyl group or aryl group optionally substituted with a halogen atom, and more preferably a C₁₋₁₈ alkyl group or aryl group.

The C₁₋₁₈ alkyl group may be linear or may be branched, and is preferably linear. The C₁₋₁₈ alkyl group is preferably a C₁₋₁₀ alkyl group, more preferably a C₁₋₆ alkyl group, even more preferably a C₁₋₄ alkyl group, and yet more preferably a methyl group.

The aryl group is preferably a phenyl group.

In one embodiment, R⁷⁵ is each independently a C₁₋₆ alkyl group, preferably a C₁₋₄ alkyl group, and more preferably a methyl group.

In another embodiment, R⁷⁵ is a phenyl group.

In another embodiment, R⁷⁵ is each independently a methyl group or a phenyl group, and preferably a methyl group.

x is an integer of 0 to 500, preferably an integer of 0 to 300, more preferably an integer of 0 to 100, even more preferably an integer of 1 to 100, yet more preferably an integer of 5 to 50, and yet more preferably an integer of 10 to 30.

In one embodiment, x is 0.

In one embodiment, x is an integer of 1 to 500, preferably an integer of 1 to 300, more preferably an integer of 1 to 100, even more preferably an integer of 5 to 50, and yet more preferably an integer of 10 to 30.

y is an integer of 0 to 500, preferably an integer of 0 to 300, more preferably an integer of 0 to 100, even more preferably an integer of 1 to 100, yet more preferably an integer of 5 to 50, and yet more preferably an integer of 10 to 30.

In one embodiment, y is 0.

In one embodiment, y is an integer of 1 to 500, preferably an integer of 1 to 300, more preferably an integer of 1 to 100, even more preferably an integer of 5 to 50, and yet more preferably an integer of 10 to 30.

z is an integer of 0 to 500, preferably an integer of 0 to 300, more preferably an integer of 0 to 100, even more preferably an integer of 1 to 100, yet more preferably an integer of 5 to 50, and yet more preferably an integer of 10 to 30.

In one embodiment, z is 0.

In one embodiment, z is an integer of 1 to 500, preferably an integer of 1 to 300, more preferably an integer of 1 to 100, even more preferably an integer of 5 to 50, and yet more preferably an integer of 10 to 30.

In one embodiment, y is 0, and z is 0.

In another embodiment, x is 0, and y is 0.

In yet another embodiment, x is 0, and z is 0.

The divalent siloxane-containing group may be a random polymer, or may be a block polymer.

R^{1a} is a hydrocarbon group.

R^{2a} is each independently a hydrocarbon group.

The hydrocarbon groups in R^{1a} and R^{2a} are each optionally substituted.

R^{1a} and R^{2a} are each independently preferably an unsubstituted hydrocarbon group, or a hydrocarbon group substituted with a halogen atom.

R^{1a} and R^{2a} are each independently preferably a C₁₋₁₈ alkyl group or an aryl group optionally substituted with a halogen atom, and more preferably a C₁₋₁₈ alkyl group or an aryl group.

The C₁₋₁₈ alkyl group may be linear or may be branched, and is preferably linear. The C₁₋₁₈ alkyl group is preferably a C₁₋₁₀ alkyl group, more preferably a C₁₋₆ alkyl group, even more preferably a C₁₋₄ alkyl group, and yet more preferably a methyl group.

The aryl group is preferably a phenyl group.

In one embodiment, R^{1a} and R^{2a} are each independently a C₁₋₆ alkyl group, preferably a C₁₋₄ alkyl group, and more preferably a methyl group or a n-butyl group.

In one embodiment, R^{1a} and R^{2a} are each a methyl group. In another embodiment, R^{1a} and R^{2a} are each a n-butyl group.

In another embodiment, R^{1a} and R^{2a} are each a phenyl group.

In another embodiment, R^{1a} and R^{2a} are each independently methyl group or a phenyl group, preferably a methyl group.

R^{3a} represents R^{4a}-O-CO-, R^{4a}-CO-O-, R^{4a}-O-C(=O)-O-, R^{4a}-NR-CO-, R^{4a}-CO-NR-, R^{4a}-OCO-NR^{5a}-, R^{4a}-NR^{5a}-COO-, R^{4a}-NR^{5a}-CO-NR^{5a}-, CH₂=CH-, NHR^{5a}-, CR^{5a}₃-, CHR^{6a}- or a halogen atom.

R^{4a} is a hydrogen atom, a C₁₋₆ alkyl group, or an oxyalkylene-containing group having 1 to 30 carbon atoms, preferably a hydrogen atom or a C₁₋₆ alkyl group, and even more preferably a C₁₋₆ alkyl group.

The C₁₋₆ alkyl group may be linear or may be branched. The C₁₋₆ alkyl group is preferably a C₁₋₄ alkyl group, more preferably a methyl group or an ethyl group, and even more preferably a methyl group.

R^{5a} is a hydrogen atom, or C₁₋₆ alkyl group, and preferably a hydrogen atom.

The C₁₋₆ alkyl group may be linear or may be branched. The C₁₋₆ alkyl group is preferably a C₁₋₄ alkyl group, more preferably a methyl group or an ethyl group, and even more preferably a methyl group.

The oxyalkylene-containing group having 1 to 30 carbon atoms is a group comprising -O-C₁₋₃₀ alkylene-, and is, for example, -R⁸¹-(-O-C₁₋₃₀ alkylene)ₙ-R⁸² (wherein R⁸¹ is a single bond or a divalent organic group, and preferably a C₁₋₆ alkylene group, n is any integer, and preferably an integer of 1 to 10, and R⁸² is a hydrogen atom or a monovalent organic group, preferably a C₁₋₆ alkyl group, and more preferably a methyl group). The alkylene group may be linear or may be branched.

R^{6a} represents a halogen atom. The halogen atom is chlorine, bromine, or iodine, and is preferably bromine.

R^{3a} is preferably, R^{4a}-O-CO-, CH₂=CH-, NH₂-, or a bromine atom, and R^{4a} is a C₁₋₆ alkyl group, preferably a C₁₋₄ alkyl group, and more preferably a methyl group.

In one embodiment, R^{3a} is R^{4a}-O-CO- or CH₂=CH-, and R^{4a} is a C₁₋₆ alkyl group, preferably a C₁₋₄ alkyl group, and more preferably a methyl group.

In the formulae, X^{1a} is an alkylene group having 12 or more carbon atoms, and is an alkylene group having preferably 16 or more carbon atoms and even more preferably 20 or more carbon atoms.

The upper limit of the number of carbon atoms in X^{1a} is not limited, and is preferably 32, and more preferably 28, and may be, for example, 26 or 23.

X^{1a} is preferably a C₁₂₋₃₆ alkylene group, more preferably a C₁₆₋₃₆ alkylene group, and even more preferably a C₂₀₋₃₂ alkylene group.

R^{7a} each independently represents -(R^{10a}-SiR^{9a}₂)ₘ-R^{a9}.

R^{10a} is each independently an oxygen atom or a C₁₋₆ alkylene group.

The C₁₋₆ alkylene group in R^{10a} may be linear or may be branched. The C₁₋₆ alkylene group may be preferably a C₁₋₄ alkylene group, and more preferably a C₂₋₄ alkylene group.

In one embodiment, R^{10a} is O.

In one embodiment, some R^{10a} groups are O, and other R^{10a} groups are C₁₋₆ alkylene groups.

R^{9a} is each independently a hydrocarbon group or R^{7a'}.

The hydrocarbon group in R^{9a} may be preferably an alkyl group or an aryl group.

The alkyl group may be linear or may be branched. The alkyl group is preferably a C₁₋₆ alkyl group, and more preferably a C₁₋₄ alkyl group. The alkyl group is particularly preferably a methyl group, an ethyl group, a n-propyl group, an iso-propyl group, a n-butyl group or a tert-butyl group.

The aryl group may be monocyclic or may be polycyclic. The aryl is preferably a C₆₋₂₀ aryl group, and more preferably a C₆₋₁₀ aryl group. The aryl group is particularly preferably a phenyl group.

R^{9a} is preferably an alkyl group, more preferably a C₁₋₄ alkyl group, and more preferably a methyl group or a n-butyl group.

In one embodiment, R^{9a} is a methyl group. In another embodiment, R^{9a} is a n-butyl group.

R^{7a'} has the same meaning as R^{7a}. That is, R^{7a'} is -(R^{10a}-SiR^{9a}₂)ₘ-R^{a9}. However, in R^{7a}, the number of R^{7a'} is 20 or less, preferably 10 or less, more preferably 6 or less, and even more preferably 3 or less.

In one embodiment, R^{9a} is each independently a hydrocarbon group or R^{7a'}.

In a preferable embodiment, R^{9a} is each independently a hydrocarbon group.

In one embodiment, R^{9a} is -(R^{10a'}-SiR^{9a'}₂)_{ma'}-R^{9a'}
wherein
R^{9a'} is each independently a hydrocarbon group or -(R^{10a}-SiR^{9a}₂)ₘₐ-R^{9a},
at least one R^{9a'} is -(R^{10a}-SiR^{9a}2)ₘₐ-R^{9a},
   R^{9a} is each independently a hydrocarbon group,
   R^{10a} is each independently an oxygen atom or a C₁₋₆ alkylene group,
   ma is each independently an integer of 1 to 5,
R^{10a'} is each independently an oxygen atom or a C₁₋₆ alkylene group, and
ma' is each independently an integer of 1 to 5.

In another embodiment, R^{9a} is -(R^{10a'}-SiR^{9a'}₂)_{ma'}-R^{9a'}
wherein
R^{9a'} is each independently a hydrocarbon group or -(R^{10a"}-SiR^{9a"}₂)_{ma"}-R^{9a"},
at least one R^{9a'}is -(R^{10a"}-SiR^{9a"}₂)_{ma"}-R^{9a"},
   R^{9a"} is each independently a hydrocarbon group or -(R^{10a}-SiR^{9a}₂)ₘₐ-R^{9a},
   at least one R^{9a"} is -(R^{10a}-SiR^{9a}₂)ₘₐ-R^{9a},
      R^{9a} is each independently a hydrocarbon group,
      R^{10a} is each independently an oxygen atom or a C₁₋₆ alkylene group,
      ma is each independently an integer of 1 to 5,
   R^{10a"} is each independently an oxygen atom or a C₁₋₆ alkylene group,
   ma" is each independently an integer of 1 to 5,
R^{10a'} is each independently an oxygen atom or a C₁₋₆ alkylene group, and
ma' is each independently an integer of 1 to 5.
ma is each independently an integer of 1 to 5, and preferably 1 or 2.
R^{8a} is each independently a hydrocarbon group.

The hydrocarbon group in R^{8a} may be preferably an alkyl group or an aryl group.

The alkyl group may be linear or may be branched. The alkyl group is preferably a C₁₋₆ alkyl group, and more preferably a C₁₋₄ alkyl group. The alkyl group is particularly preferably a methyl group, an ethyl group, a n-propyl group, an iso-propyl group, a n-butyl group, or a tert-butyl group.

The aryl group may be monocyclic or may be polycyclic. The aryl is preferably a C₆₋₂₀ aryl group, and more preferably a C₆₋₁₀ aryl group.
The aryl group is particularly preferably a phenyl group.

R^{8a} is preferably an alkyl group, more preferably a C₁₋₄ alkyl group, and more preferably a n-butyl group or a methyl group.

In one embodiment, R^{8a} is a C₁₋₆ alkyl group, preferably a C₁₋₄ alkyl group, and more preferably a n-butyl group.

na is 1 to 3. In one embodiment, na is 2. In another embodiment, na is 3. Note that na, when R^{7a'} is present, is independently selected for (R^{10a}-SiR^{9a}₂)ₘₐ.

In R^{7a}, 2 or more, preferably 3 or more, more preferably 4 or more, even more preferably 6 or more, for example, 8 or more, 9 or more, 10 or more, or 12 or more Si-O bonds are present.

In a preferable embodiment, in the group represented by the formula (A3),

R^{7a} each independently represents a C₁₋₁₂ alkyl group, or the following group A or group B.

In one embodiment, R^{7a} is a C₁₋₁₂ alkyl group.

The C₁₋₁₂ alkyl group in R^{7a} may be linear or may be branched. In one embodiment, the C₁₋₁₂ alkyl group is linear. In another embodiment, the C₁₋₁₂ alkyl group is branched. The C₁₋₁₂ alkyl group is preferably a C₁₋₆ alkyl group, more preferably a C₁₋₃ alkyl group, even more preferably a methyl group or an ethyl group, and particularly preferably a methyl group.

The C₁₋₁₂ alkyl group in R^{7a} is preferably a C₁₋₆ alkyl group, more preferably a C₁₋₄ alkyl group, even more preferably a methyl group or a n-butyl group, and particularly preferably a n-butyl group.

In one embodiment, R^{7a} is a group A or a group B.

R⁵¹ₙₐR⁵²₃₋ₙₐSi-(O)_{z}- (A)

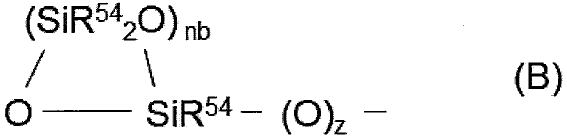

### (Group A)

R⁵¹ is each independently a group represented by R⁵³-(SiR⁵³₂-R⁶¹)ₘₐ-.

R⁶¹ is each independently a single bond, an oxygen atom, or a C₁₋₆ alkylene group.

The C₁₋₆ alkylene group in R⁶¹ may be linear or may be branched. The C₁₋₆ alkylene group is preferably a C₁₋₄ alkylene group, and more preferably a C₂₋₄ alkylene group.

In one embodiment, R⁶¹ is an oxygen atom, or a C₁₋₆ alkylene group.

In one embodiment, R⁶¹ is an oxygen atom.

In one embodiment, some R⁶¹ groups are oxygen atoms, and other R⁶¹ groups are C₁₋₆ alkylene groups.

R⁵³ is each independently a hydrocarbon group or R^{51'}.

The hydrocarbon group in R⁵³ may preferably be an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, a n-butyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R⁵³ is preferably an alkyl group, and more preferably an alkyl group having 1 to 4 carbon atoms.

In one embodiment, R⁵³ is a C₁₋₆ alkyl group, preferably a C₁₋₃ alkyl group, and more preferably a methyl group.

In one embodiment, R⁵³ is a C₁₋₆ alkyl group, preferably a C₁₋₄ alkyl group, and more preferably a n-butyl group.

R^{51'} has the same meaning as R⁵¹. That is, R^{51'} is R⁵³-(SiR⁵³₂O)ₘₐ-. However, in R⁵¹, the number of R^{51'} is 20 or less, preferably 10 or less, more preferably 6 or less, and even more preferably 3 or less.

In one embodiment, R⁵³ is each independently a hydrocarbon group or R^{51'}.

In a preferable embodiment, R⁵³ is each independently a hydrocarbon group.

In one embodiment, R⁵³ is R^{53'}-(SiR^{53'}₂-R^{61'})_{ma'}-
wherein
R^{53'} is each independently a hydrocarbon group or R⁵³-(SiR⁵³₂-R⁶¹)ₘₐ-,
   at least one R^{53'} is R⁵³-(SiR⁵³₂-R⁶¹)ₘₐ-,
   R⁵³ is each independently a hydrocarbon group,
   R⁶¹ is each independently a single bond, an oxygen atom, or a C₁₋₆ alkylene group,
   ma is each independently an integer of 1 to 5,
R^{61'} is each independently an oxygen atom or a C₁₋₆ alkylene group, and
ma' is each independently an integer of 1 to 5.

In another embodiment, R⁵³ is R^{53'}-(SiR^{53'}₂-R^{61'})_{ma'}-
wherein
R^{53'} is each independently a hydrocarbon group or R^{53"}-(SiR^{53"}₂-R^{61"})_{ma"}-,
at least one R^{53'} is R^{53"}-(SiR^{53"}₂-R^{6"})_{ma"}-,
   R^{53"} is each independently a hydrocarbon group or R⁵³-(SiR⁵³₂-R⁶¹)ₘₐ-,
   at least one R^{53"} is R⁵³-(SiR⁵²₂-R⁶¹)ₘₐ-,
      R⁵³ is each independently a hydrocarbon group,
      R⁶¹ is each independently an oxygen atom or a C₁₋₆ alkylene group,
      ma is each independently an integer of 1 to 5,
   R^{61"} is each independently an oxygen atom or a C₁₋₆ alkylene group,
   ma" is each independently an integer of 1 to 5,
R^{61'} is each independently an oxygen atom or a C₁₋₆ alkylene group, and
ma' is each independently an integer of 1 to 5.
ma is each independently an integer of 1 to 5, and preferably 1 or 2.
R⁵² is each independently a hydrocarbon group.

The hydrocarbon group in R⁵² may be preferably an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, a n-butyl group or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R⁵² is preferably an alkyl group, and more preferably an alkyl group having 1 to 4 carbon atoms.

In one embodiment, R⁵² is a C₁₋₆ alkyl group, preferably a C₁₋₃ alkyl group, and more preferably a methyl group.

In one embodiment, R⁵² is a C₁₋₆ alkyl group, preferably a C₁₋₄ alkyl group, and more preferably a n-butyl group.
na is an integer of 1 to 3. In one embodiment, na is 2. In another embodiment, na is 3. Note that na, when R^{51'} is present, is independently selected for (R⁶¹-S1R⁵³₂)ₘₐ.
z is 0 or 1. In one embodiment, z is 0. In another embodiment, z is 1.

In a preferable embodiment, in the group A,
R⁵¹ is each independently a group represented by R⁵³-(SiR⁵³₂-R⁶¹)ₘₐ-,
   R⁶¹ is each independently a single bond, an oxygen atom, or a C₁₋₆ alkylene group, and preferably an oxygen atom or a C₁₋₆ alkylene group,
   R⁵³ is each independently a hydrocarbon group, and preferably an alkyl group having 1 to 4 carbon atoms,
   ma is 1 or 2,
R⁵² is each independently a hydrocarbon group, and preferably an alkyl group having 1 to 4 carbon atoms, and
na is 1 or 2.

Examples of the group A include, but are not limited to, the following groups:

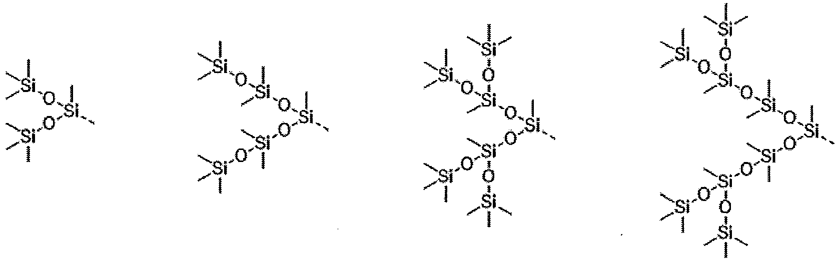

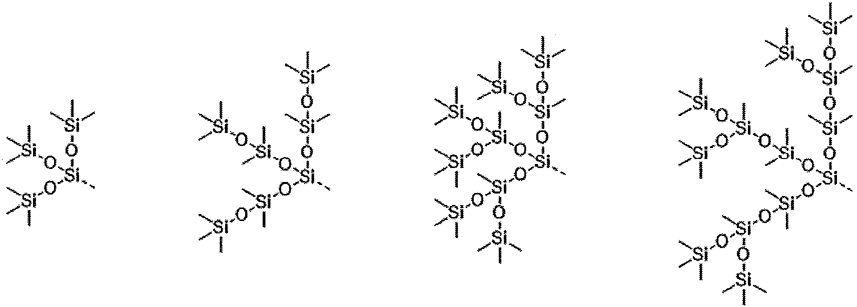

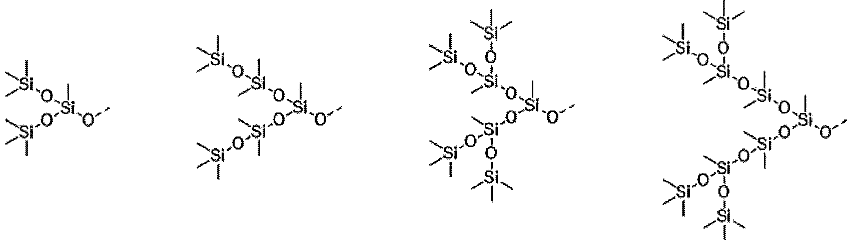

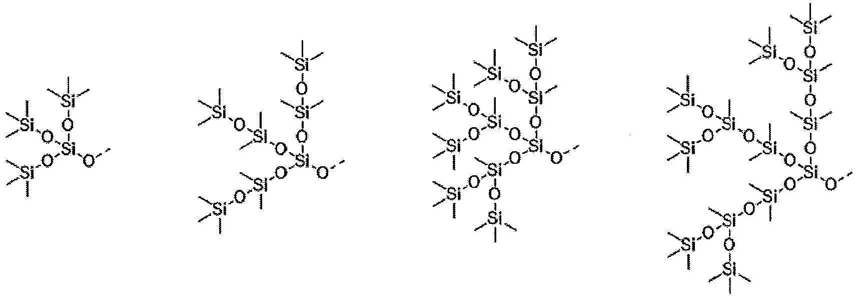

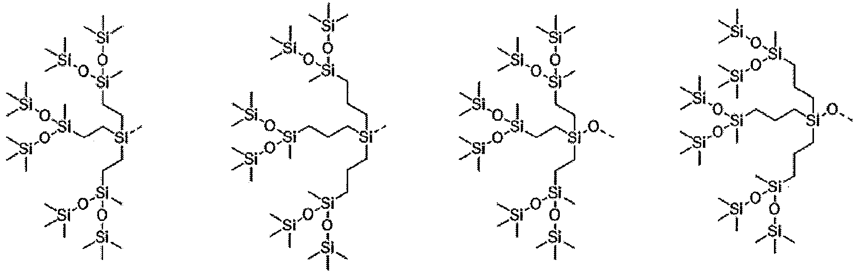

In a preferable embodiment, the group A is the following group:

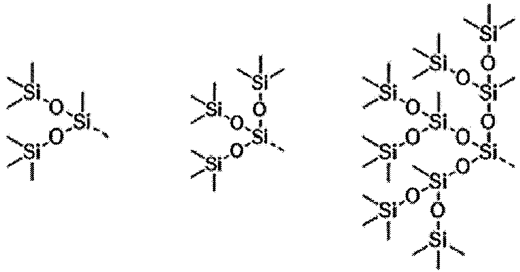

### (Group B)

R⁵⁴ is each independently a hydrocarbon group.

The hydrocarbon group in R⁵⁴ may be preferably an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, a n-butyl group or a tert-butyl group.

The aryl group may be monocyclic or may be polycyclic. The aryl is preferably an aryl group having 6 to 20 carbon atoms, and more preferably an aryl group having 6 to 10 carbon atoms. The aryl group is particularly preferably a phenyl group.

R⁵⁴ is preferably an alkyl group, and more preferably an alkyl group having 1 to 4 carbon atoms.

In one embodiment, R⁵⁴ is a C₁₋₆ alkyl group, preferably a C₁₋₃ alkyl group, and more preferably a methyl group.

In one embodiment, R⁵⁴ is a C₁₋₆ alkyl group, preferably a C₁₋₄ alkyl group, and more preferably a n-butyl group.

nb is an integer of 1 to 5, and preferably 2 or 3.

In a preferable embodiment, in the group B,
R⁵⁴ is each independently a hydrocarbon group, and preferably an alkyl group having 1 to 4 carbon atoms, and
nb is 2 or 3.

Examples of the group B include, but are not limited to, the following groups.

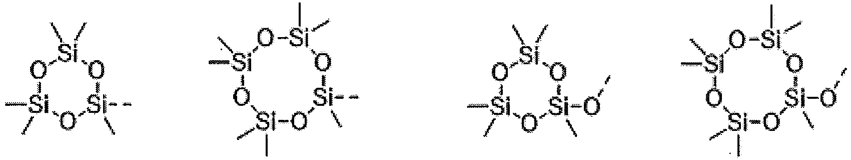

The C₁₋₁₂ alkyl group in R^{8a} may be linear or may be branched. In one embodiment, the C₁₋₁₂ alkyl group is linear. In another embodiment, the C₁₋₁₂ alkyl group is branched. The C₁₋₁₂ alkyl group is preferably a C₁₋₆ alkyl group, more preferably a C₁₋₃ alkyl group, even more preferably a methyl group or an ethyl group, and particularly preferably a methyl group.

n may be 0 to 1,500, preferably 0 to 1,500, more preferably 0 to 500, and even more preferably 0 to 10. In one embodiment, n may be preferably 1 to 1,500, more preferably 1 to 500, and even more preferably 1 to 10. n is yet more preferably 0, 1 or 2.

In one embodiment, n is 10 to 500, and more preferably 10 to 100.

na is each independently 0 or 1. In one embodiment, n is 0. In another embodiment, n is 1.

R^{11a} represents a monovalent group comprising one or more Si atoms to which neither a hydroxyl group nor a hydrolyzable group is directly bonded, or a hydrocarbon group.

In one embodiment, R^{11a} is a hydrocarbon group.

The hydrocarbon group is preferably an alkyl group.

The alkyl group may be linear or may be branched. In one embodiment, the alkyl group is linear. In another embodiment, the alkyl group is branched. The alkyl group is preferably a C₁₋₁₂ alkyl group, more preferably a C₁₋₆ alkyl group, even more preferably a C₁₋₃ alkyl group, and yet more preferably a methyl group or an ethyl group, and particularly preferably a methyl group.

In one embodiment, R^{11a} is a C₁₋₆ alkyl group, preferably a C₁₋₃ alkyl group, and more preferably a methyl group.

In one embodiment, R^{11a} is a C₁₋₆ alkyl group, preferably a C₁₋₄ alkyl group, and more preferably a n-butyl group.

In one embodiment, R^{11a} is a group represented by the following group A:

R⁵¹ₙₐR⁵²₃₋ₙₐSi-(O)_{z}- (A)

wherein
R⁵¹ is each independently a group represented by R⁵³-(R⁶¹-SiR⁵³₂)ₘₐ-,
   R⁶¹ is each independently an oxygen atom or a C₁₋₆ alkylene group,
   R⁵³ is each independently a hydrocarbon group or R^{51'}
      R^{51'} has the same meaning as R⁵¹,
   ma is each independently an integer of 1 to 5,
provided that the number of R^{51'} in R⁵¹ is 20 or less,
R⁵² is each independently a hydrocarbon group,
na is an integer of 1 to 3, and
z is 0 or 1. Such a group A has the same meaning as the group A in the formula (A3).

In the formula (4A), R^{S} has the same meaning as above.

R^{12a} is each independently a C₁₋₄ alkyl group.

The C₁₋₄ alkyl group in R^{12a} may be linear or may be branched. The C₁₋₄ alkyl group is preferably a methyl group, an ethyl group, a n-propyl group, an iso-propyl group, a n-butyl group or a tert-butyl group.

R^{12a} is preferably a methyl group or an ethyl group, and more preferably a methyl group.

R^{Ar} is a divalent aromatic group.

The divalent aromatic group is not limited as long as it is an aromatic divalent group.

The divalent aromatic group may be either an aromatic hydrocarbon group or a heteroaromatic group. The aromatic group may be monocyclic or may be polycyclic. The polycyclic aromatic group may be a group in which two rings are fused, a group in which two or more rings are fused, for example, a group bonded by a single bond, or any combination thereof.

The number of ring members in the divalent aromatic group may be, in total, 6 to 30, preferably 6 to 24, more preferably 6 to 20, even more preferably 6 to 14, and particularly preferably 6 to 12.

In one embodiment, R^{Ar} is a C₆₋₂₀ arylene group.

In one embodiment, R^{Ar} is each independently represented by the following formula.

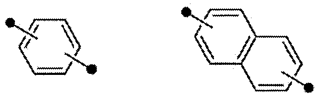

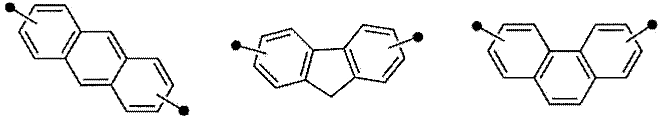

In one embodiment, R^{Ar} may be an o-phenylene group, a m-phenylene group, a p-phenylene group, a 2-methyl-1,4-phenylene group, a 2,5-dimethyl-1,4-phenylene group, a 1,2-naphthylene group, a 1,4-naphthylene group, a 1,5-naphthylene group, a 9,10-anthrylene group, a 9,10-phenanthrylene group, or a 4,4'-biphenylylene group.

In a preferable embodiment, R^{Ar} is a phenylene group, and particularly preferably a p-phenylene group.

The divalent aromatic group may have a substituent. The number of substituents is not limited, and is, for example, 1 to 4, and preferably 1 or 2.

In a preferable embodiment, R^{Ar} is an unsubstituted phenylene group.
γ1 is 0 or 1. In one embodiment, γ1 is 0. In one embodiment, γ1 is 1.
γ2 is 0 or 1, and in one embodiment, γ2 is 0. In one embodiment, γ2 is 1.

In one embodiment, R^{A1} is a group represented by the following formula (A5):

R^{13a}-(SiR^{14a}₂O)ₙ-SiR^{14a}₂-

wherein
R^{13a} is a C₁₋₁₂ alkyl group,
R^{14a} is each independently a C₁₋₁₂ alkyl group, and
n is 1 to 1,500.

The C₁₋₁₂ alkyl group in R^{13a} may be linear or may be branched. In one embodiment, the C₁₋₁₂ alkyl group is linear. In another embodiment, the C₁₋₁₂ alkyl group is branched. The C₁₋₁₂ alkyl group is preferably a C₁₋₆ alkyl group, more preferably a C₁₋₃ alkyl group, even more preferably a methyl group or an ethyl group, and particularly preferably a methyl group.

In one embodiment, R^{13a} is a C₁₋₆ alkyl group, preferably a C₁₋₃ alkyl group, and more preferably a methyl group.

In one embodiment, R^{13a} is a C₁₋₆ alkyl group, preferably a C₁₋₄ alkyl group, and more preferably a n-butyl group.

The C₁₋₁₂ alkyl group in R^{14a} may be linear or may be branched. In one embodiment, the C₁₋₁₂ alkyl group is linear. In another embodiment, the C₁₋₁₂ alkyl group is branched. The C₁₋₁₂ alkyl group is preferably a C₁₋₆ alkyl group, more preferably a C₁₋₃ alkyl group, even more preferably a methyl group, an ethyl group or a n-butyl group, and particularly preferably a methyl group or a n-butyl group. In one embodiment, R^{14a} is a methyl group. In another embodiment, R^{14a} is a n-butyl group.

n is 1 to 1,500, preferably 1 to 500, more preferably 1 to 10, and even more preferably 1 or 2.

In one embodiment, n is 10 to 500, and more preferably 10 to 100.

In a preferable embodiment, R^{13a} is methyl, R^{14a} is a methyl or n-butyl group, and n is 1 or 2.

In one embodiment, R^{A1} may be a monovalent organic group that comprises one or more Si atoms to which neither a hydroxyl group nor a hydrolyzable group is directly bonded and that does not comprise a siloxane bond.

In one embodiment, R^{A1} is a group represented by the following formula:

-SiR^{15a}₃

wherein
R^{15a} is each independently a C₁₋₆ alkyl group, or -SiR^{16a}₃, and
R^{16a} is each independently a C₁₋₆ alkyl group.

The C₁₋₆ alkyl group in R^{15a} may be linear or may be branched. In one embodiment, the C₁₋₆ alkyl group is linear. In another embodiment, the C₁₋₆ alkyl group is branched. The C₁₋₆ alkyl group is preferably a C₁₋₄ alkyl group, and more preferably a methyl group or a butyl group. In one embodiment, R^{15a} is a methyl group. In another embodiment, R^{15a} is a butyl group.

The C₁₋₁₂ alkyl group in R^{16a} may be linear or may be branched. In one embodiment, the C₁₋₁₂ alkyl group is linear. In another embodiment, the C₁₋₁₂ alkyl group is branched. The C₁₋₁₂ alkyl group is preferably a C₁₋₆ alkyl group, more preferably a C₁₋₃ alkyl group, even more preferably a methyl group or an ethyl group, and particularly preferably a methyl group.

SiR^{15a}₃ may be preferably, -Si(CH₃)₃, -Si(CH₂CH₃)₃, -Si(CH(CH₃)₂)₃, - Si(CH₃) (CH₃) (C(CH₃)₃)), -Si(Si(CH₃)₃, or -Si(Si(CH₂CH₃)₃.

In one embodiment, R^{A1} is represented by the following formula:

R^{17a}-R^{S}-(SiR^{18a}₂)ₛ- (A6)

in the formula (A6),
R^{17a} is a hydrocarbon group, or R^{18a}ₙₐ₁R^{19a}₃₋ₙₐ₁Si-(O)_{z}-,
   R^{18a} is a group represented by R^{21a}-(SiR^{21a}₂-R^{20a})ₘₐ₁-,
   R^{20a} is an oxygen atom, or a C₁₋₆ alkylene group,
   R^{21a} is a hydrocarbon group or R^{18a'},
   R^{18a'} has the same meaning as R^{18a},
   ma1 is each independently an integer of 1 to 5,
   provided that the number of R^{18a'} in R^{18a} is 20 or less,
R^{19a} is each independently a hydrocarbon group,
na1 is an integer of 1 to 3,
z is 0 or 1,
s is 0 or 1, and
R^{S} has the same meaning as above.
R^{17a} is a hydrocarbon group, or R^{18a}ₙₐ₁R^{19a}₃₋ₙₐ₁Si-(O)_{z}-.

In one embodiment, the hydrocarbon group in R^{17a} may be preferably an alkyl group or an aryl group.

The alkyl group may be linear or may be branched. The alkyl group is preferably a C₁₋₆ alkyl group, and more preferably a C₁₋₄ alkyl group. The alkyl group is particularly preferably a methyl group, an ethyl group, a n-propyl group, an iso-propyl group, a n-butyl group or a tert-butyl group.

The aryl group may be monocyclic or may be polycyclic. The aryl group is preferably a C₆₋₂₀ aryl group, and more preferably a C₆₋₁₀ aryl group. The aryl group is particularly preferably a phenyl group.

The hydrocarbon group in R^{17a} is preferably an alkyl group, and more preferably a C₁₋₄ alkyl group.

In one embodiment, R^{17a} is a C₁₋₆ alkyl group, preferably a C₁₋₃ alkyl group, and more preferably a methyl group.

In one embodiment, R^{17a} is a C₁₋₆ alkyl group, preferably a C₁₋₄ alkyl group, and more preferably a n-butyl group.

In one embodiment, R^{17a} is a C₁₋₆ alkyl group, preferably a C₁₋₃ alkyl group, and more preferably a methyl group.

In one embodiment, R^{17a} is a C₁₋₆ alkyl group, preferably a C₁₋₄ alkyl group, and more preferably a n-butyl group.

In one embodiment, R^{17a} is R^{18a}ₙₐ₁R^{19a}₃₋ₙₐ₁Si-(O)_{z}-.

R^{18a} is each independently a group represented by R^{21a}-(SiR^{21a}₂-R^{20a})ₘₐ₁-.

R^{20a} is each independently an oxygen atom or a C₁₋₆ alkylene group.

The C₁₋₆ alkylene group in R^{20a} may be linear or may be branched. The C₁₋₆ alkylene group may be preferably a C₁₋₄ alkylene group, and more preferably a C₂₋₄ alkylene group.

In one embodiment, R^{20a} is O.

In one embodiment, some R^{20a} groups are O, and other R^{20a} groups are C₁₋₆ alkylene groups.

R^{21a} is each independently a hydrocarbon group or R^{18a'}.

In one embodiment, R^{21a} is a hydrocarbon group.

The hydrocarbon group in R^{21a} may be preferably an alkyl group or an aryl group.

The alkyl group may be linear or may be branched. The alkyl group is preferably a C₁₋₆ alkyl group, and more preferably a C₁₋₄ alkyl group. The alkyl group is particularly preferably a methyl group, an ethyl group, a n-propyl group, an iso-propyl group, a n-butyl group or a tert-butyl group.

The aryl group may be monocyclic or may be polycyclic. The aryl is preferably a C₆₋₂₀ aryl group, and more preferably a C₆₋₁₀ aryl group.
The aryl group is particularly preferably a phenyl group.

The hydrocarbon group in R^{21a} is preferably an alkyl group, and more preferably a C₁₋₄ alkyl group.

In one embodiment, R^{21a} is a C₁₋₆ alkyl group, preferably a C₁₋₃ alkyl group, and more preferably a methyl group.

In one embodiment, R^{21a} is a C₁₋₆ alkyl group, preferably a C₁₋₄ alkyl group, and more preferably a n-butyl group.

In one embodiment, R^{21a} is R^{18a'}.

R^{18a'} has the same meaning as R^{18a}. That is, R^{18a'} is R^{21a}-(SiR^{21a}₂-R^{20a})ₘₐ₁-. However, in R^{18a}, the number of R^{18a'} is 20 or less, preferably 10 or less, more preferably 6 or less, and even more preferably 3 or less.

In one embodiment, R^{21a} is R^{21a'}-(SiR^{21a'}₂-R^{20a'})_{ma1'}-
wherein
R^{21a'} is each independently a hydrocarbon group or R^{21a}-(SiR^{21a}₂-R^{20a})ₘₐ₁-,
at least one R^{21a'} is R^{21a}-(SiR^{21a}₂-R^{20a})ₘₐ₁-,
   R^{20a} is each independently an oxygen atom or a C₁₋₆ alkylene group,
   R^{21a} is each independently a hydrocarbon group,
   ma1 is each independently an integer of 1 to 5,
R^{20a}' is each independently an oxygen atom or a C₁₋₆ alkylene group, and
mal' is each independently an integer of 1 to 5.

In another embodiment, R^{21a} is R^{21a'}-(SiR^{21a'}₂-R^{20a'})m_{a1'}-
wherein
R^{20a'} is each independently an oxygen atom or a C₁₋₆ alkylene group,
R^{21a'} is each independently a hydrocarbon group or R^{21a"}-(SiR^{21a"}₂-R^{20a"})_{ma1"}-,
at least one R^{21a'} is R^{21a"}-(SiR^{21a"}₂-R^{20a"})_{ma1"}-,
   R^{21a"} is each independently a hydrocarbon group or R^{21a}-(SiR^{21a}₂-R^{20a})ₘₐ₁-,
   at least one R^{21a"} is -(R^{20a}-SiR^{21a}₂)ₘₐ₁-R^{21a},
      R^{20a} is each independently an oxygen atom or a C₁₋₆ alkylene group,
      R^{21a} is each independently a hydrocarbon group,
      ma1 is each independently an integer of 1 to 5,
   R^{20a"} is each independently an oxygen atom or a C₁₋₆ alkylene group,
   ma1" is each independently an integer of 1 to 5, and
ma1" is each independently an integer of 1 to 5.
ma1 is each independently an integer of 1 to 5, and preferably 1 or 2.
R^{19a} is each independently a hydrocarbon group.

The hydrocarbon group in R^{19a} may be preferably an alkyl group or an aryl group.

The alkyl group may be linear or may be branched. The alkyl group is preferably a C₁₋₆ alkyl group, and more preferably a C₁₋₄ alkyl group. The alkyl group is particularly preferably a methyl group, an ethyl group, a n-propyl group, an iso-propyl group, a n-butyl group or a tert-butyl group.

The aryl group may be monocyclic or may be polycyclic. The aryl is preferably a C₆₋₂₀ aryl group, and more preferably a C₆₋₁₀ aryl group. The aryl group is particularly preferably a phenyl group.

R^{19a} is preferably an alkyl group, and more preferably a C₁₋₄ alkyl group.

In one embodiment, R^{19a} is a C₁₋₆ alkyl group, preferably a C₁₋₃ alkyl group, and more preferably a methyl group.

In one embodiment, R^{19a} is a C₁₋₆ alkyl group, preferably a C₁₋₄ alkyl group, and more preferably a n-butyl group.
na1 is 1 to 3. In one embodiment, na1 is 2. In another embodiment, na1 is 3. Note that na1, when R^{18a'} is present, is independently selected for (Si^{21a}₂-R^{20a})ₘₐ₁.
z is 0 or 1. In one embodiment, z is 0. In another embodiment, z is 1.
s is 0 or 1. In one embodiment, s is 0. In another embodiment, s is 1.

In R^{18a}, 2 or more, preferably 3 or more, more preferably 4 or more, even more preferably 6 or more, for example, 8 or more, 9 or more, 10 or more, or 12 or more Si-O bonds are present.

In a preferable embodiment, in R^{18a}ₙₐ₁R^{19a}₃₋ₙₐ₁Si-(O)_{z}-,
R^{18a} is each independently a group represented by R^{21a}-(Si^{21a}₂-R^{20a})ₘₐ₁-,
   R^{20a} is each independently an oxygen atom or a C1-6 alkylene group,
   R^{21a} is each independently a hydrocarbon group (preferably a C₁₋₄ alkyl group), or R^{18a'} is preferably a hydrocarbon group (preferably a C₁₋₄ alkyl group),
      R^{18a'} has the same meaning as R^{18a},
   ma1 is 1 or 2,
R^{19a} is each independently a hydrocarbon group, and preferably a C₁₋₄ alkyl group,
na1 is 1 to 3, and
z is 0 or 1, and preferably 0.

Examples of the group represented by R^{18a}ₙₐ₁R^{19a}₃₋ₙₐ₁Si-(O)_{z}- include, but are not limited to, the following groups.

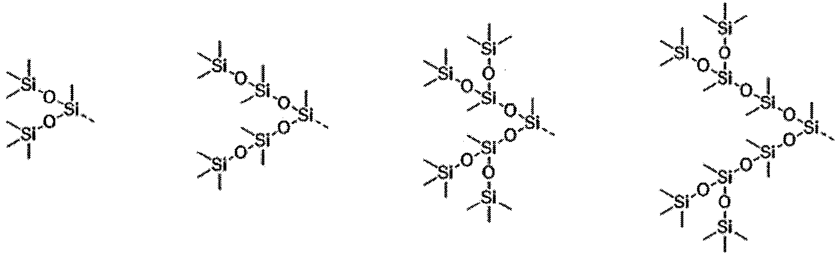

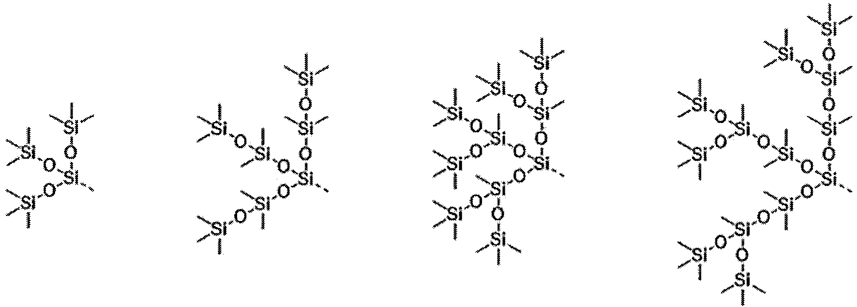

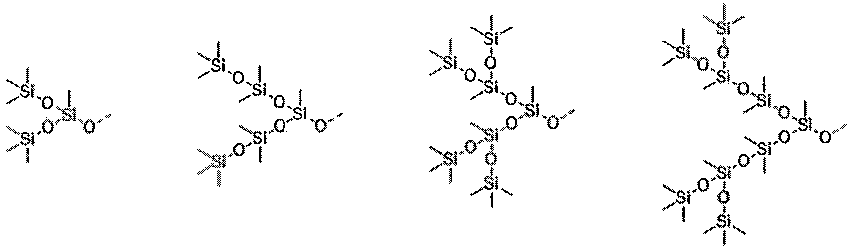

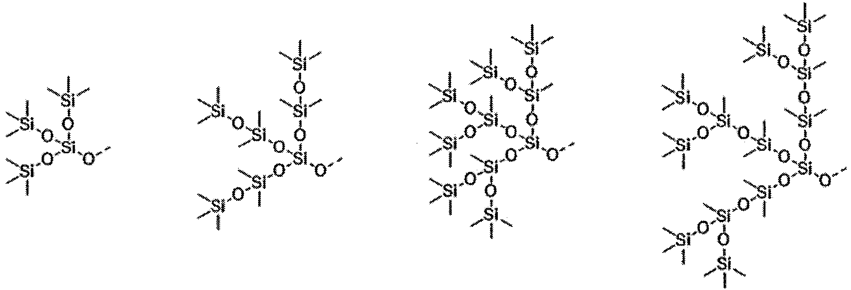

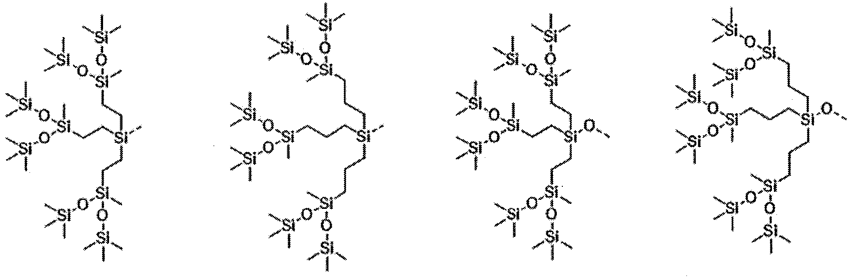

In a preferable embodiment, the group is the following group:

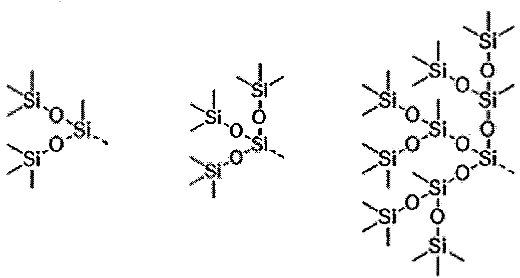

Examples of the hydrocarbon group represented by R^{A1} include an alkyl group having 7 or more carbon atoms. That is, the silane compound may comprise a compound in which R^{A1} is an alkyl group having 7 or more carbon atoms. Examples of such an alkyl group include a C₁₁₋₃₆ alkyl group, a linear alkyl group having 7 or more carbon atoms, and R^{101a}-R^{102a}- (R^{101a} represents a C₃₋₈ branched alkyl group branched on a carbon atom, and R^{102a} represents a linear C₄₋₃₆ alkylene group).

In one preferable embodiment, R^{A1} is preferably a C₁₁₋₃₆ alkyl group.

In the above embodiment, when the atom bonded to R^{A1} in X^{A} is an atom other than a carbon atom, the number of carbon atoms of the C₁₁₋₃₆ alkyl group represented by R^{A1} is preferably 16, more preferably 18, and even more preferably 19, and may be, for example, 21, or 23. The upper limit of the number of carbon atoms is preferably 32, and more preferably 28, and may be, for example, 26 or 23. R^{A1} may be preferably a linear C₁₈₋₃₆ alkyl group, and more preferably a C₁₈₋₂₃ alkyl group.

In the above embodiment, when the atom bonded to R^{A1} in X^{A} is a carbon atom, the lower limit of the number of carbon atoms of the C₁₁₋₃₆ alkyl group represented by R^{A1} is preferably 15, more preferably 17, and even more preferably 18, and may be, for example, 20, or 22. The upper limit of the number of carbon atoms is preferably 31, and more preferably 27, and may be, for example, 25 or 22. R^{A1} may be preferably a linear C₁₇₋₃₅ alkyl group, and more preferably a C₁₇₋₂₂ alkyl group.

In another preferable embodiment, R^{A1} is preferably a linear alkyl group having 7 or more carbon atoms.

In the above embodiment, when the atom bonded to R^{A1} in X^{A} is an atom other than a carbon atom, the lower limit of the number of carbon atoms in R^{A1} is preferably 10, more preferably 16, and even more preferably 19, and may be, for example, 21 or 23. The upper limit of the number of carbon atoms is preferably 32, and more preferably 28, and may be, for example, 26 or 23. R^{A1} may be preferably a linear C₁₀₋₃₂ alkyl group, and more preferably a C₁₆₋₂₂ alkyl group.

In the above embodiment, when the atom bonded to R^{A1} in X^{A} is a carbon atom, the lower limit of the number of carbon atoms in R^{A1} is preferably 9, more preferably 15, and even more preferably 18, and may be, for example, 20 or 22. The upper limit of the number of carbon atoms is preferably 31, and more preferably 27, and may be, for example, 25 or 22. R^{A1} may be preferably a linear C₉₋₃₁ alkyl group, and more preferably a C₁₅₋₂₁ alkyl group.

In yet another embodiment, R^{A1} is preferably a group represented by the following formula:

R^{101a}-R^{102a}-

wherein
R^{101a} represents a C₃₋₈ branched alkyl group branched on a carbon atom, and
R^{102a} represents a linear C₄₋₃₆ alkylene group.

R^{101a} is a C₃₋₈ branched alkyl group branched on a carbon atom bonded to R^{102a} (hereinafter, also simply referred to as "branched alkyl group"). In the branched alkyl group, the carbon atom bonded to R^{102a} is a secondary or tertiary carbon atom.

In one embodiment, the carbon atom bonded to R^{102a}, in the branched alkyl group, is a secondary carbon atom.

In another embodiment, the carbon atom bonded to R^{102a}, in the branched alkyl group, is a tertiary carbon atom.

A carbon atom other than the carbon atom bonded to R^{102a}, in the C₃₋₈ branched alkyl group, may have a branched structure. That is, the carbon chain bonded to the carbon atom bonded to R^{102a} may be linear or may be branched, or both of linear and branched chains may be present.

In one embodiment, the carbon chain bonded to the carbon atom bonded to R^{102a} is linear.

R^{101a} is preferably a C₃₋₅ branched alkyl group, and may be, for example, a C₃₋₄ branched alkyl group.

R^{101a} may be more preferably an isopropyl group, a 1-methylpropyl group, a 1,1-dimethylpropyl group, a 1-methylbutyl group, or a tert-butyl group.

R^{102a} is a linear C₄₋₃₆ alkylene group.

The lower limit of the number of carbon atoms in R^{102a} is preferably 8, more preferably 12, and even more preferably 16, and may be, for example, 18, 20, or 22. The upper limit of the number of carbon atoms is preferably 28 and more preferably 26, and may be, for example, 24 or 22. R1b is preferably a linear C₈₋₂₈ alkylene group and more preferably a C₈₋₂₆ alkylene group, and may be, for example, a C₁₂₋₂₈ alkylene group or a C₁₂₋₂₆ alkylene group.

The total number of carbon atoms in R^{101a} and R^{102a} is 12 or more, and preferably 13 or more, and may be, for example, 14 or more, 16 or more, or 18 or more. The upper limit of the number of carbon atoms in R^{101a} and R^{102a} is preferably 32, and more preferably 30, and may be, for example, 28, or 26.

The hydrocarbon group represented by R^{A1} may also be CH₃-CH=CH-. That is, the silane compound may comprise a compound in which R^{A1} is CH₃-CH=CH-.

In one embodiment, R^{A1} is a group having a branched structure of at least one Si.

The branched structure is preferably the following structure: 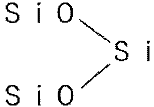 In the formula, a Si atom is tetravalent, but other bonds are not denoted.

In one embodiment, the branched structure may be the following structure: 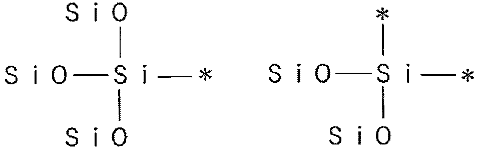
[* represents a bonding site]
That is, the structure may be branched to two SiO or may be branched to three SiO. In the formula, a Si atom in SiO is tetravalent, but other bonds are not denoted.

The bonding site represented by * is optionally bonded to any other group not bonded to X^{A} that may be comprised in R^{A1}, optionally bonded to a group bonded to X^{A} that may be comprised in R^{A1}, or optionally directly bonded to X^{A}. When one * is comprised in the branched structure, * is preferably directly bonded to a group bonded to X^{A} that may be comprised in R^{A1}, or X^{A}. When 2 or more * are comprised, these * are each independently optionally bonded to any other group not bonded to X^{A} that may be comprised in R^{A1}, or optionally bonded to a group bonded to X^{A} that may be comprised in R^{A1}, or X^{A}, and at least one * is preferably bonded to X^{A} or a group bonded to X^{A}.

X^{A} is interpreted as a linker connecting the moiety (R^{A1} or R^{A2}) that mainly provides functions such as water-repellency and abrasion resistance, and the silane moiety (R^{Si}) that provides an ability to bind to a substrate. Accordingly, X^{A} is not limited as long as the silane compound represented by the formula (1) or (2) can stably exist.

In one embodiment, X^{A} is each independently a di- to decavalent group comprising a partial structure selected from a single bond, a C₁₋₆₀ alkylene group, - CO-, -COO-, -OCO-, -NR⁴¹-, -CONR⁴¹-, -NR⁴¹CO-, -OCONR⁴¹-, -NR⁴¹COO-, - NR⁴¹-CO-NR⁴¹-, -O-, -S-, -CON= or R^{S}, and is, for example, a di- or trivalent group, and x is an integer of 1 to 20.

When the silane compound comprises plural kinds of the compounds represented by the formula (1) or the formula (2), X^{A} in these compounds may have the same partial structure or different partial structures. In this case, the partial structure is selected from a single bond, a C₁₋₆₀ alkylene group, -CO-, -COO-, - NR⁴¹-, -CONR⁴¹-, -OCONR⁴¹-, -NR⁴¹-CO-NR⁴¹-, -O-, -S-, and -CON= and R^{S}.

R⁴¹ is a hydrogen atom, an oxyalkylene-containing group or a C₁₋₆ alkyl group. The C₁₋₆ alkyl group in R⁴¹ may be linear or may be branched. In one embodiment, the C₁₋₆ alkyl group is linear. In another embodiment, the C₁₋₆ alkyl group is branched. The C₁₋₆ alkyl group is preferably a C₁₋₄ alkyl group, more preferably a C₁₋₃ alkyl group, even more preferably a methyl group or an ethyl group, and particularly preferably a methyl group.

The oxyalkylene-containing group in R⁴¹ is a group comprising -O-alkylene-, and may be representatively an oxyalkylene-containing group having 1 to 10 carbon atoms. The oxyalkylene-containing group having 1 to 10 carbon atoms is a group comprising -O-C₁₋₁₀ alkylene-, and is, for example, -R⁵⁵-(-O-C₁₋₁₀ alkylene)ₙ-R⁵⁶ (wherein R⁵⁵ is a single bond or a divalent organic group, and preferably a C₁₋₆ alkylene group, n is any integer, and preferably an integer of 2 to 10, and R⁵⁶ is a hydrogen atom or a monovalent organic group, and preferably a C₁₋₆ alkyl group). The alkylene group may be linear or may be branched.

In one embodiment, R⁴¹ is a hydrogen atom.

In one embodiment, R⁴¹ is a C₁₋₆ alkyl group, preferably a methyl group.

The C₁₋₆₀ alkylene group in the partial structure is more preferably a C₁₀₋₃₀ alkylene group, and even more preferably a C₁₀₋₂₂ alkylene group, may be linear or may be branched, and is preferably linear.

In one embodiment, the partial structure comprised in X^{A} is an alkylene group having 10 to 30 carbon atoms.

In one embodiment, the partial structure comprised in X^{A} is an alkylene group having 10 carbon atoms.

In one embodiment, the partial structure comprised in X^{A} is an alkylene group having 22 carbon atoms.

X^{A} is preferably a group represented by the following formula:

-(X¹²¹)ₐ₀-X¹¹⁰-[(X¹¹¹)ₐ₁₋(X¹¹²)ₐ₂]-

wherein
X¹²¹ is R¹⁶¹_{b1}R¹⁶²_{3-b1}C-, R¹⁶³_{b2}R¹⁶⁴_{3-b2}Si-, or R¹⁶⁵₂N-,
   R¹⁶¹ is each independently a single bond or a divalent organic group,
   R¹⁶² is a hydrogen atom, or a monovalent organic group,
   R¹⁶³ is each independently a single bond or a divalent organic group,
   R¹⁶⁴ is a hydrogen atom, or a monovalent organic group,
   R¹⁶⁵ is each independently a single bond or a divalent organic group,
   b1 is 2 or 3,
   b2 is 2 or 3,
X¹¹⁰ is a single bond or an alkylene group having 1 or more carbon atoms,
X¹¹¹ is a single bond or a divalent organic group,
X¹¹² is -CO-, -COO-, -OCO-, -NR⁴¹-, -CONR⁴¹-, -NR⁴¹CO-, -OCONR⁴¹-, - NR⁴¹COO-, -NR⁴¹-CO-NR⁴¹-, -O-, -S-, -CON= or R^{S},
   R⁴¹ is a hydrogen atom, an oxyalkylene-containing group or a C₁₋₆ alkyl group,
   R^{S} is a group represented by the following formula: 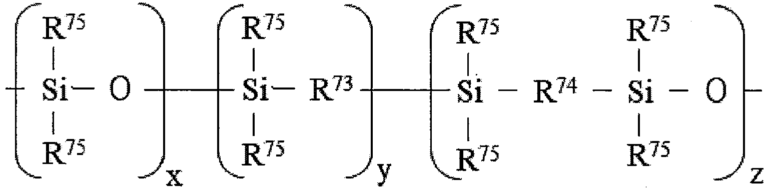 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted arylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
a0 is 0 or 1,
a1 is an integer of 1 to 5,
a2 is an integer of 0 to 5, and
the occurrence order of the respective repeating units enclosed in parentheses provided with a1 or a2 is not limited in the formula; or
a group represented by formula (X^{A1}): 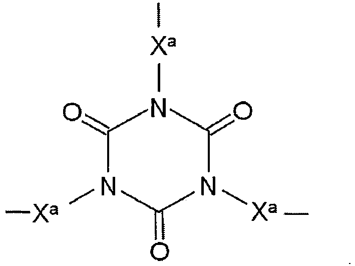 wherein X^{a} is each independently a single bond or a divalent linking group; and the left side of the group X^{A} binds to R^{A1} or R^{A2} and the right side thereof binds to R^{Si}.
X¹²¹ is R¹⁶¹_{b1}R¹⁶²_{3-b1}C-, R¹⁶³_{b2}R¹⁶⁴_{3-b2}Si-, or R¹⁶⁵₂N-.
R¹⁶¹ is a divalent organic group.
R¹⁶¹ is preferably a C₁₋₆ alkylene group, -(CH₂)_{f1}-O-(CH₂)_{f2}- (wherein f1 is an integer of 0 to 6 such as an integer of 1 to 6, and f2 is an integer of 0 to 6 such as an integer of 1 to 6), or -(CH₂)_{f3}-phenylene-(CH₂)_{f4}- (wherein f3 is an integer of 0 to 6 such as an integer of 1 to 6, and f4 is an integer of 0 to 6 such as an integer of 1 to 6). Such a C₁₋₆ alkylene group may be linear or may be branched, and is preferably linear. These groups may be substituted with one or more substituents selected from, for example, a C₁₋₆ alkyl group, a C₂₋₆ alkenyl group, and a C₂₋₆ alkynyl group, and are preferably unsubstituted.

In a preferable embodiment, R¹⁶¹ is a C₁₋₆ alkylene group or -(CH₂)_{f3}-phenylene-(CH₂)_{f4}-, and preferably -phenylene-(CH₂)_{f4}-.

In another preferable embodiment, R¹⁶¹ is a C₁₋₃ alkylene group. In one embodiment, R¹⁶¹ may be -CH₂CH₂CH₂-. In another embodiment, R¹⁶¹ may be - CH₂CH₂-.

R¹⁶² is a hydrogen atom or a monovalent organic group.

In one embodiment, R¹⁶² is a hydrogen atom.

In another embodiment, R¹⁶² is a monovalent organic group.

In R¹⁶², the monovalent organic group is preferably a C₁₋₂₀ alkyl group, more preferably a C₁₋₆ alkyl group, and even more preferably a methyl group.

b1 is 2 or 3. In one embodiment, b1 is 2. In another embodiment, b1 is 3.

R¹⁶³ is a divalent organic group.

R¹⁶³ is preferably a C₁₋₆ alkylene group, -(CH₂)_{g1}-O-(CH₂)_{g2}- (wherein g1 is an integer of 0 to 6 such as an integer of 1 to 6, and g2 is an integer of 0 to 6 such as an integer of 1 to 6), or -(CH₂)_{g3}-phenylene-(CH₂)_{g4}- (wherein g3 is an integer of 0 to 6 such as an integer of 1 to 6, and g4 is an integer of 0 to 6 such as an integer of 1 to 6). Such a C₁₋₆ alkylene group may be linear or may be branched, and is preferably linear. These groups may be substituted with one or more substituents selected from, for example, a C₁₋₆ alkyl group, a C₂₋₆ alkenyl group, and a C₂₋₆ alkynyl group, and are preferably unsubstituted.

In a preferable embodiment, R¹⁶³ is a C₁₋₆ alkylene group or -(CH₂)_{g3}-phenylene-(CH₂)_{g4}-, and preferably -phenylene-(CH₂)_{g4}-.

In another preferable embodiment, R¹⁶³ is a C₁₋₃ alkylene group. In one embodiment, R¹⁶³ may be -CH₂CH₂CH₂-. In another embodiment, R¹⁶³ may be - CH₂CH₂-.

R⁶⁴ is a hydrogen atom or a monovalent organic group.

In one embodiment, R¹⁶⁴ is a hydrogen atom.

In another embodiment, R¹⁶⁴ is a monovalent organic group.

In R¹⁶⁴, the monovalent organic group is preferably a C₁₋₂₀ alkyl group, more preferably a C₁₋₆ alkyl group, and even more preferably a methyl group.

b2 is 2 or 3. In one embodiment, b2 is 2. In another embodiment, b2 is 3.

R¹⁶⁵ is a divalent organic group.

R¹⁶⁵ is preferably a C₁₋₆ alkylene group, -(CH₂)ₕ₁-O-(CH₂)ₕ₂- (wherein h1 is an integer of 0 to 6 such as an integer of 1 to 6, and h2 is an integer of 0 to 6 such as an integer of 1 to 6), or -(CH₂)ₕ₃-phenylene-(CH₂)ₕ₄- (wherein h3 is an integer of 0 to 6 such as an integer of 1 to 6, and h4 is an integer of 0 to 6 such as an integer of 1 to 6). Such a C₁₋₆ alkylene group may be linear or may be branched, and is preferably linear. These groups may be substituted with one or more substituents selected from, for example, a C₁₋₆ alkyl group, a C₂₋₆ alkenyl group, and a C₂₋₆ alkynyl group, and are preferably unsubstituted.

In a preferable embodiment, R¹⁶⁵ is a C₁₋₆ alkylene group or -(CH₂)ₕ₃-phenylene-(CH₂)ₕ₄-, and preferably -phenylene-(CH₂)ₕ₄-.

In another preferable embodiment, R¹⁶⁵ is a C₁₋₃ alkylene group. In one embodiment, R¹⁶⁵ may be -CH₂CH₂CH₂-. In another embodiment, R¹⁶⁵ may be-CH₂CH₂-.

In one embodiment, X¹²¹ is R¹⁶¹_{b1}R¹⁶²_{3-b1}C-.

In one embodiment, X¹²¹ is R¹⁶³_{b2}R¹⁶⁴_{3-b2}Si-.

In one embodiment, X¹²¹ is R¹⁶⁵₂N-.

X¹¹⁰ is a single bond or an alkylene group having 1 or more carbon atoms.

The number of carbon atoms of the alkylene group in X¹¹⁰ is preferably 1 or more, more preferably 3 or more, even more preferably 6 or more, yet more preferably 10 or more, and further preferably 12 or more, and may be, for example, 16 or more, 18 or more, or 22 or more. The number of carbon atoms of the alkylene group in X¹¹⁰ may be preferably 60 or less, more preferably 40 or less, even more preferably 30 or less, and yet more preferably 24 or less. The number of carbon atoms of the alkylene group in X¹¹⁰ may be preferably 3 to 60, more preferably 6 to 40, and even more preferably 10 to 30.

The alkylene group in X¹¹⁰ may be linear or may be branched. The alkylene group is preferably linear.

X¹¹¹ is a single bond or a divalent organic group.

The divalent organic group is preferably a divalent hydrocarbon group.

The hydrocarbon group in X¹¹¹ is preferably a hydrocarbon group having 1 to 60 carbon atoms, more preferably a hydrocarbon group having 1 to 30 carbon atoms.

The hydrocarbon group may be preferably an alkylene group or an arylene group.

The alkylene group may be linear or may be branched. The alkylene group may be preferably an alkylene group having 1 to 60 carbon atoms, more preferably an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

In one embodiment, the alkylene group may be, for example, a C₁₀₋₃₀ alkylene group. The number of carbon atoms of such an alkylene group may be preferably 10 or more, more preferably 16 or more, even more preferably 18 or more, and yet more preferably 22 or more. The number of carbon atoms of the alkylene group in X¹¹¹ may be preferably 60 or less, more preferably 40 or less, even more preferably 30 or less, and yet more preferably 24 or less. The number of carbon atoms of the alkylene group in X¹¹¹ may be preferably 10 to 60, more preferably 10 to 40, and even more preferably 16 to 30.

In one embodiment, the alkylene group may be, for example, a C₁₁₋₃₀ alkylene group. The number of carbon atoms of such an alkylene group may be preferably 10 or more, more preferably 16 or more, even more preferably 18 or more, and yet more preferably 22 or more. The number of carbon atoms of the alkylene group in X¹¹¹ may be preferably 60 or less, more preferably 40 or less, even more preferably 30 or less, and yet more preferably 24 or less. The number of carbon atoms of the alkylene group in X¹¹¹ may be preferably 11 to 60, more preferably 12 to 40, and even more preferably 16 to 30.

The arylene group may be monocyclic or may be polycyclic. The arylene group is preferably an arylene group having 6 to 20 carbon atoms, and more preferably an arylene group having 6 to 10 carbon atoms. The arylene group is particularly preferably a phenylene group.

In one embodiment, X¹¹¹ is a group represented by

-X¹¹³-X¹¹²-X¹¹⁴-

wherein
X¹¹³ is an alkylene group, an oxyalkylene group, or -(CⱼH₂ⱼ)ₖ₁-(O-CⱼH₂ⱼ)ₖ₂ (wherein j is an integer of 1 to 6, k1 is 1 or 0, and k2 is an integer of 1 to 20),
X¹¹² is -CO-, -COO-, -OCO-, -NR⁴¹-, -CONR⁴¹-, -NR⁴¹CO-, -OCONR⁴¹-, - NR⁴¹COO-, -NR⁴¹-CO-NR⁴¹-, -O-, or -S-, preferably -CO-, -NR⁴¹-, -CONR⁴¹-, or - NR⁴¹CO-, and more preferably -CONR⁴¹- or -NR⁴¹CO-,
   R⁴¹ is a hydrogen atom, an oxyalkylene-containing group or a C₁₋₆ alkyl group, and preferably a hydrogen atom, and
X¹¹⁴ is a single bond or an alkylene group.

X¹¹³ is an alkylene group, an oxyalkylene group, or -(CⱼH₂ⱼ)ₖ₁-(O-CⱼH₂ⱼ)ₖ₂ (wherein j is an integer of 1 to 6, k1 is 1 or 0, and k2 is an integer of 1 to 20).

The alkylene group may be linear or may be branched. The alkylene group may be preferably an alkylene group having 1 to 60 carbon atoms, more preferably an alkylene group having 1 to 30 carbon atoms.

In one embodiment, the alkylene group may be, for example, a C₁₋₁₆ alkylene group, a C₁₋₈ alkylene group, a C₁₋₆ alkylene group, a C₂₋₁₀ alkylene group, a C₂₋₈ alkylene group, or a C₂₋₆ alkylene group.

In one embodiment, the alkylene group may be, for example, a C₁₀₋₃₀ alkylene group. The number of carbon atoms of such an alkylene group may be preferably 12 or more, more preferably 16 or more, even more preferably 18 or more, and yet more preferably 22 or more. The number of carbon atoms of the alkylene group in X¹¹³ may be preferably 60 or less, more preferably 40 or less, even more preferably 30 or less, and yet more preferably 24 or less. The number of carbon atoms of the alkylene group in X¹¹³ may be preferably 10 to 60, more preferably 10 to 40, and even more preferably 16 to 30.

In one embodiment, the alkylene group may be, for example, a C₁₁₋₃₀ alkylene group. The number of carbon atoms of the alkylene group may preferably be 12 or more, more preferably 16 or more, even more preferably 18 or more, and yet more preferably 22 or more. The number of carbon atoms of the alkylene group in X¹¹³ may be preferably 60 or less, more preferably 40 or less, even more preferably 30 or less, yet more preferably 24 or less. The number of carbon atoms of the alkylene group in X¹¹³ may be preferably 11 to 60, more preferably 12 to 40, and even more preferably 16 to 30.

The oxyalkylene group is a group having an oxygen atom on the left side (R^{1A} or R^{A2} side) of the alkylene group, namely, a -O- alkylene group.

j is an integer of 1 to 6, and preferably an integer of 2 to 4.

k1 is 1 or 0, and preferably 0.

k2 is an integer of 1 to 20, preferably an integer of 2 to 10, and more preferably an integer of 2 to 6.

X¹¹⁴ is an alkylene group.

The alkylene group may be linear or may be branched. The alkylene group may be preferably an alkylene group having 1 to 60 carbon atoms, more preferably an alkylene group having 1 to 30 carbon atoms, preferably a C₁₋₁₀ alkylene group, more preferably a C₁₋₈ alkylene group, and even more preferably a C₁₋₆ alkylene group, such as a C₂₋₁₀ alkylene group, a C₂₋₈ alkylene group, or a C₂₋₆ alkylene group.

In one embodiment, X¹¹¹ is

-O-R^{S}-X¹¹³-X¹¹²-X¹¹⁴-

wherein
R^{S} is a group represented by the following formula: 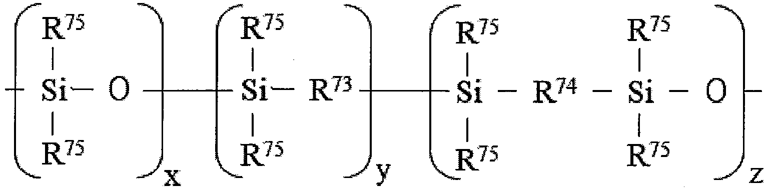 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an arylene group optionally substituted,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
X¹¹² is -CO-, -COO-, -OCO-, -NR⁴¹-, -CONR⁴¹-, -NR⁴¹CO-, -OCONR⁴¹-, - NR⁴¹COO-, -NR⁴¹-CO-NR⁴¹-, -O-, or -S-, preferably -CO-, -NR⁴¹-, -CONR⁴¹-, or - NR⁴¹CO-, and more preferably -CONR⁴¹- or -NR⁴¹CO-,
   R⁴¹ is a hydrogen atom, an oxyalkylene-containing group or a C₁₋₆ alkyl group, and preferably a hydrogen atom,
X¹¹³ is an alkylene group, an oxyalkylene group, or -(CⱼH₂ⱼ)ₖ₁-(O-CⱼH₂ⱼ)ₖ₂ (wherein j is an integer of 1 to 6, k1 is 1 or 0, and k2 is an integer of 1 to 20), and
X¹¹⁴ is a single bond or an alkylene group.

In one embodiment, X¹¹¹ is a group represented by

-X¹¹⁵-R^{S}-X¹¹³-X¹¹²-X¹¹⁴-

wherein
R^{S} is a group represented by the following formula: 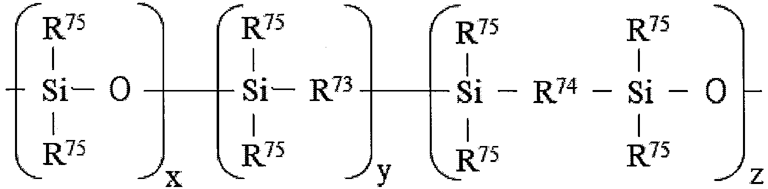 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
   R⁷⁶ is each independently a C₁₋₆ alkylene group,
   R⁷⁷ is each independently an optionally substituted arylene group,
   R⁷⁸ is each independently a single bond or a C₁₋₆ alkylene group,
   R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
X¹¹² is -CO-, -COO-, -OCO-, -NR⁴¹-, -CONR⁴¹-, -NR⁴¹CO-, -OCONR⁴¹-, - NR⁴¹COO-, -NR⁴¹-CO-NR⁴¹-, -O-, or -S-, preferably -CO-, -NR⁴¹-, -CONR⁴¹-, or - NR⁴¹CO-, and more preferably -CONR⁴¹- or -NR⁴¹CO-,
   R⁴¹ is a hydrogen atom, an oxyalkylene-containing group or a C₁₋₆ alkyl group, and preferably a hydrogen atom,
X¹¹³ is an alkylene group, an oxyalkylene group, or -(CⱼH₂ⱼ)ₖ₁-(O-CⱼH₂ⱼ)ₖ₂ (wherein j is an integer of 1 to 6, k1 is 1 or 0, and k2 is an integer of 1 to 20.),
X¹¹⁴ is a single bond, or an alkylene group, and
X¹¹⁵ is an alkylene group, an oxyalkylene group, or -(Cₚ₁₀H₂ₚ₁₀)_{q1}-(O-Cₚ₁₀H₂ₚ₁₀)_{q2} (wherein p10 is an integer of 1 to 6, q1 is 1 or 0, and q2 is an integer of 1 to 20).
X¹¹⁵ is an alkylene group, an oxyalkylene group, or -(CₚH₂ₚ)_{q1}-(O-CₚH₂ₚ)_{q2} wherein p is an integer of 1 to 6, q1 is 1 or 0, and q2 is an integer of 1 to 20.

The alkylene group may be linear or may be branched. The alkylene group may be an alkylene group having preferably 1 to 60, and more preferably 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

The oxyalkylene group is a group having an oxygen atom at the left terminal (the R^{A1} or R^{A2} side) of the alkylene group, i.e., an -O-alkylene group.

p10 is an integer of 1 to 6, and preferably an integer of 2 to 4.

q1 is 1 or 0, and preferably 0.

q2 is an integer of 1 to 20, preferably an integer of 2 to 10, and more preferably an integer of 2 to 6.

In one embodiment, X^{A} may be a group represented by formula (X^{A1}): 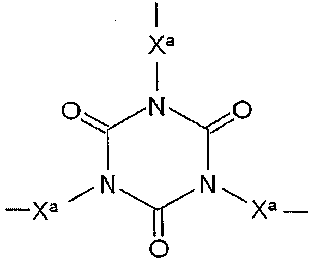 wherein X^{a} is a single bond or a divalent organic group.

X^{a} is a single bond or divalent linking group directly bonded to the isocyanuric ring. X^{a} is preferably a single bond, an alkylene group, or a divalent group comprising at least one bond selected from the group consisting of an ether bond, an ester bond, an amide bond, and a sulfide bond, and more preferably a single bond, an alkylene group having 1 to 10 carbon atoms, or a divalent hydrocarbon group having 1 to 10 carbon atoms and comprising at least one bond selected from the group consisting of an ether bond, an ester bond, an amide bond, and a sulfide bond.

X^{a} is even more preferably a group represented by the following formula:

-(CX¹²¹X¹²²)ₓ₁-(X^{a1})_{y1}-(CX¹²³X¹²⁴)_{z1}-

wherein X¹²¹ to X¹²⁴ are each independently H, OH, or -OSi(OR¹²¹)₃, where three R¹²¹ are each independently an alkyl group having 1 to 4 carbon atoms,
X^{a1} is -C(=O)NH-, -NHC(=O)-, -O-, -C(=O)O-, -OC(=O)-, -OC(=O) O-, - NH-, or -NHC(=O)NH- (left side of each bond binds to CX¹²¹X¹²²), and
x1 is an integer of 0 to 10, y1 is 0 or 1, and z1 is an integer of 1 to 10.

X^{a1} is preferably -O- or -C(=O)O-.

X^{a} is particularly preferably
a group represented by the following formula:

   -(CH₂)ₘ₁₂-O-(CH₂)ₘ₁₃-
wherein m12 is an integer of 1 to 3, and m13 is an integer of 1 to 3,
a group represented by

   -(CH₂)ₘ₁₅-O-CH₂CH(OH)-(CH₂)ₘ₁₆-
wherein m15 is an integer of 1 to 3, and m16 is an integer of 1 to 3,
a group represented by

   -(CH₂)ₘ₁₈-
wherein m18 is an integer of 1 to 3, and
a group represented by

   -(CH₂)ₘ₂₀-O-CH₂CH(OSi(OCH₃)₃)-(CH₂)ₘ₂₁-
wherein m20 is an integer of 1 to 3, and m21 is an integer of 1 to 3.

X^{a} is not limited, and specific examples include -CH₂-, -C₂H₄-, -C₃H₆-, -C₄H₈-, -C₄H₈-O-CH₂-, -CO-O-CH₂-CH(OH)-CH₂-, -S-, - NR¹²¹-, -(CH₂)ₘ₂₂-C(=O)-O-(CH₂)ₘ₂₃-, -(CH₂)ₘ₂₂-O-C(=O)-(CH₂)ₘ₂₃-, -(CH₂)ₘ₂₂-C(=O)-NR¹²¹-(CH₂)ₘ₂₃-, and -(CH₂)ₘ₂₂-NR¹²¹-C(=O)-(CH₂)ₘ₂₃-CH₂OCH₂CH(OSi(OCH₃)₃)CH₂-,
wherein R¹²¹ is a hydrogen atom or a C₁₋₆ hydrocarbon chain, m22 is an integer of 1 to 10, and m23 is an integer of 1 to 10.

In another preferable embodiment, X^{A} may be each independently a divalent organic group comprising an alkylene group having 7 or more carbon atoms. More preferably, X^{A} may be each independently a divalent organic group comprising an alkylene group having 11 or more carbon atoms. Even more preferably, X^{A} may be each independently a divalent organic group further comprising an alkylene group and -CO-, -COO-, -NR⁴¹-, -CONR⁴¹-, -OCONR⁴¹-, -NR⁴¹-CO-NR⁴¹-, -CON=, -O- or -S-. More preferably, X^{A} is a group represented by the following formula:

-X^{10B}-X^{11B}-X^{12B}-

wherein
X^{10B} is an alkylene group having 11 or more carbon atoms,
X^{11B} is a single bond, -CO-, -COO-, -NR⁴¹-, -CONR⁴¹-, -OCONR⁴¹-, -NR⁴¹-CO-NR⁴¹-, -O-, -S-, -O-(CH₂)ₓ-CONR⁴¹-, or -O-(CH₂)ₓ-CO-,
R⁴¹ is a hydrogen atom, an oxyalkylene-containing group or a C₁₋₆ alkyl group,
x is an integer of 1 to 20, and
X^{12B} is a single bond or a C₁₋₆ alkylene group.

The number of carbon atoms of each of the alkylene groups in X^{A} and X^{10B} may be preferably 12 or more, more preferably 16 or more, even more preferably 18 or more, and yet more preferably 22 or more. The number of carbon atoms of each of the alkylene groups in X^{A} and X^{10B} may be preferably 60 or less, more preferably 40 or less, even more preferably 30 or less, and yet more preferably 24 or less. The number of carbon atoms of each of the alkylene groups in X^{A} and X^{10B} may be preferably 11 to 60, more preferably 12 to 40, and even more preferably 16 to 30.

The alkylene groups in X^{A} and X^{10B} may be linear or may be branched. The alkylene groups are preferably linear.

X^{10B} is preferably -CO-, -COO-, -NR⁴¹-, -CONR⁴¹-, -OCONR⁴¹-, -NR⁴¹-CO-NR⁴¹-, -O-, -S-, -O-(CH₂)ₓ-CONR⁴¹-, or -O-(CH₂)ₓ-CO-, more preferably -CO-, - CONR⁴¹-, or -OCONR⁴¹-, and more preferably -CONR⁴¹-. R⁴¹ represents a hydrogen atom, an oxyalkylene-containing group or a C₁₋₆ alkyl group, and preferably a hydrogen atom, and x is an integer of 1 to 20.

In one embodiment, X^{12B} is a single bond.

In another embodiment, X^{12B} is a C₁₋₆ alkylene group.

The C₁₋₆ alkylene group in X^{12B} may be linear or may be branched. In one embodiment, the C₁₋₆ alkylene group is linear. In another embodiment, the C₁₋₆ alkylene group is branched. The C₁₋₆ alkylene group is preferably a C₁₋₄ alkylene group, and more preferably a C₁₋₃ alkylene group.

In one embodiment, the number of carbon atoms of the alkylene group in X^{A} is each greater than the number of Si atoms in R^{Si}. Causing the number of carbon atoms of the alkylene group in X^{A} or X^{B} to be greater than the number of Si atoms in R^{Si} enables the friction durability of the resulting surface-treating layer to be increased.

In a preferable embodiment, the number of carbon atoms of the alkylene group in X^{A} may be not less than 2.5 times, preferably not less than 3.0 times, and even more preferably not less than 3.5 times the number of Si atoms in R^{Si}. The number of carbon atoms of the alkylene group in X^{A} is preferably not more than 50 times, and may be, for example, not more than 30 times, not more than 20 times, or not more than 10 times the number of Si atoms in R^{Si}.

In one embodiment, the number of carbon atoms of the alkylene group in X^{A} is greater than the number of atoms of the main chain in R^{Si}. Causing the number of carbon atoms of the alkylene group in X^{A} to be greater than the number of atoms of the main chain in R^{Si} enables the friction durability of the resulting surface-treating layer to be increased.

In a preferable embodiment, the number of carbon atoms of the alkylene group in X^{A} may be each not less than 2.0 times, preferably not less than 2.5 times, more preferably not less than 3.0 times, and even more preferably not less than 4.0 times the number of atoms of the main chain in R^{Si}. The number of carbon atoms of the alkylene group in X^{A} is preferably not more than 30 times, and may be, for example, not more than 20 times, not more than 10 times, or not more than 6.0 times the number of atoms of the main chain in R^{Si}.

Here, the main chain in R^{Si} means an atomic chain having the largest number of atoms (excluding hydrogen atoms) from the Si atom in R^{Si} bonded to X^{A}. For example, the number of atoms of the main chain in R^{Si} is 4 in the case of Si(CH₃)₃OSi(CH₃)₂-, and the number of atoms of the main chain in R^{Si} is 6 in the case of Si(CH₃)₃OSi(CH₃)₃OSi(CH₃)₂-, and 3 in the case of Si(Si(CH₃)₃)₃-.

R^{Si} is a monovalent group comprising a Si atom to which a hydroxyl group or a hydrolyzable group is bonded.

R^{Si} is preferably a group represented by the following formula (S1), (S2), (S3), (S4), or (S5):

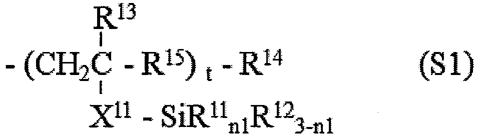

- SiR¹¹ₙ₁R¹²₃₋ₙ₁ (S2)

- SiR^{a1}ₖ₁R^{b1}ₗ₁R^{c1}ₘ₁ (S3)

- CR^{d1}ₖ₂R^{e1}ₗ₂R^{f1}ₘ₂ (S4)

- NR^{g1}R^{h1} (S5)

wherein
R¹¹ is each independently a hydroxyl group or a hydrolyzable group,
R¹² is each independently a monovalent organic group,
n1 is each independently an integer of 0 to 3 for each (SiR¹¹ₙ₁R¹²₃₋ₙ₁) unit,
X¹¹ is each independently a single bond or a divalent organic group,
R¹³ is each independently a hydrogen atom or a monovalent organic group,
t is each independently an integer of 2 or more,
R¹⁴ is each independently a hydrogen atom, a halogen atom, or -X¹¹-SiR¹¹ₙ₁R¹²₃₋ₙ₁,
R¹⁵ is each independently a single bond, an oxygen atom, an alkylene group having 1 to 6 carbon atoms, or an alkyleneoxy group having 1 to 6 carbon atoms,
R^{a1} is each independently -Z¹-SiR²¹ₚ₁R²²_{q1}R²³ᵣ₁,
Z¹ is each independently a divalent organic group,
R²¹ is each independently -Z^{1'}-SiR^{21'}_{p1'}R^{22'}_{q1'}R^{23'}_{r1'},
R²² is each independently a hydroxyl group or a hydrolyzable group,
R²³ is each independently a monovalent organic group,
p1 is each independently an integer of 0 to 3,
q1 is each independently an integer of 0 to 3,
r1 is each independently an integer of 0 to 3,
Z^{1'} is each independently a divalent organic group,
R^{21'} is each independently -Z^{1"}-SiR^{22"}_{q1"}R^{23"}_{r1"},
R^{22'} is each independently a hydroxyl group or a hydrolyzable group,
R^{23'} is each independently a monovalent organic group,
p1' is each independently an integer of 0 to 3,
q1' is each independently an integer of 0 to 3,
r1' is each independently an integer of 0 to 3,
Z^{1"} is each independently a divalent organic group,
R^{22"} is each independently a hydroxyl group or a hydrolyzable group,
R^{23"} is each independently a monovalent organic group,
q1" is each independently an integer of 0 to 3,
r1" is each independently an integer of 0 to 3,
R^{b1} is each independently a hydroxyl group or a hydrolyzable group,
R^{c1} is each independently a monovalent organic group,
k1 is each independently an integer of 0 to 3,
l1 is each independently an integer of 0 to 3,
m1 is each independently an integer of 0 to 3,
provided that, in the formula (S3), at least two Si atoms to which a hydroxyl group or a hydrolyzable group is bonded are present,
R^{d1} is each independently -Z²-CR³¹ₚ₂R³²_{q2}R³³ᵣ₂,
Z² is each independently a single bond, an oxygen atom, or a divalent organic group,
R³¹ is each independently -Z^{2'}-CR^{32'}_{q2'}R^{33'}_{r2'},
R³² is each independently -Z³-SiR³⁴ₙ₂R³⁵₃₋ₙ₂,
R³³ is each independently a hydrogen atom, a hydroxyl group, or a monovalent organic group,
p2 is each independently an integer of 0 to 3,
q2 is each independently an integer of 0 to 3,
r2 is each independently an integer of 0 to 3,
Z^{2'} is each independently a single bond, an oxygen atom, or a divalent organic group,
R^{32'} is each independently -Z³-SiR³⁴ₙ₂R³⁵₃₋ₙ₂,
R^{33'} is each independently a hydrogen atom, a hydroxyl group, or a monovalent organic group,
q2' is each independently an integer of 0 to 3,
r2' is each independently an integer of 0 to 3,
Z³ is each independently a single bond, an oxygen atom, or a divalent organic group,
R³⁴ is each independently a hydroxyl group or a hydrolyzable group,
R³⁵ is each independently a monovalent organic group,
n2 is each independently an integer of 0 to 3,
R^{e1} is each independently -Z³-SiR³⁴ₙ₂R³⁵₃₋ₙ₂,
R^{f1} is each independently a hydrogen atom, a hydroxyl group, or a monovalent organic group,
k2 is each independently an integer of 0 to 3,
l2 is each independently an integer of 0 to 3,
m2 is each independently an integer of 0 to 3,
provided that, in the formula (S4), at least two Si atoms to which a hydroxyl group or a hydrolyzable group is bonded are present,
R^{g1} and R^{h1} are each independently -Z⁴-SiR¹¹ₙ₁R¹¹₃₋ₙ₁, -Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂, and
Z⁴ is each independently a single bond, an oxygen atom, or a divalent organic group,
provided that, in the formula (S5), at least two Si atoms to which a hydroxyl group or a hydrolyzable group is bonded are present.

In the formulae, R¹¹ is each independently a hydroxyl group or a hydrolyzable group.

R¹¹ is preferably, each independently, a hydrolyzable group.

R¹¹ is preferably, each independently, -OR^{h}, -OCOR^{h}, -O-N=CR^{h}₂, -NR^{h}₂, - NHR^{h}, -NCO, or a halogen (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formulae, R¹² is each independently a monovalent organic group. Such a monovalent organic group is a monovalent organic group excluding the above hydrolyzable group.

In R¹², the monovalent organic group is preferably a C₁₋₂₀ alkyl group, more preferably a C₁₋₆ alkyl group, and even more preferably a methyl group.

In the formulae, n1 is each independently an integer of 0 to 3 for each (SiR¹¹ₙ₁R¹²₃₋ₙ₁) unit, provided that, in the formula (S1), at least two (SiR¹¹ₙ₁R¹²₃₋ₙ₁) units wherein n1 is 1 to 3 are present. In other words, in the formula (S1), at least two Si atoms to which a hydroxyl group or a hydrolyzable group is bonded are present.

n1 is each independently an integer of preferably 1 to 3, more preferably 2 to 3, and even more preferably 3 for each (SiR¹¹ₙ₁R¹²₃₋ₙ₁) unit.

In the formula, X¹¹ is each independently a single bond or a divalent organic group. Such a divalent organic group is preferably -R²⁸-Oₓ-R²⁹-, wherein R²⁸ and R²⁹ are each independently a single bond or a C₁₋₂₀ alkylene group, and x is 0 or 1. Such a C₁₋₂₀ alkylene group may be linear or may be branched, and is preferably linear. Such a C₁₋₂₀ alkylene group is preferably a C₁₋₁₀ alkylene group, more preferably a C₁₋₆ alkylene group, and even more preferably a C₁₋₃ alkylene group.

In one embodiment, X¹¹ is each independently a -C₁₋₆ alkylene-O-C₁₋₆ alkylene- or a -O-C₁₋₆ alkylene-.

In a preferable embodiment, X¹¹ is each independently a single bond or a linear C₁₋₆ alkylene group, preferably a single bond or a linear C₁₋₃ alkylene group, more preferably a single bond or a linear C₁₋₂ alkylene group, and even more preferably a linear C₁₋₂ alkylene group.

In the formula, R¹³ is each independently a hydrogen atom or a monovalent organic group. Such a monovalent organic group is preferably a C₁₋₂₀ alkyl group.

In a preferable embodiment, R¹³ is each independently a hydrogen atom or a linear C₁₋₆ alkyl group, preferably a hydrogen atom or a linear C₁₋₃ alkyl group, and preferably a hydrogen atom or a methyl group.

In the formula, R¹⁵ is each independently a single bond, an oxygen atom, an alkylene group having 1 to 6 carbon atoms, or an alkyleneoxy group having 1 to 6 carbon atoms.

In one embodiment, R¹⁵ is each independently an oxygen atom, an alkylene group having 1 to 6 carbon atoms, or an alkyleneoxy group having 1 to 6 carbon atoms.

In a preferable embodiment, R¹⁵ is a single bond.

In the formula, t is each independently an integer of 2 or more.

In a preferable embodiment, t is each independently an integer of 2 to 10, and preferably an integer of 2 to 6.

In the formula, R¹⁴ is each independently a hydrogen atom, a halogen atom, or -X¹¹-SiR¹¹ₙ₁R¹²₃₋ₙ₁. Such a halogen atom is preferably an iodine atom or a chlorine atom. In a preferable embodiment, R¹⁴ is a hydrogen atom.

In one embodiment, the formula (S1) is the following formula (S1-a): 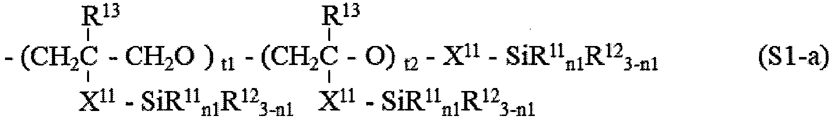 wherein
R¹¹, R¹², R¹³, X¹¹, and n1 have the same meanings as those described for the formula (S1),
t1 and t2 are each independently an integer of 1 or more, preferably an integer of 1 to 10, and more preferably an integer of 2 to 10, such as an integer of 1 to 5 or an integer of 2 to 5, and
the occurrence order of the respective repeating units enclosed in parentheses provided with t1 and t2 is not limited in the formula.

In a preferable embodiment, the formula (S1) is the following formula (S1-b): 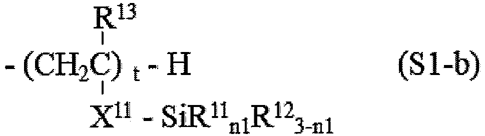 R¹¹, R¹², R¹³, X¹¹, n1, and t have the same meanings as those described for the formula (S1).

R^{a1} is each independently -Z¹-SiR²¹ₚ₁R²²_{q1}R²³ᵣ₁.

Z¹ is each independently an oxygen atom or a divalent organic group. Below, the right side of the structure denoted as Z¹ binds to (SiR²¹ₚ₁R²²_{q1}R²³ᵣ₁).

In a preferable embodiment, Z¹ is a divalent organic group.

In a preferable embodiment, Z¹ does not comprise a group that forms a siloxane bond with the Si atom to which Z¹ is bonded. Preferably, in the formula (S2), (Si-Z¹-Si) does not comprise a siloxane bond.

Z¹ is preferably a C₁₋₃₀ alkylene group, -(CH₂)_{z1}-O-(CH₂)_{z2}- (wherein z1 is an integer of 0 to 6 such as an integer of 1 to 6, and z2 is an integer of 0 to 6 such as an integer of 1 to 6), or -(CH₂)_{z3}-phenylene-(CH₂)_{z4}- (wherein z3 is an integer of 0 to 6 such as an integer of 1 to 6, and z4 is an integer of 0 to 6 such as an integer of 1 to 6). Such a C₁₋₃₀ alkylene group is more preferably a C₁₋₂₀ alkylene group, and even more preferably a C₁₋₁₅ alkylene group, may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z¹ is a C₁₋₂₀ alkylene group or -(CH₂)_{z3}-phenylene-(CH₂)_{z4}-, and preferably -phenylene-(CH₂)_{z4}-.

In another preferable embodiment, Z¹ is a C₁₋₂₀ alkylene group. In one embodiment, Z¹ may be -CH₂CH₂CH₂-. In another embodiment, Z¹ may be - CH₂CH₂-. In another embodiment, Z¹ may be - CH₂CH₂CH₂CH₂CH₂CH₂CH₂CH₂CH₂CH₂CH₂-.

R²¹ is each independently -Z^{1'}-SiR^{21'}_{p1'}R^{22'}_{q1'}R^{23'}_{r1'}.

Z^{1'} is each independently an oxygen atom or a divalent organic group. Below, the right side of the structure denoted as Z^{1'} binds to (SiR^{21'}ₚ₁'R^{22'}_{q1'}R^{23'}_{r1'}).

In a preferable embodiment, Z^{1'} is a divalent organic group.

In a preferable embodiment, Z^{1'} does not comprise a group that forms a siloxane bond with the Si atom to which Z^{1'} is bonded. Preferably, in the formula (S2), (Si-Z^{1'}-Si) does not comprise a siloxane bond.

Z^{1'} is preferably a C₁₋₁₅ alkylene group, -(CH₂)_{z1'}-O-(CH₂)_{z2'}- (wherein z1' is an integer of 0 to 6 such as an integer of 1 to 6, and z2' is an integer of 0 to 6 such as an integer of 1 to 6), or -(CH₂)_{z3'}-phenylene-(CH₂)_{z4'}- (wherein z3' is an integer of 0 to 6 such as an integer of 1 to 6, and z4' is an integer of 0 to 6 such as an integer of 1 to 6). Such a C₁₋₃₀ alkylene group is more preferably a C₁₋₂₀ alkylene group, and even more preferably a C₁₋₁₅ alkylene group, may be linear or may be branched, and is preferably linear. These groups may be substituted with, for example, one or more substituents selected from, a C₁₋₆ alkyl group, a C₂₋₆ alkenyl group, and a C₂₋₆ alkynyl group, and are preferably unsubstituted.

In a preferable embodiment, Z^{1'} is a C₁₋₂₀ alkylene group or -(CH₂)_{z3'}-phenylene-(CH₂)_{z4'}-, and preferably -phenylene-(CH₂)_{z4'}-.

In another preferable embodiment, Z^{1'} is a C₁₋₂₀ alkylene group. In one embodiment, Z^{1'} may be -CH₂CH₂CH₂-. In another embodiment, Z^{1'} may be - CH₂CH₂-. In another embodiment, Z^{1'} may be - CH₂CH₂CH₂CH₂CH₂CH₂CH₂CH₂CH₂CH₂CH₂-.

R^{21'} is each independently -Z^{1"}-SiR^{22"}_{q1"}R^{23"}_{r1"}.

Z^{1"} is each independently an oxygen atom or a divalent organic group. Below, the right side of the structure denoted as Z^{1"} binds to (SiR^{22"}_{q1"}R^{23"}_{r1"}).

In a preferable embodiment, Z^{1"} is a divalent organic group.

In a preferable embodiment, Z^{1"} does not comprise a group that forms a siloxane bond with the Si atom to which Z^{1"} is bonded. Preferably, in the formula (S2), (Si-Z^{1"}-Si) does not comprise a siloxane bond.

Z^{1"} is preferably a C₁₋₁₅ alkylene group, -(CH₂)_{z1"}-O-(CH₂)_{z2"}- (wherein z1" is an integer of 0 to 6 such as an integer of 1 to 6, and z2" is an integer of 0 to 6 such as an integer of 1 to 6), or -(CH₂)_{z3"}-phenylene-(CH₂)_{z4"}- (wherein z3" is an integer of 0 to 6 such as an integer of 1 to 6, and z4" is an integer of 0 to 6 such as an integer of 1 to 6). Such a C₁₋₆ alkylene group may be linear or may be branched, and is preferably linear. These groups may be substituted with, for example, one or more substituents selected from, a C₁₋₆ alkyl group, a C₂₋₆ alkenyl group, and a C₂₋₆ alkynyl group, and are preferably unsubstituted.

In a preferable embodiment, Z^{1"} is a C₁₋₂₀ alkylene group or -(CH₂)_{z3"}-phenylene-(CH₂)_{z4"}-, and preferably -phenylene-(CH₂)_{z4"}-. When Z^{1"} is such a group, light resistance, in particular ultraviolet resistance, can be more increased.

In another preferable embodiment, Z^{1"} is a C₁₋₂₀ alkylene group. In one embodiment, Z^{1"} may be -CH₂CH₂CH₂-. In another embodiment, Z^{1"} may be - CH₂CH₂-. In another embodiment, Z^{1"} may be - CH₂CH₂CH₂CH₂CH₂CH₂CH₂CH₂CH₂CH₂CH₂-.

R^{22"} is each independently a hydroxyl group or a hydrolyzable group.

R^{22"} is preferably, each independently, a hydrolyzable group.

R^{22"} is preferably, each independently, -OR^{h}, -OCOR^{h}, -O-N=CR^{h}₂, -NR^{h}₂, - NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23"} is each independently a monovalent organic group. Such a monovalent organic group is a monovalent organic group excluding the above hydrolyzable group.

In R^{23"}, the monovalent organic group is preferably a C₁₋₂₀ alkyl group, more preferably a C₁₋₆ alkyl group, and even more preferably a methyl group.

q1" is each independently an integer of 0 to 3, and r1" is each independently an integer of 0 to 3. The sum of q1" and r1" is 3 in the (SiR^{22"}_{q1"}R^{23"}_{r1"}) unit.

q1" is preferably, each independently, an integer of 1 to 3, more preferably 2 to 3, and even more preferably 3 for each (SiR^{22"}_{q1"}R^{23"}_{r1"}) unit.

R^{22'} is each independently a hydroxyl group or a hydrolyzable group.

R^{22'} is preferably, each independently, a hydrolyzable group.

R^{22'} is preferably, each independently, -OR^{h}, -OCOR^{h}, -O-N=CR^{h}₂, -NR^{h}₂, - NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23'} is each independently a monovalent organic group. Such a monovalent organic group is a monovalent organic group excluding the above hydrolyzable group.

In R^{23'}, the monovalent organic group is preferably a C₁₋₂₀ alkyl group, more preferably a C₁₋₆ alkyl group, and even more preferably a methyl group.

p1' is each independently an integer of 0 to 3, q1' is each independently an integer of 0 to 3, and r1' is each independently an integer of 0 to 3. The sum of p', q1', and r1' is 3 in the (SiR^{21'}_{p1'}R²²_{q1'}R^{23'}_{r1'}) unit.

In one embodiment, p1' is 0.

In one embodiment, p1' may be each independently an integer of 1 to 3, an integer of 2 to 3, or 3 for each (SiR^{21'}_{p1'}R^{22'}_{q1'}R^{23'}_{r1'}) unit. In a preferable embodiment, p1' is 3.

In one embodiment, q1' is each independently an integer of 1 to 3, preferably an integer of 2 to 3, and more preferably 3 for each (SiR^{21'}_{p1'}R^{22'}_{q1'}R^{23'}_{r1'}) unit.

In one embodiment, p1' is 0, and q1' is each independently an integer of 1 to 3, preferably an integer of 2 to 3, and even more preferably 3 for each (SiR^{21'}_{p1'}R^{22'}_{q1'}R^{23'}_{r1'}) unit.

R²² is each independently a hydroxyl group or a hydrolyzable group.

R²² is preferably, each independently, a hydrolyzable group.

R²² is preferably, each independently, -OR^{h}, -OCOR^{h}, -O-N=CR^{h}₂, -NR^{h}₂, - NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R²³ is each independently a monovalent organic group. Such a monovalent organic group is a monovalent organic group excluding the above hydrolyzable group.

In R²³, the monovalent organic group is preferably a C₁₋₂₀ alkyl group, more preferably a C₁₋₆ alkyl group, and even more preferably a methyl group.

p1 is each independently an integer of 0 to 3, q1 is each independently an integer of 0 to 3, and r1 is each independently an integer of 0 to 3. The sum of p1, q1, and r1 is 3 in the (SiR²¹ₚ₁R²²_{q1}R²³ᵣ₁) unit.

In one embodiment, p1 is 0.

In one embodiment, p1 may be each independently an integer of 1 to 3, an integer of 2 to 3, or 3 for each (SiR²¹ₚ₁R²²_{q1}R²³ᵣ₁) unit. In a preferable embodiment, p1 is 3.

In one embodiment, q1 is each independently an integer of 1 to 3, preferably an integer of 2 to 3, and more preferably 3 for each (SiR²¹ₚ₁R²²_{q1}R²³ᵣ₁) unit.

In one embodiment, p1 is 0, and q1 is each independently an integer of 1 to 3, preferably an integer of 2 to 3, and even more preferably 3 for each (SiR²¹ₚ₁R²²_{q1}R²³ᵣ₁) unit.

In the formula, R^{b1} is each independently a hydroxyl group or a hydrolyzable group.

R^{b1} is preferably, each independently, a hydrolyzable group.

R^{b1} is preferably, each independently, -OR^{h}, -OCOR^{h}, -O-N=CR^{h}₂, -NR^{h}₂, - NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formula, R^{c1} is each independently a monovalent organic group. Such a monovalent organic group is a monovalent organic group excluding the above hydrolyzable group.

In R^{c1}, the monovalent organic group is preferably a C₁₋₂₀ alkyl group, more preferably a C₁₋₆ alkyl group, and even more preferably a methyl group.

k1 is each independently an integer of 0 to 3, 11 is each independently an integer of 0 to 3, and m1 is each independently an integer of 0 to 3. The sum of k1, 11, and m1 is 3 in the (SiR^{a1}ₖ₁R^{b1}ₗ₁R^{c1}ₘ₁) unit.

In one embodiment, k1 is each independently an integer of 1 to 3, preferably 2 or 3, and more preferably 3 for each (SiR^{a1}ₖ₁R^{b1}ₗ₁R^{c1}ₘ₁) unit. In a preferable embodiment, k1 is 3.

In the formula (S3), at least two Si atoms to which a hydroxyl group or a hydrolyzable group is bonded are present.

In a preferable embodiment, in the terminal moiety of the formula (S3), at least two Si atoms to which a hydroxyl group or a hydrolyzable group is bonded are present.

In a preferable embodiment, the group represented by the formula (S3) has any one of -Z¹-SiR²²_{q1}R²³ᵣ₁ (wherein q1 is an integer of 1 to 3, preferably 2 or 3, and more preferably 3, and r1 is an integer of 0 to 2), -Z^{1'}-SiR^{22'}_{q1'}R^{23'}_{r1'} (wherein q1' is an integer of 1 to 3, preferably 2 or 3, and more preferably 3, and r1' is an integer of 0 to 2), and -Z^{1"}-SiR^{22"}_{q1"}R^{23"}_{r1"} (wherein q1" is an integer of 1 to 3, preferably 2 or 3, and more preferably 3, and r1" is an integer of 0 to 2). Z¹, Z^{1'}, Z^{1"}, R²², R²³, R^{22'}, R^{23'}, R^{22"}, and R^{23"} have the same meanings as those described above.

In a preferable embodiment, when R^{21'} is present in the formula (S3), q1" is an integer of 1 to 3, preferably 2 or 3, and more preferably 3 in at least one and preferably all R^{21'} groups.

In a preferable embodiment, when R²¹ is present in the formula (S3), p1' is 0, and q1' is an integer of 1 to 3, preferably 2 or 3, and more preferably 3 in at least one and preferably all R²¹ groups.

In a preferable embodiment, when R^{a1} is present in the formula (S3), p1 is 0, and q1 is an integer of 1 to 3, preferably 2 or 3, and more preferably 3 in at least one and preferably all R^{a1} groups.

In a preferable embodiment, in the formula (S3), k1 is 2 or 3 and is preferably 3, p1 is 0, q1 is 2 or 3 and is preferably 3.

R^{d1} is each independently -Z²-CR³¹ₚ₂R³²_{q2}R³³ᵣ₂.

Z² is each independently a single bond, an oxygen atom, or a divalent organic group. Below, the right side of the structure denoted as Z² binds to (CR³¹ₚ₂R³²_{q2}R³³ᵣ₂).

In a preferable embodiment, Z² is a divalent organic group.

In a preferable embodiment, Z² does not comprise a siloxane bond.

Z² is preferably a C₁₋₃₀ alkylene group, -(CH₂)_{z5}-O-(CH₂)_{z6}- (wherein z5 is an integer of 0 to 6 such as an integer of 1 to 6, and z6 is an integer of 0 to 6 such as an integer of 1 to 6), or -(CH₂)_{z7}-phenylene-(CH₂)_{z8}- (wherein z7 is an integer of 0 to 6 such as an integer of 1 to 6, and z8 is an integer of 0 to 6 such as an integer of 1 to 6). Such a C₁₋₃₀ alkylene group is more preferably a C₁₋₂₀ alkylene group, and even more preferably a C₁₋₁₅ alkylene group, may be linear or may be branched, and is preferably linear. These groups may be substituted with, for example, one or more substituents selected from, a C₁₋₆ alkyl group, a C₂₋₆ alkenyl group, and a C₂₋₆ alkynyl group, and are preferably unsubstituted.

In a preferable embodiment, Z² is a C₁₋₂₀ alkylene group or -(CH₂)_{z7}-phenylene-(CH₂)_{z8}-, and preferably -phenylene-(CH₂)_{z8}-. When Z² is such a group, light resistance, in particular ultraviolet resistance, can be more increased.

In another preferable embodiment, Z² is a C₁₋₂₀ alkylene group. In one embodiment, Z² may be -CH₂CH₂CH₂-. In another embodiment, Z² may be - CH₂CH₂-. In another embodiment, Z² may be - CH₂CH₂CH₂CH₂CH₂CH₂CH₂CH₂CH₂CH₂CH₂-.

R³¹ is each independently -Z^{2'}-CR^{32'}_{q2'}R^{33'}_{r2'}.

Z^{2'} is each independently a single bond, an oxygen atom, or a divalent organic group. Below, the right side of the structure denoted as Z^{2'} binds to (CR^{32'}_{q2'}R^{33'}_{r2'}).

In a preferable embodiment, Z^{2'} does not comprise a siloxane bond.

Z^{2'} is preferably a C₁₋₃₀ alkylene group, -(CH₂)_{z5'}-O-(CH₂)_{z6'}- (wherein z5' is an integer of 0 to 6 such as an integer of 1 to 6, and z6' is an integer of 0 to 6 such as an integer of 1 to 6), or -(CH₂)_{z7'}-phenylene-(CH₂)_{z8'}- (wherein z7' is an integer of 0 to 6 such as an integer of 1 to 6, and z8' is an integer of 0 to 6 such as an integer of 1 to 6). Such a C₁₋₃₀ alkylene group is more preferably a C₁₋₂₀ alkylene group, and even more preferably a C₁₋₁₅ alkylene group, may be linear or may be branched, and is preferably linear. These groups may be substituted with one or more substituents selected from, for example, a C₁₋₆ alkyl group, a C₂₋₆ alkenyl group, and a C₂₋₆ alkynyl group, and are preferably unsubstituted.

In a preferable embodiment, Z^{2'} is a C₁₋₂₀ alkylene group or -(CH₂)_{z7'}-phenylene-(CH₂)_{z8'}-, and preferably -phenylene-(CH₂)_{z8'}-. When Z^{2'} is such a group, light resistance, in particular ultraviolet resistance, can be more increased.

In another preferable embodiment, Z^{2'} is a C₁₋₂₀ alkylene group. In one embodiment, Z² may be -CH₂CH₂CH₂-. In another embodiment, Z² may be - CH₂CH₂-. In another embodiment, Z² may be - CH₂CH₂CH₂CH₂CH₂CH₂CH₂CH₂CH₂CH₂CH₂-.

R^{32'} is each independently -Z³-SiR³⁴ₙ₂R³⁵₃₋ₙ₂.

Z³ is each independently a single bond, an oxygen atom, or a divalent organic group. Below, the right side of the structure denoted as Z³ binds to (SiR³⁴ₙ₂R³⁵₃₋ₙ₂).

In one embodiment, Z³ is an oxygen atom.

In one embodiment, Z³ is a divalent organic group.

In a preferable embodiment, Z³ does not comprise a siloxane bond.

Z³ is preferably a C₁₋₃₀ alkylene group, -(CH₂)_{z5"}-O-(CH₂)_{z6"}- (wherein z5" is an integer of 0 to 6, for example, an integer of 1 to 6, and z6" is an integer of 0 to 6, for example, an integer of 1 to 6), -(CH₂)_{z7"}-phenylene-(CH₂)_{z8"}- (wherein z7" is an integer of 0 to 6, for example, an integer of 1 to 6, and z8" is an integer of 0 to 6, for example, an integer of 1 to 6) or -(CH₂)_{z9"}-OCONR^{z1}-(CH₂)_{z10"}- (wherein R^{z1} is a hydrogen atom or a C₁₋₆ alkyl group, in particular, a hydrogen atom, z9" is an integer of 0 to 6, for example, an integer of 1 to 6, and z10" is an integer of 0 to 6, for example, an integer of 1 to 6). Such a C₁₋₃₀ alkylene group is more preferably a C₁₋₂₀ alkylene group, and even more preferably a C₁₋₁₅ alkylene group, may be linear or may be branched, and is preferably linear. These groups may be substituted with, for example, a fluorine atom, one or more substituents selected from a C₁₋₆ alkyl group, a C₂₋₆ alkenyl group, and a C₂₋₆ alkynyl group, and are preferably unsubstituted.

In a preferable embodiment, Z³ is a C₁₋₁₅ alkylene group, -(CH₂)_{z7"}-phenylene-(CH₂)_{z8"}- or -(CH₂)_{z9"}-OCONR^{z1}-(CH₂)_{z10"}-, and preferably -phenylene-(CH₂)_{z8"}- or - (CH₂)_{z9"}-OCONR^{z1}-(CH₂)_{z10"}-. When Z³ is such a group, light resistance, in particular ultraviolet resistance, can be more increased.

In another preferable embodiment, Z³ is a C₁₋₂₀ alkylene group. In one embodiment, Z³ may be -CH₂CH₂CH₂-. In another embodiment, Z³ may be - CH₂CH₂-. In another embodiment, Z³ may be - CH₂CH₂CH₂CH₂CH₂CH₂CH₂CH₂CH₂CH₂CH₂-.

R³⁴ is each independently a hydroxyl group or a hydrolyzable group.

R³⁴ is preferably, each independently, a hydrolyzable group.

R³⁴ is preferably, each independently, -OR^{h}, -OCOR^{h}, -O-N=CR^{h}₂, -NR^{h}₂, - NHR^{h}, -NCO, or a halogen (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R³⁵ is each independently a monovalent organic group. Such a monovalent organic group is a monovalent organic group excluding the above hydrolyzable group.

In R³⁵, the monovalent organic group is preferably a C₁₋₂₀ alkyl group, more preferably a C₁₋₆ alkyl group, and even more preferably a methyl group.

n2 is each independently an integer of 0 to 3 for each (SiR³⁴ₙ₂R³⁵₃₋ₙ₂) unit, provided that, in the terminal moiety of the formula (S3), at least two (SiR³⁴ₙ₂R³⁵₃₋ₙ₂) units wherein n2 is 1 to 3 are present. In other words, in the terminal moiety of the formula (S3), at least two Si atoms to which a hydroxyl group or a hydrolyzable group is bonded are present.

n2 is each independently an integer of preferably 1 to 3, more preferably 2 to 3, and even more preferably 3 for each (SiR³⁴ₙ₂R³⁵₃₋ₙ₂) unit.

R^{33'} is each independently a hydrogen atom, a hydroxyl group, or a monovalent organic group. Such a monovalent organic group is a monovalent organic group excluding the hydrolyzable group.

In R^{33'}, the monovalent organic group is preferably a C₁₋₂₀ alkyl group or - (CₛH₂ₛ)ₜ₁-(O-CₛH₂ₛ)ₜ₂H (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R^{33'} is a hydroxyl group.

In another embodiment, R^{33'} is a monovalent organic group, preferably a C₁₋₂₀ alkyl group, and more preferably a C₁₋₆ alkyl group.

q2' is each independently an integer of 0 to 3, and r2' is each independently an integer of 0 to 3. The sum of q2' and r2' is 3 in the (CR^{32'}_{q2'}R^{33'}_{r2'}) unit.

q2' is each independently an integer of preferably 1 to 3, more preferably 2 to 3, and even more preferably 3 for each (CR^{32'}_{q2'}R^{33'}_{r2'}) unit.

R³² is each independently -Z³-SiR³⁴ₙ₂R³⁵₃₋ₙ₂. Such -Z³-SiR³⁴ₙ₂R³⁵₃₋ₙ₂ has the same meanings as those described for R^{32'}.

R³³ is each independently a hydrogen atom, a hydroxyl group, or a monovalent organic group. Such a monovalent organic group is a monovalent organic group excluding the above hydrolyzable group.

In R³³, the monovalent organic group is preferably a C₁₋₂₀ alkyl group or - (CₛH₂ₛ)ₜ₁-(O-CₛH₂ₛ)ₜ₂H (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R³³ is a hydroxyl group.

In another embodiment, R³³ is a monovalent organic group, preferably a C₁₋₂₀ alkyl group, and more preferably a C₁₋₆ alkyl group.

p2 is each independently an integer of 0 to 3, q2 is each independently an integer of 0 to 3, and r2 is each independently an integer of 0 to 3. The sum of p2, q2, and r2 is 3 in the (CR³¹ₚ₂R³²_{q2}R³³ᵣ₂) unit.

In one embodiment, p2 is 0.

In one embodiment, p2 may be each independently an integer of 1 to 3, an integer of 2 to 3, or 3 for each (CR³¹ₚ₂R³²_{q2}R³³ᵣ₂) unit. In a preferable embodiment, p2 is 3.

In one embodiment, q2 is each independently an integer of 1 to 3, preferably an integer of 2 to 3, and more preferably 3 for each (CR³¹ₚ₂R³²_{q2}R³³ᵣ₂) unit.

In one embodiment, p2 is 0, and q2 is each independently an integer of 1 to 3, preferably an integer of 2 to 3, and even more preferably 3 for each (CR³¹ₚ₂R³²_{q2}R³³ᵣ₂) unit.

R^{e1} is each independently -Z³-SiR³⁴ₙ₂R³⁵₃₋ₙ₂. Such -Z³-SiR³⁴ₙ₂R³⁵₃₋ₙ₂ has the same meanings as those described for R^{32'}.

R^{f1} is each independently a hydrogen atom, a hydroxyl group, or a monovalent organic group. Such a monovalent organic group is a monovalent organic group excluding the above hydrolyzable group.

In R^{f1}, the monovalent organic group is preferably a C₁₋₂₀ alkyl group, a C₂₋₂₀ alkenyl group or -(CₛH₂ₛ)ₜ₁-(O-CₛH₂ₛ)ₜ₂H (wherein s is an integer of 1 to 6, and preferably an integer of 2 to 4, t1 is 1 or 0, and preferably 0, and t2 is an integer of 1 to 20, preferably an integer of 2 to 10, and more preferably an integer of 2 to 6), more preferably a C₁₋₂₀ alkyl group or a C₂₋₂₀ alkenyl group, even more preferably a C₁₋₆ alkyl group or a C₂₋₆ alkenyl group, and particularly preferably a methyl group, an ethyl group, or a 2-propenyl group.

In one embodiment, R^{f1} is a hydrogen atom.

In one embodiment, R^{f1} is a hydroxyl group.

In another embodiment, R^{f1} is a monovalent organic group, preferably a C₁₋₂₀ alkyl group or a C₂₋₂₀ alkenyl group, and more preferably a C₁₋₆ alkyl group or a C₂₋₆ alkenyl group.

k2 is each independently an integer of 0 to 3, 12 is each independently an integer of 0 to 3, and m2 is each independently an integer of 0 to 3. The sum of k2, l2, and m2 is 3 in the (CR^{d1}ₖ₂R^{e1}ₗ₂R^{f1}ₘ₂) unit.

In one embodiment, two or more such as 2 to 27, preferably 2 to 9, more preferably 2 to 6, even more preferably 2 to 3, and particularly preferably 3 (SiR³⁴ₙ₂R³⁵₃₋ₙ₂) units in which n2 is 1 to 3, preferably 2 or 3, and more preferably 3 are present in each terminal moiety of the formula (S4).

In a preferable embodiment, when R^{32'} is present in the formula (S4), n2 is an integer of 1 to 3, preferably 2 or 3, and more preferably 3 in at least one and preferably all R^{32'} groups.

In a preferable embodiment, when R³² is present in the formula (S4), n2 is an integer of 1 to 3, preferably 2 or 3, and more preferably 3 in at least one and preferably all R³² groups.

In a preferable embodiment, when R^{e1} is present in the formula (S4), n2 is an integer of 1 to 3, preferably 2 or 3, and more preferably 3 in at least one and preferably all R^{a1} groups.

In a preferable embodiment, in the formula (S4), k2 is 0, 12 is 2 or 3 and is preferably 3, and n2 is 2 or 3 and is preferably 3.

R^{g1} and R^{h1} are each independently -Z⁴-SiR¹¹ₙ₁R¹²₃₋ₙ₁, -Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂. Here, R¹¹, R¹², R^{a1}, R^{b2}, R^{c1}, R^{d1}, R^{e1}, R^{f1}, n1, k1, l1, m1, k2, l2, and m2 have the same meanings as above.

In a preferable embodiment, R^{g1} and R^{h1} are each independently -Z⁴-SiR¹¹ₙ₁R¹²₃₋ₙ₁.

Z⁴ is each independently a single bond, an oxygen atom, or a divalent organic group. Below, the right side of the structure denoted as Z⁴ binds to (SiR¹¹ₙ₁R¹²₃₋ₙ₁).

In one embodiment, Z⁴ is an oxygen atom.

In one embodiment, Z⁴ is a divalent organic group.

In a preferable embodiment, Z⁴ does not comprise a siloxane bond.

Z⁴ is preferably a C₁₋₃₀ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}- (wherein z7" is an integer of 0 to 6 such as an integer of 1 to 6, and z8" is an integer of 0 to 6 such as an integer of 1 to 6). Such a C₁₋₃₀ alkylene group is more preferably a C₁₋₂₀ alkylene group, and even more preferably a C₁₋₁₅ alkylene group, may be linear or may be branched, and is preferably linear. These groups may be substituted with, for example, one or more substituents selected from a C₁₋₆ alkyl group, a C₂₋₆ alkenyl group, and a C₂₋₆ alkynyl group, and are preferably unsubstituted.

In a preferable embodiment, Z⁴ is a C₁-₂₀ alkylene group or -(CH₂)_{z7"}-phenylene-(CH₂)_{z8"}-, and preferably -phenylene-(CH₂)_{z8"}-. When Z³ is such a group, light resistance, in particular ultraviolet resistance, can be more increased.

In another preferable embodiment, Z⁴ is a C₁₋₂₀ alkylene group. In one embodiment, Z⁴ may be -CH₂CH₂CH₂-. In another embodiment, Z⁴ may be - CH₂CH₂-. In another embodiment, Z⁴ may be - CH₂CH₂CH₂CH₂CH₂CH₂CH₂CH₂CH₂CH₂CH₂-.

In one embodiment, none of the formulae (S1), (S2), (S3), and (S4) comprises a siloxane bond.

In one embodiment, R^{Si} is a group represented by the formula (S2), (S3), (S4), or (S5).

In one embodiment, R^{Si} is a group represented by the formula (S2), (S3), or (S4).

In one embodiment, R^{Si} is a group represented by the formula (S3), (S4), or (S5).

In one embodiment, R^{Si} is a group represented by the formula (S3) or (S4).

In one embodiment, R^{Si} is a group represented by the formula (S4) or (S5).

In one embodiment, R^{Si} is a group represented by the formula (S1). In a preferable embodiment, n1 is 1 to 3, preferably 2 to 3, and even more preferably 3.

In one embodiment, R^{Si} is a group represented by the formula (S2). In a preferable embodiment, the formula (S2) is the following formulae. In the following formulae, * represents the point of attachment to X^{A}.

*-Si(OCH₃)₃

*-Si(OCH₂CH₃)₃

In one embodiment, R^{Si} is a group represented by the formula (S3). In a preferable embodiment, the formula (S3) is -SiR^{a1}₂R^{c1} or -SiR^{a1}₃, R^{a1} is -Z¹-SiR²²_{q1}R²³ᵣ₁, Z¹ is a C₁₋₁₅ alkylene group, -(CH₂)_{z1}-O-(CH₂)_{z2}- (wherein z1 is an integer of 0 to 6 such as an integer of 1 to 6, and z2 is an integer of 0 to 6 such as an integer of 1 to 6), or -(CH₂)_{z3}-phenylene-(CH₂)_{z4}- (wherein z3 is an integer of 0 to 6 such as an integer of 1 to 6, and z4 is an integer of 0 to 6 such as an integer of 1 to 6), preferably a C₁₋₁₅ alkylene group, and q1 is 1 to 3, preferably 2 to 3, and even more preferably 3.

In a preferable embodiment, the formula (S3) is the following formulae. In the following formulae, * represents the point of attachment to X^{A}.

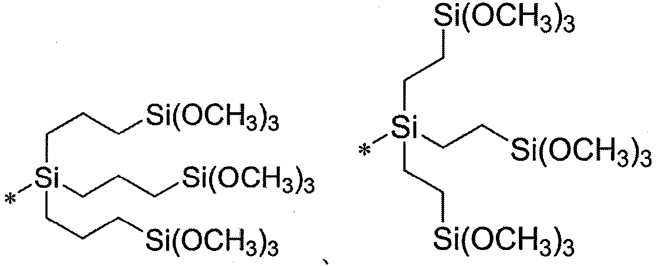

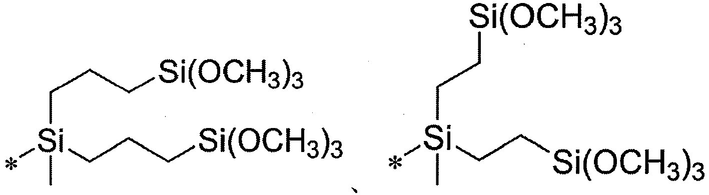

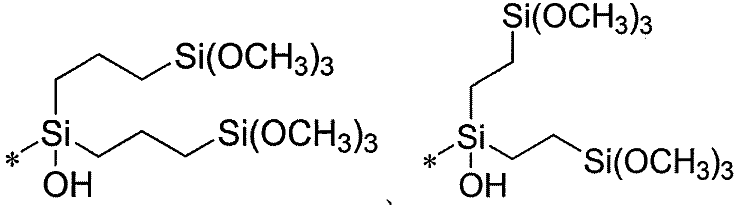

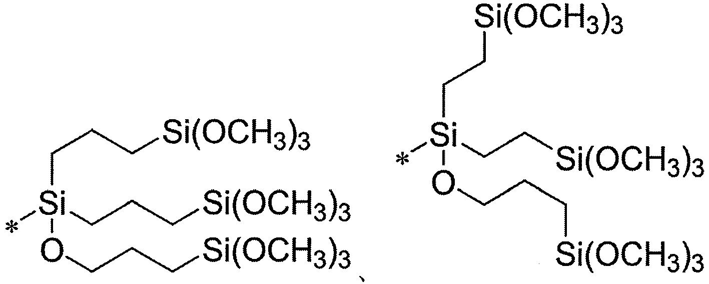

In one embodiment, R^{Si} is a group represented by the formula (S4). In a preferable embodiment, the formula (S4) is -CR^{e1}₂R^{f1} or -CR^{e1}₃, R^{e1} is -Z³-SiR³⁴ₙ₂R³⁵₃₋ₙ₂, Z³ is a C₁₋₁₅ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}- (wherein z7" is an integer of 0 to 6 such as an integer of 1 to 6, and z8" is an integer of 0 to 6 such as an integer of 1 to 6), preferably a C₁₋₁₅ alkylene group, and n2 is 1 to 3, preferably 2 to 3, and even more preferably 3.

In a preferable embodiment, the formula (S4) is the following formulae. In the following formulae, * represents the point of attachment to X^{A}.

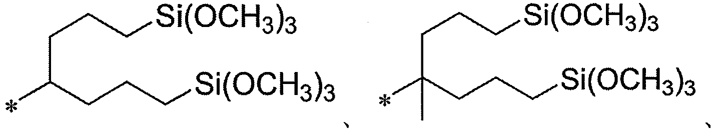

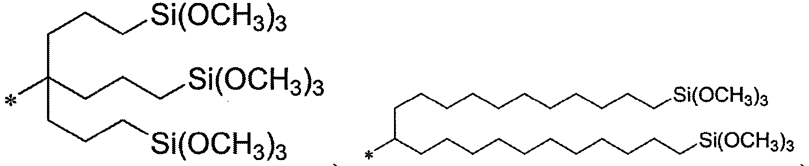

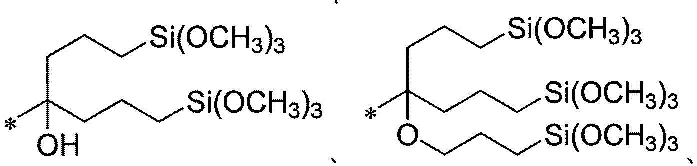

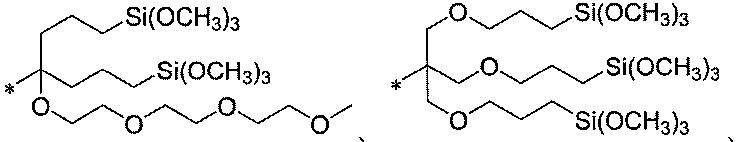

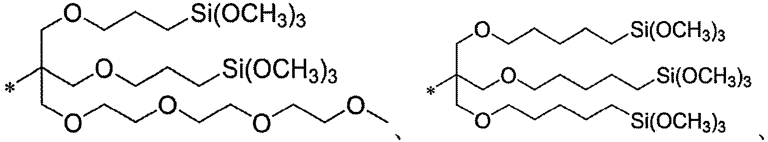

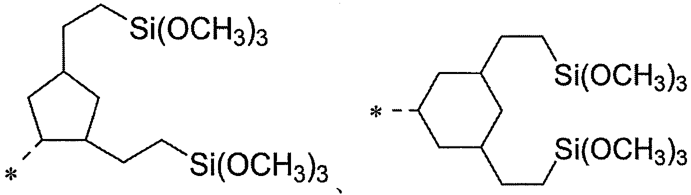

In one embodiment, R^{Si} is a group represented by the formula (S5). In a preferable embodiment, R^{g1} and R^{h1} are -Z⁴-SiR¹¹ₙ₁R¹²₃₋ₙ₁, Z⁴ is a C₁₋₁₅ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}- (wherein z7" is an integer of 0 to 6 such as an integer of 1 to 6, and z8" is an integer of 0 to 6 such as an integer of 1 to 6), preferably a C₁₋₁₅ alkylene group, and n1 is 1 to 3, preferably 2 to 3, and even more preferably 3.

In a preferable embodiment, formula (S5) is the following formulae. In the following formulae, * represents the point of attachment to X^{A}.

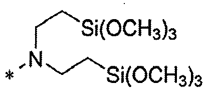

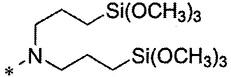

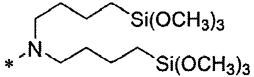

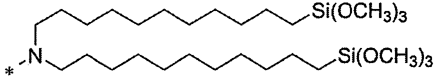

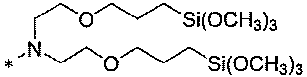

The silane compound preferably comprises a compound in which, in formula (1): R^{A1}_{α}-X^{A}-R^{Si}_{β},
α is 1, and β is 1,
R^{A1} is a group represented by formula (A1): in R^{1a}-R^{S}-SiR^{2a}₂-,
R^{1a} and R^{2a} are each a methyl group, and R^{S} is a group represented by the following formula: 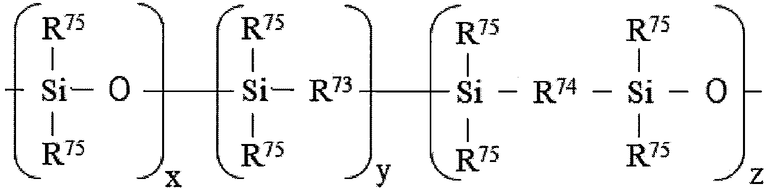
wherein R⁷⁵ is a methyl group, x is an integer of 10 to 300, and preferably an integer of 10 to 150, and y and z are each 0;
X^{A} is -(CH₂)ₚ-(X)ᵣ-R^{p}-: wherein p is an integer of 11 to 60, and preferably an integer of 11 to 30, r is 0 or 1, X is -C(=O)NR⁴¹-, -C(=O)- or -C(=O)O-, R⁴¹ is a hydrogen atom, an oxyalkylene-containing group, an alkyl group having 1 to 6 carbon atoms, or a phenyl group, and R^{p} is a single bond or an alkylene group having 1 to 30 carbon atoms; and
R^{Si} is -X^{b}R^{a1}ₖ₁R^{b1}ₗ₁R^{c1}ₘ₁
wherein X^{b} is a silicon atom, a carbon atom or a nitrogen atom, and R^{a1}, R^{b1}, R^{c1}, k1, 11 and m1 respectively have the same meanings as above.

The silane compound preferably comprises one or more compounds selected from the following group:

CH₃-[S(CH₃)₂O]ₙ₁Si(CH₃)₂-(CH₂)_{H1}-C(=O)NHCH₂CH₂CH₂Si(OCH₃)₃

CH₃CH₂CH₂CH₂-[Si(CH₃)₂O]ₙ₁Si(CH₃)₂-(CH₂)_{H1}-C(=O)NHCH₂CH₂CH₂Si(OCH₃)₃

[(CH₃)₃SiO)]₂(CH₃)Si-O-[Si(CH₃)₂O]ₙ₁Si(CH₃)₂-(CH₂)_{H1}- C(=O)NHCH₂CH₂CH₂Si(OCH₃)₃

[(CH₃)₃SiO)]₃Si-O-[Si(CH₃)₂O]ₙ₁Si(CH₃)₂-(CH₂)_{H1}- C(=O)NHCH₂CH₂CH₂Si(OCH₃)₃

CH₃-[Si(CH₃)₂O]ₙ₁Si(CH₃)₂-(CH₂)_{H1}-O-(CH₂)_{H2}-C(=O)NHCH₂CH₂CH₂Si(OCH₃)₃

CH₃CH₂CH₂CH₂-[Si(CH₃)₂O]ₙ₁Si(CH₃)₂-(CH₂)_{H1}-O-(CH₂)_{H2}- C(=O)NHCH₂CH₂CH₂Si(OCH₃)₃

CH₃-[Si(CH₃)₂O]ₙ₁Si(CH₃)₂-(CH₂)_{H1}-Si(OCH₃)₃

CH₃CH₂CH₂CH₂-[Si(CH₃)₂O]ₙ₁Si(CH₃)₂-(CH₂)_{H1}-Si(OCH₃)₃

[(CH₃)₃SiO)]₂(CH₃)Si-O-[Si(CH₃)₂O]ₙ₁Si(CH₃)₂-(CH₂)_{H1}-Si(OCH₃)₃

[(CH₃)₃SiO)]₃Si-O-[Si(CH₃)₂O]ₙ₁Si(CH₃)₂-(CH₂)_{H1}-Si(OCH₃)₃

CH₃-[Si(CH₃)₂O]ₙ₁Si(CH₃)₂-(CH₂)_{H1}-C(=O)NHCH₂CH[CH₂CH₂CH₂Si(OCH₃)₃]₂

CH₃CH₂CH₂CH₂-[Si(CH₃)₂O]ₙ₁Si(CH₃)₂-(CH₂)_{H1}- C(=O)NHCH₂CH[CH₂CH₂CH₂Si(OCH₃)₃]₂

[(CH₃)₃SiO)]₂(CH₃)Si-O-[Si(CH₃)₂O]ₙ₁Si(CH₃)₂-(CH₂)_{H1}- C(=O)NHCH₂CH[CH₂CH₂CH₂Si(OCH₃)₃]₂

[(CH₃)₃SiO)]₃Si-O-[Si(CH₃)₂O]ₙ₁Si(CH₃)₂-(CH₂)_{H1}- C(=O)NHCH₂CH[CH₂CH₂CH₂Si(OCH₃)₃]₂

CH₃-[Si(CH₃)₂O]ₙ₁Si(CH₃)₂-(CH₂)_{H1}-O-(CH₂)_{H2}- C(=O)NHCH₂CH[CH₂CH₂CH₂Si(OCH₃)₃]₂

CH₃CH₂CH₂CH₂-[Si(CH₃)₂O]ₙ₁Si(CH₃)₂-(CH₂)_{H1}-O-(CH₂)_{H2}- C(=O)NHCH₂CH[CH₂CH₂CH₂Si(OCH₃)₃]₂

CH₃-[Si(CH₃)₂O]ₙ₁Si(CH₃)₂-(CH₂)_{H1}-CH[CH₂CH₂CH₂Si(OCH₃)₃]₂

CH₃CH₂CH₂CH₂-[Si(CH₃)₂O]ₙ₁Si(CH₃)₂-(CH₂)_{H1}-CH[CH₂CH₂CH₂Si(OCH₃)₃]₂

[(CH₃)₃SiO)]₂(CH₃)Si-O-[Si(CH₃)₂O]ₙ₁Si(CH₃)₂-(CH₂)_{H1}- CH[CH₂CH₂CH₂Si(OCH₃)₃]₂

[(CH₃)₃SiO)]₃Si-O-[Si(CH₃)₂O]ₙ₁Si(CH₃)₂-(CH₂)_{H1}-CH[CH₂CH₂CH₂Si(OCH₃)₃]₂

CH₃-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂

CH₃CH₂CH₂CH₂-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂

[(CH₃)₃SiO)]₂(CH₃)Si-O-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂

[(CH₃)₃SiO)]₃Si-O-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂

CH₃-[Si(CH₃)₂O]ₙ₁Si(CH₃)₂-(CH₂)_{H1}-O-(CH₂)_{H2}- C(=O)NHCH₂CH[CH₂CH₂CH₂CH₂CH₂CH₂CH₂CH₂CH₂CH₂CH₂Si(OCH₃)₃]₂

CH₃CH₂CH₂CH₂-[Si(CH₃)₂O]ₙ₁Si(CH₃)₂-(CH₂)_{H1}-O-(CH₂)_{H2}- C(=O)NHCH₂CH[CH₂CH₂CH₂CH₂CH₂CH₂CH₂CH₂CH₂CH₂CH₂Si(OCH₃)₃]₂

CH₃-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

CH₃CH₂CH₂CH₂-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

[(CH₃)₃SiO)]₂(CH₃)Si-O-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

[(CH₃)₃SiO)]₃Si-O-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂

CH₃-[Si(CH₃)₂O]ₙ₁Si(CH₃)₂-(CH₂)_{H1}-C(=O)N[CH₂CH₂CH₂Si(OCH₃)₃]₂

CH₃CH₂CH₂CH₂-[Si(CH₃)₂O]ₙ₁Si(CH₃)₂-(CH₂)_{H1}-C(=O)N[CH₂CH₂CH₂Si(OCH₃)₃]₂

[(CH₃)₃SiO)]₂(CH₃)Si-O-[Si(CH₃)₂O]ₙ₁Si(CH₃)₂-(CH₂)_{H1}- C(=O)N[CH₂CH₂CH₂Si(OCH₃)₃]₂

[(CH₃)₃SiO)]₃Si-O-[Si(CH₃)₂O]ₙ₁Si(CH₃)₂-(CH₂)_{H1}- C(=O)N[CH₂CH₂CH₂Si(OCH₃)₃]₂

CH₃-[Si(CH₃)₂O]ₙ₁Si(CH₃)₂-(CH₂)_{H1}-O-(CH₂)_{H2}-C(=O)N[CH₂CH₂CH₂Si(OCH₃)₃]₂

CH₃CH₂CH₂CH₂-[Si(CH₃)₂O]ₙ₁Si(CH₃)₂-(CH₂)_{H1}-O-(CH₂)_{H2}- C(=O)N[CH₂CH₂CH₂Si(OCH₃)₃]₂

CH₃-[Si(CH₃)₂O]ₙ₁Si(CH₃)₂-(CH₂)_{H1}-N[CH₂CH₂CH₂Si(OCH₃)₃]₂

CH₃CH₂CH₂CH₂-[Si(CH₃)₂O]ₙ₁Si(CH₃)₂-(CH₂)_{H1}-N[CH₂CH₂CH₂Si(OCH₃)₃]₂

[(CH₃)₃SiO)]₂(CH₃)Si-O-[Si(CH₃)₂O]ₙ₁Si(CH₃)₂-(CH₂)_{H1}- N[CH₂CH₂CH₂Si(OCH₃)₃]₂

[(CH₃)₃SiO)]₃Si-O-[Si(CH₃)₂O]ₙ₁Si(CH₃)₂-(CH₂)_{H1}-N[CH₂CH₂CH₂Si(OCH₃)₃]₂

CH₃-[Si(CH₃)₂O]ₙ₁Si(CH₃)₂-(CH₂)_{H1}-C(=O)NHCH₂C[CH₂CH₂CH₂Si(OCH₃)₃]₃

CH₃CH₂CH₂CH₂-[Si(CH₃)₂O]ₙ₁Si(CH₃)₂-(CH₂)_{H1}- C(=O)NHCH₂C[CH₂CH₂CH₂Si(OCH₃)₃]₃

[(CH₃)₃SiO)]₂(CH₃)Si-O-[Si(CH₃)₂O]ₙ₁Si(CH₃)₂-(CH₂)_{H1}- C(=O)NHCH₂C[CH₂CH₂CH₂Si(OCH₃)₃]₃

[(CH₃)₃SiO)]₃Si-O-[Si(CH₃)₂O]ₙ₁Si(CH₃)₂-(CH₂)_{H1}- C(=O)NHCH₂C[CH₂CH₂CH₂Si(OCH₃)₃]₃

CH₃-[Si(CH₃)₂O]ₙ₁Si(CH₃)₂-(CH₂)_{H1}-O-(CH₂)_{H2}- C(=O)NHCH₂C[CH₂CH₂CH₂Si(OCH₃)₃]₃

CH₃CH₂CH₂CH₂-[Si(CH₃)₂O]ₙ₁Si(CH₃)₂-(CH₂)_{H1}-O-(CH₂)_{H2}- C(=O)NHCH₂C[CH₂CH₂CH₂Si(OCH₃)₃]₃

CH₃-[Si(CH₃)₂O]ₙ₁Si(CH₃)₂-(CH₂)_{H1}-C[CH₂CH₂CH₂Si(OCH₃)₃]₃

CH₃CH₂CH₂CH₂-[Si(CH₃)₂O]ₙ₁Si(CH₃)₂-(CH₂)_{H1}-C[CH₂CH₂CH₂Si(OCH₃)₃]₃

[(CH₃)₃SiO)]₂(CH₃)Si-O-[Si(CH₃)₂O]ₙ₁Si(CH₃)₂-(CH₂)_{H1}- C[CH₂CH₂CH₂Si(OCH₃)₃]₃

[(CH₃)₃SiO)]₃Si-O-[Si(CH₃)₂O]ₙ₁Si(CH₃)₂-(CH₂)ᵤ₁-C[CH₂CH₂CH₂Si(OCH₃)₃]₃

[(CH₃)₃SiO)]₂(CH₃)Si-(CH₂)_{H1}-C(=O)NHCH₂CH₂CH₂Si(OCH₃)₃

[(CH₃)₃SiO)]₃Si-(CH₂)_{H1}-C(=O)NHCH₂CH₂CH₂Si(OCH₃)₃

[(CH₃)₃SiO)]₂(CH₃)Si-(CH₂)_{H1}-Si(OCH₃)₃

[(CH₃)₃SiO)]₃Si-(CH₂)_{H1}-Si(OCH₃)₃

[(CH₃)₃SiO)]₂(CH₃)Si-(CH₂)_{H1}-C(=O)NHCH₂CH[CH₂CH₂CH₂Si(OCH₃)₃]₂

[(CH₃)₃SiO)]₃Si-(CH₂)ᵤ₁-C(=O)NHCH₂CH[CH₂CH₂CH₂Si(OCH₃)₃]₂

[(CH₃)₃SiO)]₂(CH₃)Si-(CH₂)_{H1}-CH[CH₂CH₂CH₂Si(OCH₃)₃]₂

[(CH₃)₃SiO)]₃Si-(CH₂)_{H1}-CH[CH₂CH₂CH₂Si(OCH₃)₃]₂

[(CH₃)₃SiO)]₂(CH₃)Si-(CH₂)_{H1}- C(=O)NHCH₂CH[CH₂CH₂CH₂CH₂CH₂CH₂CH₂CH₂CH₂CH₂CH₂Si(OCH₃)₃]₂

[(CH₃)₃SiO)]₃Si-(CH₂)_{H1}- C(=O)NHCH₂CH[CH₂CH₂CH₂CH₂CH₂CH₂CH₂CH₂CH₂CH₂CH₂Si(OCH₃)₃]₂

[(CH₃)₃SiO)]₂(CH₃)Si-(CH₂)_{H1}- CH[CH₂CH₂CH₂CH₂CH₂CH₂CH₂CH₂CH₂CH₂CH₂Si(OCH₃)₃]₂

[(CH₃)₃SiO)]₃Si-(CH₂)_{H1}- CH[CH₂CH₂CH₂CH₂CH₂CH₂CH₂CH₂CH₂CH₂CH₂Si(OCH₃)₃]₂

[(CH₃)₃SiO)]₂(CH₃)Si-(CH₂)_{H1}-C(=O)N[CH₂CH₂CH₂Si(OCH₃)₃]₂

[(CH₃)₃SiO)]₃Si-(CH₂)_{H1}-C(=O)N[CH₂CH₂CH₂Si(OCH₃)₃]₂

[(CH₃)₃SiO)]₂(CH₃)Si-(CH₂)_{H1}-N[CH₂CH₂CH₂Si(OCH₃)₃]₂

[(CH₃)₃SiO)]₃Si-(CH₂)_{H1}-N[CH₂CH₂CH₂Si(OCH₃)₃]₂

[(CH₃)₃SiO)]₂(CH₃)Si-(CH₂)_{H1}-C(=O)NHCH₂C[CH₂CH₂CH₂Si(OCH₃)₃]₃

[(CH₃)₃SiO)]₃Si-(CH₂)_{H1}-C(=O)NHCH₂C[CH₂CH₂CH₂Si(OCH₃)₃]₃

[(CH₃)₃SiO)]₂(CH₃)Si-(CH₂)_{H1}-C[CH₂CH₂CH₂Si(OCH₃)₃]₃

[(CH₃)₃SiO)]₃Si-(CH₂)_{H1}-C[CH₂CH₂CH₂Si(OCH₃)₃]₃

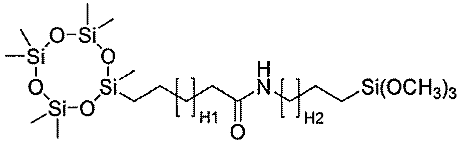

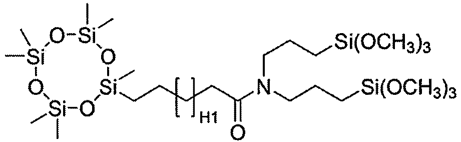

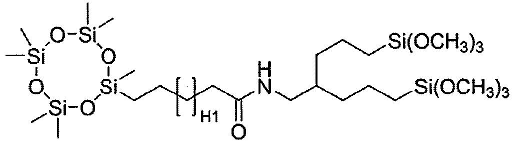

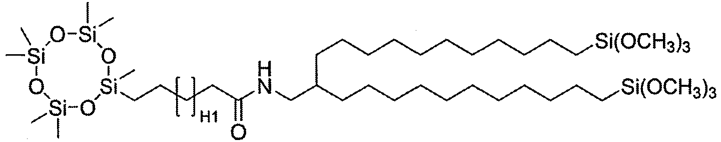

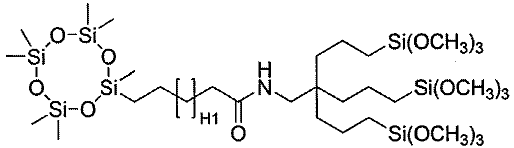

CH₃CH₂CH₂CH₂-[Si(CH₃)₂O]ₙ₁Si(CH₃)₂-(CH₂)_{H1}-O-(CH₂)_{H2}- C(CH₂CH₃)[CH₂OC(=O)NHCH₂CH₂CH₂Si(OCH₃)₃]₂

CH₃-[Si(CH₃)₂O]ₙ₁Si(CH₃)₂-(CH₂)_{H1}-O-(CH₂)_{H2}- C(CH₂CH₃)[CH₂OC(=O)NHCH₂CH₂CH₂Si(OCH₃)₃]₂

CH₃CH₂CH₂CH₂-[Si(CH₃)₂O]ₙ₁Si(CH₃)₂-(CH₂)_{H1}-O-(CH₂)_{H2}- C(CH₂CH₃)[CH₂OC(=O)NHCH₂CH₂OC(=O)CH(CH₃)CH₂Si(OCH₃)₃]₂

CH₃-[Si(CH₃)₂O]ₙ₁Si(CH₃)₂-(CH₂)_{H1}-O-(CH₂)_{H2}- C(CH₂CH₃)[CH₂OC(=O)NHCH₂CH₂OC(=O)CH(CH₃)CH₂Si(OCH₃)₃]₂

CH₃CH₂CH₂CH₂-[Si(CH₃)₂O]ₙ₁Si(CH₃)₂--(CH₂)_{H1}-O-(CH₂)_{H2}- C[CH₂OC(=O)NHCH₂CH₂CH₂Si(OCH₃)₃]₃

CH₃-[(Si(CH₃)₂O)]ₙ₁Si(CH₃)₂-(CH₂)_{H1}-O-(CH₂)_{H2}- C[CH₂OC(=O)NHCH₂CH₂CH₂Si(OCH₃)₃]₃

[CH₃CH₂CH₂CH₂-[(Si(CH₃)₂O)]ₙ₁Si(CH₃)₂-(CH₂)_{H1}-O-(CH₂)_{H2}-]₂- C[CH₂OC(=O)NHCH₂CH₂CH₂Si(OCH₃)₃]₂

[CH₃-[(Si(CH₃)₂O)]ₙ₁Si(CH₃)₂-(CH₂)_{H1}-O-(CH₂)_{H2}-]₂- C[CH₂OC(=O)NHCH₂CH₂CH₂Si(OCH₃)₃]₂

CH₃CH₂CH₂CH₂-[Si(CH₃)₂O]ₙ₁Si(CH₃)₂-(CH₂)_{H1}-O-(CH₂)_{H2}- OC(=O)NHCH₂CH₂CH₂Si(OCH₃)₃

CH₃-[Si(CH₃)₂O]ₙ₁Si(CH₃)₂-(CH₂)_{H1}-O-(CH₂)_{H2}-OC(=O)NHCH₂CH₂CH₂Si(OCH₃)₃

CH₃CH₂CH₂CH₂-[Si(CH₃)₂O]ₙ₁Si(CH₃)₂-(CH₂)_{H1}-O-(CH₂)_{H2}- OC(=O)NHCH₂CH₂OC(=O)CH(CH₃)CH₂Si(OCH₃)₃

CH₃-[Si(CH₃)₂O]ₙ₁Si(CH₃)₂-(CH₂)_{H1}-O-(CH₂)_{H2}- OC(=O)NHCH₂CH₂OC(=O)CH(CH₃)CH₂Si(OCH₃)₃

[CH₃CH₂CH₂CH₂-[Si(CH₃)₂O]ₙ₁Si(CH₃)₂-(CH₂)_{H1}-O-(CH₂)_{H2}-]₃C- CH₂OC(=O)NHCH₂CH₂CH₂Si(OCH₃)₃

[CH₃-[Si(CH₃)₂O]ₙ₁Si(CH₃)₂-(CH₂)_{H1}-O-(CH₂)_{H2}-]₃C- CH₂OC(=O)NHCH₂CH₂CH₂Si(OCH₃)₃

[CH₃CH₂CH₂CH₂-[(Si(CH₃)₂O)]ₙ₁Si(CH₃)₂-(CH₂)_{H1}-O- (CH₂)_{H2}-]₂C(CH₂CH₃)[CH₂OC(=O)NHCH₂CH₂CH₂Si(OCH₃)₃]

[CH₃-[(Si(CH₃)₂O)]ₙ₁Si(CH₃)₂-(CH₂)_{H1}-O- (CH₂)_{H2}-]₂C(CH₂CH₃)[CH₂OC(=O)NHCH₂CH₂CH₂Si(OCH₃)₃]

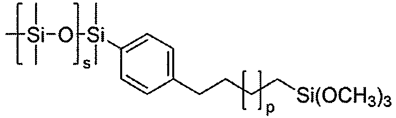

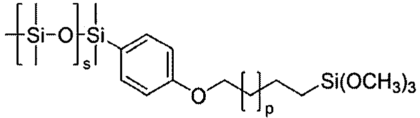

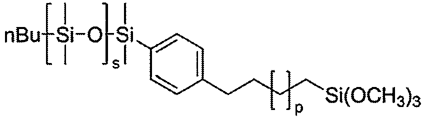

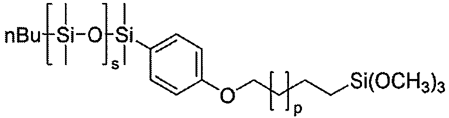

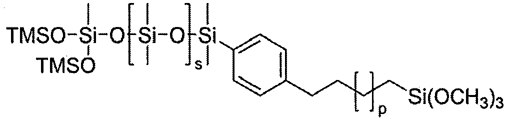

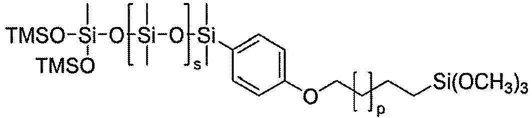

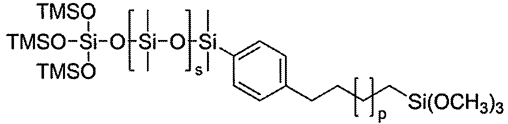

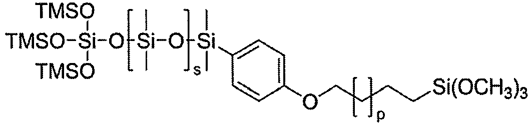

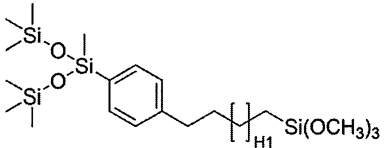

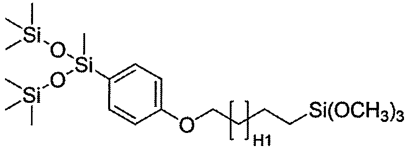

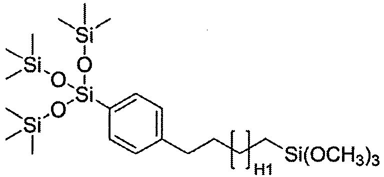

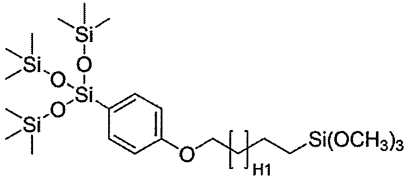

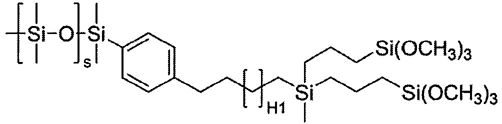

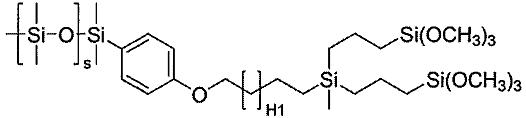

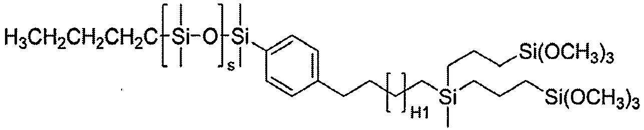

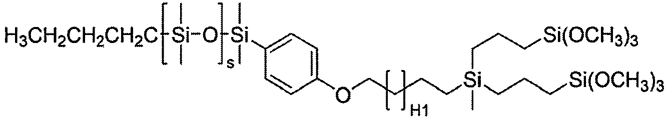

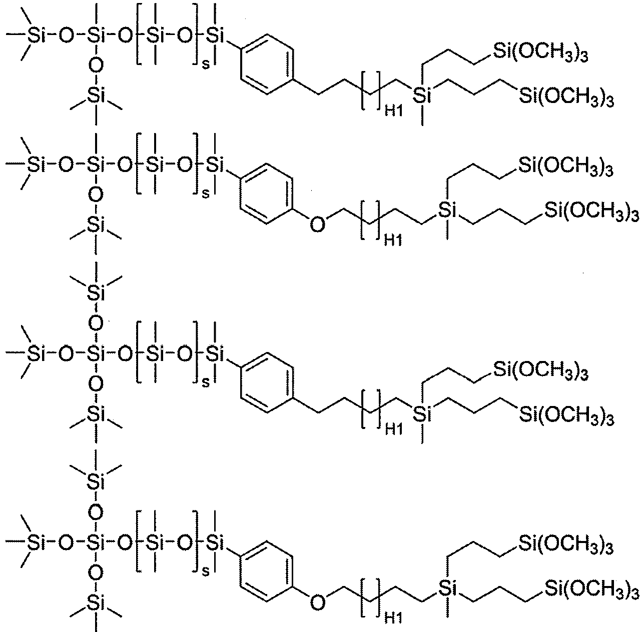

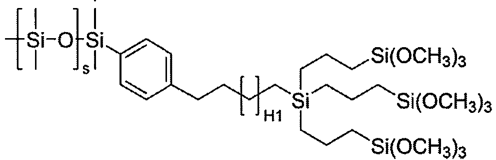

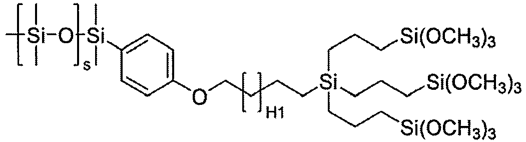

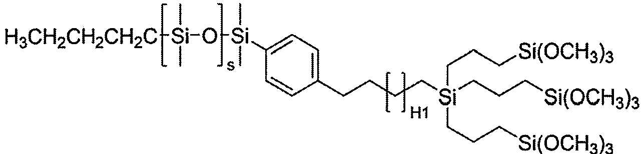

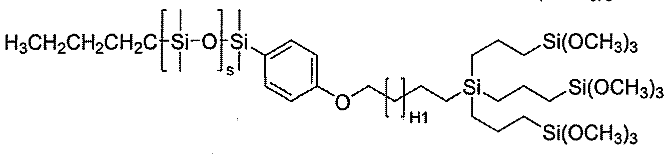

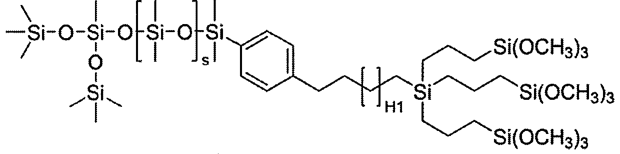

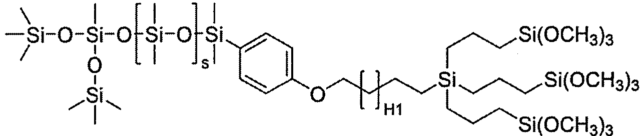

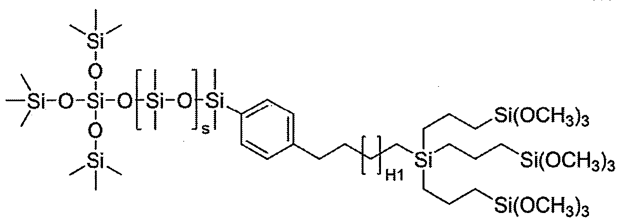

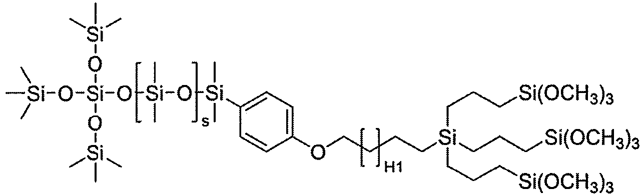

wherein TMS represents a trimethylsilyl group, n1 and s are each independently 0 to 150, and p, H1 and H2 are each independently 1 to 50.

In one embodiment, n1 and s are each independently 0 or 1, p and H1 are each independently 8 to 40, and H2 is each independently 1 to 10.

In another embodiment, n1 and s are each independently preferably 5 to 150, and more preferably 5 to 100, p and H1 are each independently 8 to 40, and H2 is each independently 1 to 10.

The silane compound preferably comprises a compound selected from the following group:
(CH₃CH₂CH₂CH₂Si(CH₃)₂-(OSi(CH₃)₂)ₙ-CH₂CH₂Si(CH₂CH₂CH₂Si(OCH₃)₃)₃ (n is 10 to 80, preferably 30 to 70, and more preferably 57)
(CH₃)₃Si-(OSi(CH₃)₂)ₙ-(CH₂)₁₀-CONH-CH₂C{CH₂CH₂CH₂Si(OCH₃)₃}₃ (n is 10 to 80, preferably 10 to 30, and more preferably 19)
(CH₃)₃Si-(OSi(CH₃)₂)ₙ-(CH₂)₂₂-CONH-CH₂CH[CH₂CH₂CH₂Si(OCH₃)₃]₂ (n is 10 to 80, preferably 30 to 70, and more preferably 57)
(CH₃CH₂CH₂CH₂Si(CH₃)₂-(OSi(CH₃)₂)ₙ-(CH₂)₃-OCH₂-CONH-CH₂C{CH₂CH₂CH₂Si(OCH₃)₃}₃ (n is 10 to 80, preferably 30 to 70, and more preferably 57)
CH₃CH₂CH₂CH₂Si(CH₃)₂-(OSi(CH₃)₂)ₙ-(CH₂)₂₂-CONH-CH₂CH₂CH₂Si(OCH₃)₃ (n is 10 to 80, preferably 10 to 30, and more preferably 13)
(CH₃)₃Si-(OSi(CH₃)₂)ₙ-(CH₂)₁₀-CON{CH₂CH₂CH₂Si(OCH₃)₃}₂ (n is 10 to 80, preferably 10 to 30, and more preferably 19)
(CH₃)₃Si-(OSi(CH₃)₂)ₙ-(CH₂)₂₂-CON[CH₂CH₂CH₂Si(OCH₃)₃]₂ (n is 10 to 80, preferably 10 to 40, and more preferably 26)
(CH₃)₃Si-(OSi(CH₃)₂)ₙ-(CH₂)₂₂-CON[CH₂CH₂CH₂Si(OCH₃)₃]₂ (n is 10 to 80, preferably 20 to 50, and more preferably 34)
(CH₃)₃Si-(OSi(CH₃)₂)ₙ-(CH₂)₂₂-CON((CH₂)₃Si(OCH₃)₃)₂ (n is 10 to 80, preferably 30 to 60, and more preferably 48)
CH₃CH₂CH₂CH₂Si(CH₃)₂-(CH₂CH₂CH₂Si(CH₃)₂)ₙ-CH₂CH₂CH₂-Si(CH₂CH₂CH₂Si(OCH₃)₃)₃ (n is 10 to 80, preferably 50 to 80, and more preferably 78)
[(CH₃)₃SiO]₂CH₃Si-(OSi(CH₃)₂)ₙ-(CH₂)₂₂-CONH-CH₂CH[CH₂CH₂CH₂Si(OCH₃)₃]₂ (n is 10 to 80, preferably 10 to 40, and more preferably 26) 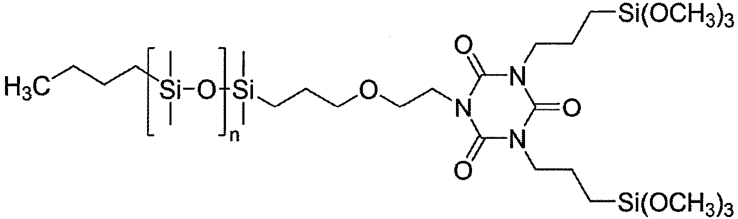
(n is 10 to 80, preferably 10 to 40, and more preferably 20) 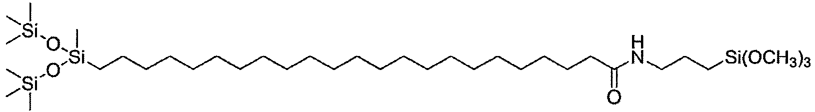 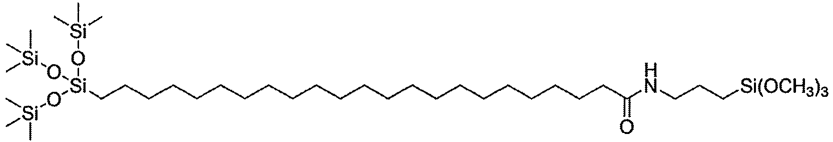 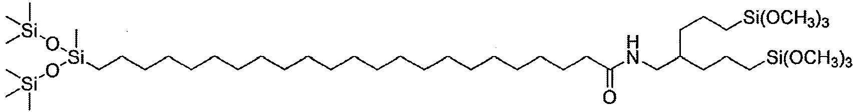 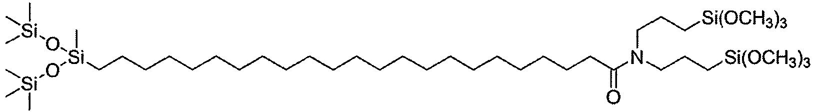 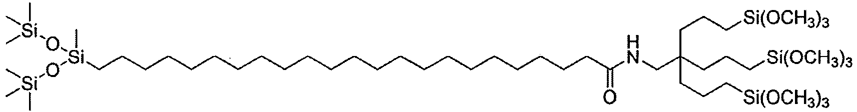 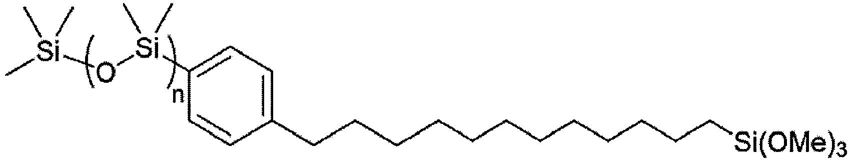
(n is 10 to 80, preferably 10 to 40, and more preferably 14) 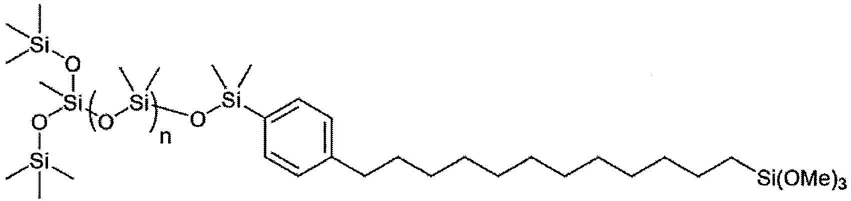
(n is 10 to 80, preferably 10 to 40, and more preferably 14.3) 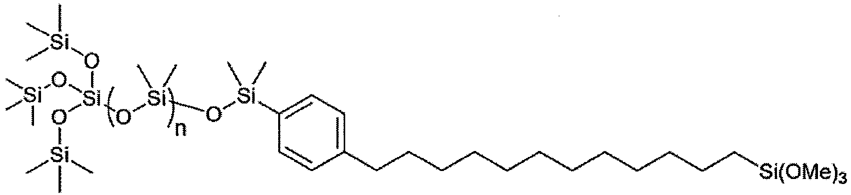
(n is 10 to 80, preferably 10 to 40, and more preferably 18.5)

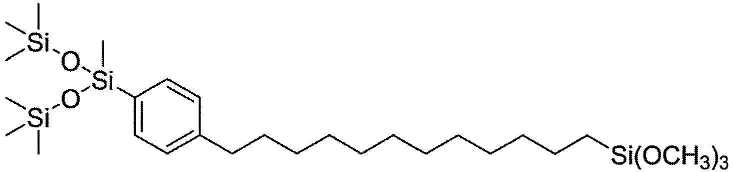

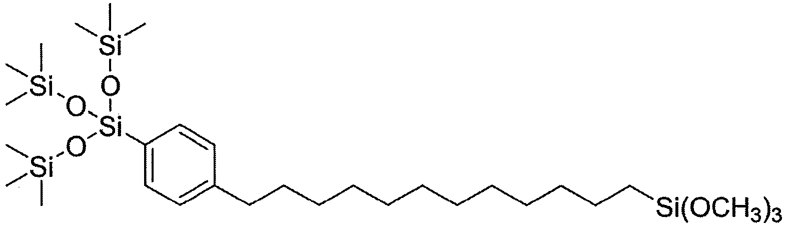

### (Transition metal)

The transition metal is not limited, and may be preferably comprised as a compound comprising the transition metal, in the composition. The transition metal may be a compound that may act as a catalyst, in particular, that may be act as a catalyst for hydrosilylation. The composition of the present disclosure comprises the transition metal and thus it is considered that a hydrolysis reaction of a hydrolyzable silyl group in the silane compound to a silanol group, and a dehydrative condensation reaction between the silanol group and a substrate surface can sufficiently progress, and it is considered that, even if the surface-treating layer is repeatedly abraded, excellent durability that hardly causes the surface-treating layer to be degraded in properties thereof is obtained. It is considered that, as a result, the number of chemical bonds that can be formed between the surface-treating layer and the substrate can increase to result in an enhancement in abrasion durability.

The transition metal is preferably comprised as one or more selected from transition metal compounds comprising Group 8 to Group 10 transition metals, in the composition, and such a transition metal compound preferably comprises one or more selected from a nickel compound, a palladium compound, a platinum compound, a rhodium compound, a ruthenium compound, an iron compound and a cobalt compound, more preferably comprises one or more selected from a nickel compound, a palladium compound, a platinum compound, a rhodium compound and a ruthenium compound, and particularly preferably comprises a platinum compound from the viewpoint of catalysis.

Examples of the nickel compound include nickel compounds such as nickel(II) acetate and nickel(II) pivalate.

Examples of the palladium compound include dichlorobis(triphenylphosphine)palladium(II), dichlorobis(benzonitrile)palladium(II), and tetrakis(triphenylphosphine)palladium(0).

Examples of the platinum compound include elemental platinum; platinum complexes such as a platinum/divinyltetramethyldisiloxane complex and a platinum/tetramethyltetravinylcyclotetrasiloxane complex; chloroplatinic acid; and platinum oxide. In particular, preferable are platinum complexes, and more preferable are a platinum/divinyltetramethyldisiloxane complex and a platinum/tetramethyltetravinylcyclotetrasiloxane complex.

Examples of the rhodium compound include chlorotris(triphenylphosphine)rhodium(I), chloro(1,5-cyclooctadiene)rhodium(I) (dimer), bis(1,5-cyclooctadiene)rhodium(I)tetrafluoroborate, and tris(triphenylphosphine)rhodium carbonyl hydride.

Examples of the ruthenium compound include dichlorotris(triphenylphosphine)ruthenium(II), dichloro(p-cymene)ruthenium(II) (dimer), and pentamethylcyclopentadienyltris(acetonitrile)ruthenium(II) hexafluorophosphate.

Examples of the iron compound include iron compounds such as iron(II) acetate, iron(II) pivalate, iron(II) trifluoroacetate (tetrahydrofuran complex), and an iron complex having an iron-oxygen bond, prepared from [Fe(mesityl) (µ-mesityl)]₂ and any of various alcohols, carboxylic acids or siloxane-containing carboxylates.

Examples of the cobalt compound include cobalt compounds such as cobalt(II) acetate, cobalt(II) chloride, cobalt(II) bromide, cobalt(II) isopropoxide, cobalt(II) pivalate, and cobalt(II) trifluoroacetate (tetrahydrofuran complex).

The content of the transition metal in the composition of the present disclosure may be preferably 0.001 mol or more and 2.00 mol or less, more preferably 0.001 mol or more and 1.00 mol or less, and even more preferably 0.001 mol or more and 0.50 mol or less based on 100 mol of the silane compound. When the content of the transition metal is in such a range, the surface-treating layer can be enhanced in abrasion durability without any loss of transparency of a substrate.

Note that, in the present disclosure, the amount of the transition metal may mean the amount of the transition metal comprised in the transition metal compound or the transition metal catalyst.

In one embodiment, the content of the transition metal catalyst in the composition of the present disclosure may be preferably 0.001 mol or more and 0.50 mol or less, more preferably 0.001 mol or more and 0.10 mol or less, and even more preferably 0.001 mol or more and 0.05 mol or less based on 100 mol of the silane compound. When the content of the transition metal catalyst is in such a range, the abrasion durability and also the storage stability of the surface-treating layer can be increased without any loss of transparency of a substrate.

In one embodiment, the content of the transition metal catalyst in the composition of the present disclosure may be preferably 0.001 mol or more and 0.05 mol or less, more preferably 0.001 mol or more and 0.03 mol or less, and even more preferably 0.001 mol or more and 0.02 mol or less based on 100 mol of the silane compound. When the content of the transition metal catalyst is in such a range, the abrasion durability and also the storage stability of the surface-treating layer can be increased without any loss of transparency of a substrate.

In one embodiment, the content of the transition metal catalyst in the composition of the present disclosure may be preferably 0.001 mol or more and 0.02 mol or less, more preferably 0.001 mol or more and 0.01 mol or less, and even more preferably 0.001 mol or more and 0.05 mol or less based on 100 mol of the silane compound. When the content of the transition metal catalyst is in such a range, the abrasion durability and also the storage stability of the surface-treating layer can be increased without any loss of transparency of a substrate.

The content of the transition metal catalyst in the composition of the present disclosure may be preferably 0.001 to 1.00% by mass, more preferably 0.001 to 0.5% by mass, even more preferably 0.001 to 0.1% by mass relative to the silane compound. When the content of the transition metal catalyst is in such a range, the abrasion durability of the surface-treating layer can be increased without any loss of transparency of a substrate.

Next, the surface-treating agent of the present invention will now be described.

The surface-treating agent of the present disclosure comprises the silane compound and the transition metal. The surface-treating agent of the present disclosure may be used for coating, and the surface-treating agent to be used in coating is also simply referred to as "coating liquid".

In one embodiment, the surface-treating agent (coating liquid) of the present disclosure is a composition itself comprising the silane compound and the transition metal.

In one embodiment, the total content of the silane compound and the transition metal may be preferably 0.1 to 50.0% by mass, more preferably 1.0 to 30.0% by mass, even more preferably 5.0 to 25.0% by mass, and particularly preferably 10.0 to 20.0% by mass based on the entirety of the surface-treating agent.

In another embodiment, the total content of the silane compound and the transition metal may be preferably 0.001 to 30% by mass, more preferably 0.01 to 10% by mass, even more preferably 0.05 to 5% by mass, and particularly preferably 0.05 to 2% by mass based on the entirety of the surface-treating agent.

In one embodiment, the surface-treating agent (coating liquid) of the present disclosure may comprise the composition and at least one of a compound composed of a condensate in which at least a part of the silane compounds comprised in the composition is condensed. In other words, the surface-treating agent of the present disclosure may comprise the silane compound and a condensate in which at least a part of the silane compounds is condensed.

In the above embodiment, the content of the condensate may be preferably 40% by mass or less and more preferably 30% by mass or less based on the sum of the silane compound and the condensate of the silane compound. Here, the content of the condensate can be determined from, for example, the abundance ratio of the peak position to the area in GPC (gel permeation chromatography).

The surface-treating agent (coating liquid) of the present disclosure may further comprise a solvent, a (non-reactive) silicone compound that may be understood as a silicone oil (hereinafter, referred to as "silicone oil"), an amine compound, an alcohol, a catalyst, a surfactant, a polymerization inhibitor, a sensitizer, and the like.

In one embodiment, the surface-treating agent (coating liquid) of the present disclosure further comprises a compound represented by R⁹⁰-OH.

R⁹⁰ is a monovalent organic group and is preferably a C₁₋₂₀ alkyl group or a C₃₋₂₀ alkylene group, and these groups may be substituted with one or more substituents. Examples of substituents include a hydroxyl group and -OR⁹¹ wherein R⁹¹ is a C₁₋₁₀ alkyl group, and preferably a C₁₋₃ alkyl group, such as a methyl group.

In one embodiment, the surface-treating agent (coating liquid) of the present disclosure may further comprise a solvent selected from the compounds represented by R⁸¹OR⁸², R⁸³ₙ₈C₆H₆₋ₙ₈, R⁸⁴R⁸⁵R⁸⁶Si-(O-SiR⁸⁷R⁸⁸)ₘ₈-R⁸⁹, and (OSiR⁸⁷R⁸⁸)ₘ₉, wherein
R⁸¹ to R⁸⁹ are each independently a monovalent organic group having 1 to 10 carbon atoms,
m8 is an integer of 1 to 6,
m9 is an integer of 3 to 8, and
n8 is an integer of 0 to 6.

The monovalent organic group having 1 to 10 carbon atoms may be linear or branched, and may further comprise a cyclic structure.

In one embodiment, the monovalent organic group having 1 to 10 carbon atoms may comprise an oxygen atom, a nitrogen atom, or a halogen atom.

In another embodiment, the monovalent organic group having 1 to 10 carbon atoms does not comprise a halogen atom.

In a preferable embodiment, the monovalent organic group having 1 to 10 carbon atoms is a hydrocarbon group optionally substituted with a halogen, and preferably a hydrocarbon group not substituted with a halogen.

In one embodiment, the hydrocarbon group is linear.

In another embodiment, the hydrocarbon group is branched.

In another embodiment, the hydrocarbon group comprises a cyclic structure.

In one embodiment, the solvent is R⁸¹OR⁸².

R⁸¹ and R⁸² may be, each independently, preferably a hydrocarbon group having 1 to 8 carbon atoms, and more preferably a C₁₋₆ alkyl group or a C₅₋₈ cycloalkyl group.

In one embodiment, the solvent is R⁸³ₙ₈C₆H₆₋ₙ₈.

C₆H₆₋ₙ₈ is an n8-valent benzene ring. That is to say, R⁸³ₙ₈C₆H₆₋ₙ₈ is benzene substituted with n8 R⁸³.

R⁸³ may be each independently a halogen, or a C₁₋₆ alkyl group optionally substituted with a halogen.

n8 is preferably an integer of 1 to 3.

In one embodiment, the solvent is R⁸⁴R⁸⁵R⁸⁶Si-(O-SiR⁸⁷R⁸⁸)ₘ₈-R⁸⁹.

In one embodiment, the solvent is (OSiR⁸⁷R⁸⁸)ₘ₉. (OSiR⁸⁷R⁸⁸)ₘ₉ is a cyclic siloxane formed of multiple OSiR⁸⁷R⁸⁸ units bonded in a cyclic form.

R⁸⁴ to R⁸⁹ are each independently a hydrogen atom or a C₁₋₆ alkyl group, preferably a C₁₋₆ alkyl group, more preferably a C₁₋₃ alkyl group, and even more preferably a methyl group.

m8 is preferably an integer of 1 to 6, more preferably an integer of 1 to 5, and even more preferably 1 to 2.

m9 is preferably an integer of 3 to 6, and more preferably an integer of 3 to 5.

In one embodiment, examples of the solvent include aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide, N,N-dimethylacetamide, and N-methylpyrrolidone; ether alcohols such as methyl cellosolve, cellosolve, isopropyl cellosolve, butyl cellosolve, and diethylene glycol monomethyl ether; diethylene glycol monoethyl ether acetate; polyfluoroaromatic hydrocarbons (for example, 1,3-bis(trifluoromethyl)benzene); polyfluoroaliphatic hydrocarbons (for example, C₆F₁₃CH₂CH₃ (for example, ASAHIKLIN(R) AC-6000 manufactured by AGC Inc.), C₆F₁₃H (for example, ASAHIKLIN(R) AC-2000 manufactured by AGC Inc.), and 1,1,2,2,3,3,4-heptafluorocyclopentane (for example, Zeorolla(R) H manufactured by ZEON Corporation); fluorine-containing hydrocarbons such as 1,1,2-trichloro-1,2,2-trifluoroethane, 1,2-dichloro-1,1,2,2-tetrafluoroethane, 1,1-dichloro-1,2,2,3,3-pentafluoropropane (HCFC 225), and 1,3-bis(trifluoromethyl)benzene; fluorine-containing alcohols such as CF₃CH₂OH, CF₃CF₂CH₂OH, and (CF₃)₂CHOH; alkyl perfluoroalkyl ethers (the perfluoroalkyl group and the alkyl group may be linear or branched) such as hydrofluoroethers (HFE) (for example, perfluoropropyl methyl ether (C₃F₇OCH₃) (for example, Novec(TM) 7000 manufactured by SUMITOMO 3M), perfluorobutyl methyl ether (C₄F₉OCH₃) (for example, Novec(TM) 7100 manufactured by SUMITOMO 3M), perfluorobutyl ethyl ether (C₄F₉OC₂H₅) (for example, Novec(TM) 7200 manufactured by SUMITOMO 3M), and perfluorohexyl methyl ether (C₂F₅CF(OCH₃)C₃F₇) (for example, Novec(TM) 7300 manufactured by SUMITOMO 3M), or CF₃CH₂OCF₂CHF₂ (for example, ASAHIKLIN(R) AE-3000 manufactured by AGC Inc.)), hydrofluoroolefins; ethers such as CF₃CH=CHCl (for example, CELEFIN(R) 1233Z manufactured by Central Glass Co., Ltd.), CHF₂CF=CHCl (for example, AMOLEA(R) AS-300 manufactured by AGC Inc.), and cyclopentyl methyl ether; siloxanes such as hexamethyldisiloxane, hexaethyldisiloxane, octamethyltrisiloxane, octamethylcyclotetrasiloxane, octamethylcyclopentasiloxane, decamethylcyclopentasiloxane, decamethyltetrasiloxane, dodecamethylpentasiloxane, and tetradecamethylhexasiloxane; and dimethylsulfoxide. Alternatively, the solvent may be a mixed solvent of two or more of such solvents. In particular, preferable are aliphatic hydrocarbons, aromatic hydrocarbons, esters, glycol ethers, alcohols, ether alcohols, and siloxanes. For example, preferable are hexane, cyclohexane, heptane, octane, nonane, decane, undecane, dodecane, mineral spirit, benzene, toluene, xylene, naphthalene, methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl-2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, ethyl 2-hydroxyisobutyrate, propylene glycol monomethyl ether, propylene glycol monoethyl ether, propylene glycol monobutyl ether, methanol, ethanol, iso-propanol, n-butanol, isobutanol, tert-butanol, sec-butanol, diethylene glycol monomethyl ether, hexamethyldisiloxane, hexaethyldisiloxane, octamethyltrisiloxane, decamethyltetrasiloxane, dodecamethylpentasiloxane, tetradecamethylhexasiloxane, octamethylcyclotetrasiloxane, and octamethylcyclopentasiloxane.

Examples of the silicone oil include, but are not limited to, compounds represented by the following general formula (3a):

R^{101a}-(SiR^{103a}₂-O)ₐ₁-SiR^{103a}₂-R^{101a} (3a)

wherein
R^{101a} is each independently a hydrogen atom or a hydrocarbon group,
R^{103a} is each independently a hydrogen atom or a hydrocarbon group, and
a1 is 2 to 3,000.

R^{103a} is each independently a hydrogen atom or a hydrocarbon group. Such a hydrocarbon group may be substituted.

R^{103a} is each independently preferably an unsubstituted hydrocarbon group, or a hydrocarbon group substituted with a halogen atom. Such a halogen atom is preferably a fluorine atom.

R^{103a} is, each independently, preferably a C₁₋₆ alkyl group or an aryl group optionally substituted with a halogen atom, and more preferably a C₁₋₆ alkyl group or an aryl group.

The C₁₋₆ alkyl group may be linear or may be branched, and is preferably linear.
The C₁₋₆ alkyl group is preferably a C₁₋₃ alkyl group, and more preferably a methyl group.

The aryl group is preferably a phenyl group.

In one embodiment, R^{103a} is each independently a C₁₋₆ alkyl group, preferably a C₁₋₃ alkyl group, and more preferably a methyl group or n-butyl group.

In one embodiment, R^{103a} is a methyl group. In another embodiment, R^{103a} is a n-butyl group.

In another embodiment, R^{103a} is a phenyl group.

In another embodiment, R^{103a} is a methyl group or a phenyl group, and preferably a methyl group.

R^{101a} is each independently a hydrogen atom or a hydrocarbon group, and has the same meanings as those described for R^{3a}.

R^{101a} is, each independently, preferably a C₁₋₆ alkyl group or an aryl group optionally substituted with a halogen atom, and more preferably a C₁₋₆ alkyl group or an aryl group.

In one embodiment, R^{101a} is each independently a C₁₋₆ alkyl group, preferably a C₁₋₃ alkyl group, and more preferably a methyl group or a n-butyl group.

In one embodiment, R^{101a} is a methyl group. In another embodiment, R^{101a} is a n-butyl group.

In another embodiment, R^{101a} is a phenyl group.

In another embodiment, R^{101a} is a methyl group or a phenyl group, and preferably a methyl group.

a1 is 2 to 1,500. a1 may be preferably 5 or more, more preferably 10 or more, and even more preferably 15 or more, such as 30 or more or 50 or more. a1 may be preferably 1,000 or less, more preferably 500 or less, even more preferably 200 or less, and yet more preferably 150 or less, such as 100 or less or 80 or less.

a1 may be preferably 5 to 1,000, more preferably 10 to 500, even more preferably 15 to 200, and yet more preferably 15 to 150.

Other examples of the silicone oil include compounds represented by (3b) below:

R^{101a}-R^{SO2}-R^{103a} (3b)

wherein
R^{101a} is each independently a hydrocarbon group,
R^{103a} is each independently a hydrocarbon group, and
R^{SO2} is -R^{S}-SiR⁵₂-, wherein R^{S} and R⁵ have the same meanings as above.

The silicone oil may have an average molecular weight of 500 to 1,000,000, and preferably 1,000 to 100,000. The molecular weight of the silicone oil may be measured using GPC.

The silicone oil may be, for example, a linear or cyclic silicone oil in which a1 in -(SiR^{3a}₂-O)ₐ₁- is 30 or less. The linear silicone oil may be a so-called straight silicone oil or modified silicone oil. Examples of the straight silicone oil include dimethyl silicone oil, methyl phenyl silicone oil, and methyl hydrogen silicone oil. Examples of the modified silicone oil include those obtained by modifying a straight silicone oil with alkyl, aralkyl, polyether, higher fatty acid ester, fluoroalkyl, amino, epoxy, carboxyl, alcohol, or the like. The cyclic silicone oil may be, for example, cyclic dimethylsiloxane oil.

The silicone oil may be comprised in an amount of, for example, 0 to 50% by mass, preferably 0.001 to 30% by mass, and more preferably 0.1 to 5% by mass, based on the surface-treating agent (coating liquid) of the present disclosure.

In the surface-treating agent (coating liquid) of the present disclosure, such a silicone oil may be comprised in an amount of, for example, 0 to 300 parts by mass, preferably 0 to 100 parts by mass, more preferably 0 to 50 parts by mass, and even more preferably 0 to 10 parts by mass, based on total 100 parts by mass of the compound comprised in the composition of the present disclosure (in the case of two or more kinds, the total thereof, and the same applies below).

The silicone oil contributes to increasing the surface lubricity of the surface-treating layer.

Examples of the alcohol include methanol, ethanol, iso-propanol, n-butanol, isobutanol, tert-butanol, sec-butanol, 3-pentanol, octyl alcohol, 3-methyl-3-methoxybutanol, and tert-amyl alcohol. Such an alcohol added to the composition improves the stability of the composition.

Examples of the catalyst include acids (for example, acetic acid, hydrochloric acid, nitric acid, sulfuric acid, phosphoric acid, sulfonic acid, p-toluenesulfonic acid, trifluoroacetic acid, and the like), bases (for example, sodium hydroxide, potassium hydroxide, ammonia, triethylamine, diethylamine, and the like), other transition metals (for example, Ti, Ni, Sn, Zr, Al, B, Si, Ta, Nb, Mo, W, Cr, Hf, V, and the like), and sulfur-containing compounds or nitrogen-containing compounds having an unshared electron pair in the molecular structure (for example, sulfoxide compounds, aliphatic amine compounds, aromatic amine compounds, phosphoric acid amide compounds, amide compounds, and urea compounds).

Examples of the aliphatic amine compound include diethylamine and triethylamine. Examples of the aromatic amine compound include aniline and pyridine.

In a preferable embodiment, another transition metal described above may be comprised as another transition metal compound represented by M-R, wherein M is a transition metal atom and R is a hydrolyzable group. By using a compound obtained by bonding another transition metal described above and a hydrolyzable group, as such another transition metal compound, another transition metal atom can be comprised in the surface-treating layer more efficiently, and the friction durability and the chemical resistance of the surface-treating layer can be more increased. Herein, another transition metal described above and another transition metal compound described above are different from the transition metal, the transition metal compound and the transition metal catalyst.

The hydrolyzable group means a group that can undergo a hydrolysis reaction in the same manner as the hydrolyzable group concerning the above compound, i.e., means a group that can be removed from the transition metal atom by a hydrolysis reaction. Examples of the hydrolyzable group include -OR^{m}, -OCOR^{m}, -ON=CR^{m}₂, -NR^{m}₂, -NHR^{m}, -NCO, and a halogen (in these formulae, R^{m} represents a substituted or unsubstituted C₁₋₄ alkyl group).

In a preferable embodiment, the hydrolyzable group is -OR^{m}, and preferably methoxy or ethoxy. By using an alkoxy group as the hydrolyzable group, the transition metal atom can be comprised in the surface-treating layer more efficiently, and the abrasion durability and the chemical resistance of the surface-treating layer can be more increased.

In one embodiment, the hydrolyzable group may be the same as the hydrolyzable group comprised in the above compound. By causing the hydrolyzable groups in the compound and in the transition metal compound to be the same group, the influence of such hydrolyzable groups being mutually exchanged, if ever, can be minimized.

In another embodiment, the hydrolyzable group may be different from the hydrolyzable group comprised in the above compound. By causing the hydrolyzable groups in the above compound and in the transition metal compound to be different, the reactivity of hydrolysis can be controlled.

In one embodiment, the above hydrolyzable group and the hydrolyzable group comprised in the above compound may be mutually exchanged in the composition.

In a preferable embodiment, another transition metal compound described above may be Ta(OR^{m})₅ (wherein R^{m} is a substituted or unsubstituted C₁₋₄ alkyl group), preferably Ta(OCH₂CH₃)₅ or Si(OR^{m})₁₋ₘ₁R^{m'}ₘ₁ (wherein R^{m} is a substituted or unsubstituted C₁₋₄ alkyl group, R^{m'} is a C₁₋₄ alkyl group, and m1 is 0 or 1), and preferably tetraethoxysilane, methyltrimethoxysilane, methyltriethoxysilane, tetraisopropoxysilane, dimethyldiethoxysilane, or dimethyldimethoxysilane.

The catalyst may be comprised in an amount of, for example, 0.0002% by mass or more based on the entirety of the surface-treating agent (coating liquid). The catalyst may be comprised in an amount of preferably 0.02% by mass or more, and more preferably 0.04% by mass or more, based on the entirety of the surface-treating agent (coating liquid). The catalyst may be comprised in an amount of, for example, 10% by mass or less based on the entirety of the surface-treating agent (coating liquid) and, in particular, is comprised in an amount of 1% by mass or less. The surface-treating agent (coating liquid) of the present disclosure can contribute to the formation of a surface-treating layer having better durability when the catalyst is comprised in the concentration as described above.

The content of the catalyst is preferably 0 to 10% by mass, more preferably 0 to 5% by mass, and particularly preferably 0 to 1% by mass, based on the compound comprised in the composition of the present disclosure.

The catalyst promotes hydrolysis and dehydrative condensation of the compound comprised in the composition of the present disclosure, and promotes formation of a layer formed of the composition of the present disclosure.

Examples of other components include, in addition to those described above, tetraethoxysilane, methyltrimethoxysilane, 3-aminopropyltrimethoxysilane, 3-glycidoxypropyltrimethoxysilane, and methyltriacetoxysilane.

The surface-treating agent (coating liquid) of the present disclosure may comprise, in addition to the components described above, trace amounts of Pt, Rh, Ru, 1,3-divinyltetramethyldisiloxane, triphenylphosphine, NaCl, KCl, silane condensates, and the like as impurities.

In one embodiment, the surface-treating agent (coating liquid) of the present disclosure is for a dry coating method, and preferably for vacuum deposition.

In one embodiment, the surface-treating agent (coating liquid) of the present disclosure is for a wet coating method, and preferably for dip coating.

The surface-treating agent (coating liquid) of the present disclosure can be formed into pellets by impregnating a porous material such as a porous ceramic material or a metal fiber such as a fiber obtained by, for example, solidifying steel wool in a cotton-like form with composition. Such pellets can be used in, for example, vacuum deposition.

The composition of the present disclosure is preferably used as a surface-treating agent or as a component of a surface-treating agent.

Below, the article of the present disclosure will now be described.

The article of the present disclosure comprises a substrate and a layer (a surface-treating layer) on the substrate surface, the layer being formed of the surface-treating agent (coating liquid) of the present disclosure.

The substrate usable in the present disclosure may be composed of any suitable material such as glass, resin (which may be natural or synthetic resin such as a commonly used plastic material), metal, ceramics, semiconductors (such as silicon and germanium), fiber (such as woven fabric and nonwoven fabric), fur, leather, wood, pottery, stone, building materials, and sanitary articles.

For example, when the article to be produced is an optical member, the material constituting the surface of the substrate may be a material for an optical member, such as glass or a transparent plastic. When the article to be produced is an optical member, some layer (or film), such as a hard coat layer or an antireflection layer, may be formed on the surface (the outermost layer) of the substrate. The antireflection layer may be any of a single-layer antireflection layer and a multi-layer antireflection layer. Examples of inorganic substances usable in the antireflection layer include SiO₂, SiO, ZrO₂, TiO₂, TiO, Ti₂O₃, Ti₂O₅, Al₂O₃, Ta₂O₅, Ta₃O₅, Nb₂O₅, HfO₂, Si₃N₄, CeO₂, MgO, Y₂O₃, SnO₂, MgF₂, and WO₃. One of these inorganic substances may be used singly, or two or more kinds thereof may be used in combination (for example, as a mixture). In the case of a multi-layer antireflection layer, SiO₂ and/or SiO is preferably used in the outermost layer thereof. When the article to be produced is an optical glass component for a touch panel, a part of the surface of the substrate (glass) may have a transparent electrode such as a thin film in which indium tin oxide (ITO), indium zinc oxide, or the like is used. The substrate, according to its specific configuration or the like, may have an insulating layer, an adhesive layer, a protecting layer, a decorated frame layer (I-CON), an atomizing film layer, a hard coating layer, a polarizing film, a phase difference film, a liquid crystal display module, or the like.

The form of the substrate is not limited, and may be, for example, a plate, a film, or the like. The surface region of the substrate on which a surface-treating layer is to be formed may be at least a portion of the substrate surface, and may be suitably determined according to the application, specific configuration, and the like of an article to be produced.

In one embodiment, the substrate, or at least the surface portion thereof, may be composed of a material originally having a hydroxyl group. Examples of the material include glass, as well as metal (in particular, base metal) that forms a natural oxidized film or a thermal oxidized film on its surface, ceramics, and semiconductors. Alternatively, when the substrate has an insufficient amount of hydroxyl groups or when the substrate originally has no hydroxyl group as in resin and the like, a pre-treatment may be performed on the substrate to thereby introduce or increase hydroxyl groups on the surface of the substrate. Examples of such a pre-treatment include a plasma treatment (for example, corona discharge) and ion beam irradiation. The plasma treatment can be suitably utilized to not only introduce or increase hydroxyl groups on the substrate surface, but also clean the substrate surface (remove foreign matter and the like). Another example of such a pre-treatment is a method wherein a monolayer of a surface adsorbent having a carbon-carbon unsaturated bonding group is formed on the surface of the substrate by a LB method (a Langmuir-Blodgett method), a chemical adsorption method, or the like beforehand, and thereafter cleaving the unsaturated bond under an atmosphere comprising oxygen, nitrogen, or the like.

In another embodiment, the substrate, or at least the surface portion thereof, may be composed of a material comprising another reactive group such as a silicone compound having one or more Si-H groups or alkoxysilane.

In a preferable embodiment, the substrate is glass. Such glass is preferably sapphire glass, soda-lime glass, alkali aluminosilicate glass, borosilicate glass, alkali-free glass, crystal glass, quartz glass, or crystallized glass, and is particularly preferably chemically strengthened soda-lime glass, chemically strengthened alkali aluminosilicate glass, or chemically bonded borosilicate glass.

In one embodiment, the article of the present disclosure may comprise a silicon oxide-comprising intermediate layer between glass and the surface-treating layer. By providing such an intermediate layer, adhesion between glass and the surface-treating layer is increased, and durability is increased.

In a preferable embodiment, the intermediate layer may comprise an alkali metal in addition to silicon oxide.

Examples of the alkali metal include lithium, sodium, and potassium. The alkali metal is preferably sodium.

The thickness of the intermediate layer is not limited, and is preferably 1 to 200 nm and particularly preferably 1 to 20 nm. By causing the thickness of the intermediate layer to be at the lower limit of the above range or greater, the effect of increasing adhesion provided by the intermediate layer is more increased.

The concentration of alkali metal atoms in the intermediate layer can be measured by various surface analysis apparatuses such as TOF-SIMS, XPS, and XRF.

The proportion of alkali metal atoms to all atoms in the entirety of the intermediate layer can be obtained by XPS depth profile analysis using ion sputtering, wherein measurement by XPS and surface etching by ion sputtering using an ion gun provided in an XPS apparatus are alternately performed.

In the intermediate layer, the average alkali metal concentration in a region having a depth of 1 nm or less from the surface that is in contact with the surface-treating layer is determined by obtaining a depth profile of the alkali metal atom concentration by TOF-SIMS (time-of-flight secondary ion mass spectrometry) depth analysis using ion sputtering, and then calculating the average alkali metal atom concentration in the profile. TOF-SIMS depth profile analysis by ion sputtering is performed by alternately repeating measurement by TOF-SIMS and surface etching by ion sputtering using an ion gun provided in a TOF-SIMS apparatus.

The article of the present disclosure can be produced by forming a layer of the surface-treating agent of the present disclosure on the surface of the substrate and post-treating this layer as necessary, thereby forming a layer from the surface-treating agent of the present disclosure.

The layer of the surface-treating agent of the present disclosure can be formed by applying the surface-treating agent to the surface of the substrate so as to coat the surface. The coating method is not limited. For example, a wet coating method and a dry coating method can be used.

Examples of the wet coating method include dip coating, spin coating, flow coating, spray coating, roll coating, gravure coating, wipe coating, squeegee coat method, die coat, inkjet, cast method, Langmuir-Blodgett method, and similar methods.

Examples of the dry coating method include deposition (usually, vacuum deposition), sputtering, CVD, and similar methods. Specific examples of the deposition method (usually, a vacuum deposition method) include resistive heating, high-frequency heating using electron beam, microwave, or the like, ion beam, and similar methods. Specific examples of the CVD method include plasma-CVD, optical CVD, thermal CVD, and similar methods.

Furthermore, coating by an atmospheric pressure plasma method can be performed.

When using the wet coating method, the surface-treating agent of the present disclosure can be applied to the substrate surface after being diluted with a solvent. From the viewpoint of the stability of the composition of the present disclosure and the volatility of the solvent, the following solvents are preferably used: aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide, N,N-dimethylacetamide, and N-methylpyrrolidone; ether alcohols such as methyl cellosolve, cellosolve, isopropyl cellosolve, butyl cellosolve, and diethylene glycol monomethyl ether; diethylene glycol monoethyl ether acetate; polyfluoroaromatic hydrocarbons (for example, 1,3-bis(trifluoromethyl)benzene); polyfluoroaliphatic hydrocarbons (for example, C₆F₁₃CH₂CH₃ (for example, ASAHIKLIN(R) AC-6000 manufactured by AGC Inc.), C₆F₁₃H (for example, ASAHIKLIN(R) AC-2000 manufactured by AGC Inc.), and 1,1,2,2,3,3,4-heptafluorocyclopentane (for example, Zeorolla(R) H manufactured by ZEON Corporation); fluorine-containing hydrocarbons such as 1,1,2-trichloro-1,2,2-trifluoroethane, 1,2-dichloro-1,1,2,2-tetrafluoroethane, 1,1-dichloro-1,2,2,3,3-pentafluoropropane (HCFC 225), and 1,3-bis(trifluoromethyl)benzene; fluorine-containing alcohols such as CF₃CH₂OH, CF₃CF₂CH₂OH, and (CF₃)₂CHOH; alkyl perfluoroalkyl ethers (the perfluoroalkyl group and the alkyl group may be linear or branched) such as hydrofluoroethers (HFE) (for example, perfluoropropyl methyl ether (C₃F₇OCH₃) (for example, Novec(TM) 7000 manufactured by SUMITOMO 3M), perfluorobutyl methyl ether (C₄F₉OCH₃) (for example, Novec(TM) 7100 manufactured by SUMITOMO 3M), perfluorobutyl ethyl ether (C₄F₉OC₂H₅) (for example, Novec(TM) 7200 manufactured by SUMITOMO 3M), and perfluorohexyl methyl ether (C₂F₅CF(OCH₃)C₃F₇) (for example, Novec(TM) 7300 manufactured by SUMITOMO 3M), or CF₃CH₂OCF₂CHF₂ (for example, ASAHIKLIN(R) AE-3000 manufactured by AGC Inc.)), hydrofluoroolefins; ethers such as CF₃CH=CHCl (for example, CELEFIN(R) 1233Z manufactured by Central Glass Co., Ltd.), CHF₂CF=CHCl (for example, AMOLEA(R) AS-300 manufactured by AGC Inc.), and cyclopentyl methyl ether; siloxanes such as hexamethyldisiloxane, hexaethyldisiloxane, octamethyltrisiloxane, octamethylcyclotetrasiloxane, octamethylcyclopentasiloxane, decamethylcyclopentasiloxane, decamethyltetrasiloxane, dodecamethylpentasiloxane, and tetradecamethylhexasiloxane; and dimethylsulfoxide. Alternatively, the solvent may be a mixed solvent of two or more of such solvents. In particular, preferable are aliphatic hydrocarbons, aromatic hydrocarbons, esters, glycol ethers, alcohols, ether alcohols, and siloxanes. For example, preferable are hexane, cyclohexane, heptane, octane, nonane, decane, undecane, dodecane, mineral spirit, benzene, toluene, xylene, naphthalene, methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl-2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, ethyl 2-hydroxyisobutyrate, propylene glycol monomethyl ether, propylene glycol monoethyl ether, propylene glycol monobutyl ether, methanol, ethanol, iso-propanol, n-butanol, isobutanol, tert-butanol, sec-butanol, diethylene glycol monomethyl ether, hexamethyldisiloxane, hexaethyldisiloxane, octamethyltrisiloxane, decamethyltetrasiloxane, dodecamethylpentasiloxane, tetradecamethylhexasiloxane, octamethylcyclotetrasiloxane, and octamethylcyclopentasiloxane.

In one embodiment, the solvent when the wet coating method is used may be, for example, a compound represented by R⁹⁰-OH. R⁹⁰ is a monovalent organic group and is preferably a C₁₋₂₀ alkyl group or a C₃₋₂₀ alkylene group, and these groups may be substituted with one or more substituents. Examples of substituents include a hydroxyl group and -OR⁹¹ wherein R⁹¹ is a C₁₋₁₀ alkyl group, and preferably a C₁₋₃ alkyl group, such as a methyl group.

When using the dry coating method, the surface-treating agent of the present disclosure may be directly subjected to the dry coating method, or may be diluted with the solvent before being subjected to the dry coating method.

A layer of the surface-treating agent is preferably formed such that the surface-treating agent of the present disclosure coexists in the layer with a catalyst for hydrolysis and dehydrative condensation. Conveniently, in the case of a wet coating method, the surface-treating agent of the present disclosure is diluted with a solvent, and then, immediately before application to the substrate surface, a catalyst may be added to the diluted solution of the surface-treating agent of the present disclosure. In the case of a dry coating method, the surface-treating agent of the present disclosure to which a catalyst has been added is directly used in a deposition (usually vacuum deposition) treatment, or a pellet-like material may be used in a deposition (usually vacuum deposition) treatment, wherein pellets are obtained by impregnating a porous body of metal such as iron or copper with the surface-treating agent of the present disclosure to which the catalyst has been added.

The catalyst may be any suitable acid or base, transition metal (such as Ti, Ni, Sn, Zr, Al, or B), sulfur-containing compound or nitrogen-containing compound having an unshared electron pair in the molecular structure (such as a sulfoxide compound, an aliphatic amine compound, an aromatic amine compound, a phosphoric acid amide compound, an amide compound, or an urea compound), or the like. The acid catalyst may be, for example, acetic acid, formic acid, trifluoroacetic acid, hydrochloric acid, nitric acid, sulfuric acid, phosphoric acid, sulfonic acid, methanesulfonic acid, or p-toluenesulfonic acid. Also, the base catalyst may be, for example, ammonia, sodium hydroxide, potassium hydroxide, or an organic amine such as triethylamine or diethylamine. Examples of the transition metal, the aliphatic amine compound, and the aromatic amine compound include those described above.

The surface-treating layer comprised in the article of the present disclosure may have high abrasion durability. Moreover, the surface-treating layer may have not only high abrasion durability but also have, depending on the composition of the surface-treating agent used, water-repellency, oil-repellency, antifouling properties (e.g., preventing grime such as fingerprints from adhering), waterproof properties (preventing water from entering electronic components and the like), surface lubricity (or lubricity, for example, such as removability by wiping of grime such as fingerprints, and excellent tactile sensations to the fingers), chemical resistance, and the like, and may be suitably used as a functional thin film.

Accordingly, the present disclosure further relates to an optical material having the surface-treating layer as the outermost layer.

The optical material preferably comprises a wide variety of optical materials, in addition to optical materials relating to displays and the like as exemplified below: for example, displays such as cathode ray tubes (CRTs; for example, PC monitors), liquid crystal displays, plasma displays, organic EL displays, inorganic thin-film EL dot matrix displays, rear projection displays, vacuum fluorescent displays (VFDs), field emission displays (FEDs); protective plates for such displays; and those obtained by performing an antireflection film treatment on their surfaces.

The article of the present disclosure may be, but is not limited to, an optical member. Examples of the optical member include lenses of glasses or the like; front surface protective plates, antireflection plates, polarizing plates, and anti-glare plates for displays such as PDPs and LCDs; touch panel sheets for equipment such as cell phones and portable information terminals; disc surfaces of optical discs such as Blu-ray(R) discs, DVD discs, CD-Rs, and MOs; optical fibers; and display surfaces of watches and clocks.

The article of the present disclosure may be medical equipment or a medical material. The article having a layer that is obtained according to the present disclosure may be an automobile interior or exterior member. Examples of the exterior material are as follows: windows, light covers, and external camera covers. Examples of the interior material are as follows: instrument panel covers, navigation system touch panels, and decorative interior materials.

The thickness of the layer is not limited. The thickness of the layer in the case of an optical member may be in the range of, for example, 1 to 50 nm, preferably 1 to 30 nm, and more preferably 1 to 15 nm, from the viewpoint of optical performance, abrasion durability, and antifouling properties.

The apparatus for performing X-ray photoelectron spectroscopy for measuring the atomic composition and the ratio of constitutional atoms of the surface-treating layer may be XPS or PHI 5000 VersaProbe II manufactured by ULVAC-PHI, Inc. Usable measurement conditions for XPS analysis may be an X-ray source of 25 W monochromatic AlKα radiation, a photoelectron detection surface of 1,400 µm × 300 µm, a photoelectron detection angle in a range of 20° to 90° (for example, 20°, 45°, 90°), a pass energy of 23.5 eV, and sputtering with a gas cluster ion beam or Ar ions. The compositions of the surface-treating layer and the intermediate layer can be determined by observing the peak areas of C1s, O1s, and Si2p under the above apparatus and measurement conditions, and calculating the atomic ratio of carbon, oxygen, and silicon.

Also, depth profile analysis may be performed as well. Usable measurement conditions for XPS analysis may be an X-ray source of 25 W monochromatic AlKα radiation, a photoelectron detection surface of 1,400 µm × 300 µm, a photoelectron detection angle in a range of 20° to 90° (for example, 20°, 45°, 90°), a pass energy of 23.5 eV, and Ar ions, gas cluster ions, C60 ions, or the like as sputtering ions. Etching may be performed to 1 to 100 nm by sputtering, and the composition in the coating film at each etching depth may be obtained as well.

By adjusting the photoelectron detection angle of the XPS analysis, the detection depth can be suitably adjusted. For example, a shallow angle close to 20 degrees allows a detection depth of about 3 nm, while a deep angle close to 90 degrees allows a detection depth of about 10 nm.

The silicon oxide-containing intermediate layer described above can be formed by applying a silicon oxide precursor to the substrate surface. When the intermediate layer comprises an alkali metal, the intermediate layer can be formed by applying a composition comprising a silicon oxide precursor and an alkali metal source to the substrate surface.

Examples of the silicon oxide precursor include silicic acid, a partial condensate of silicic acid, an alkali metal silicate, a silane compound having a hydrolyzable group that is bonded to a silicon atom, and a partially hydrolyzed condensate of such a silane compound. Silicic acid and a partial condensate thereof can be converted to silicon oxide by dehydrative condensation, and an alkali metal silicate can be converted to silicon oxide by being converted first to silicic acid or a partial condensate thereof with an acid or a cation exchange resin and then dehydratively condensing the resulting silicic acid or partial condensate thereof. Examples of the hydrolyzable group in the silane compound having a hydrolyzable group that is bonded to a silicon atom include an alkoxy group and a chlorine atom. The hydrolyzable group of the silane compound can be hydrolyzed to give a hydroxyl group, and the resulting silanol compound can be dehydratively condensed to give silicon oxide. Examples of the silane compound having a hydrolyzable group that is bonded to a silicon atom include alkoxysilanes such as tetraalkoxysilane and alkyltrialkoxysilane, and tetrachlorosilane.

The alkali metal source comprises alkali metal hydroxides, water-soluble alkali metal salts, and the like. Examples of the water-soluble alkali metal salts include alkali metal carbonates, alkali metal hydrogen carbonates, alkali metal hydrochlorides, and alkali metal nitrates. The alkali metal source is preferably an alkali metal hydroxide and an alkali metal carbonate, more preferably an alkali metal hydroxide, and even more preferably Na.

Note that the alkali metal silicate can be used as a silicon oxide precursor and an alkali metal source. The alkali metal silicate can be converted to silicon oxide via silicic acid, and in this process, a small amount of alkali metal may remain in the produced silicon oxide. Accordingly, regulating the amount of the remaining alkali metal enables silicon oxide comprising a predetermined amount of alkali metal atoms to be obtained.

The thickness of the intermediate layer is not limited, and is in the range of, for example, 1 to 50 nm, preferably 1 to 30 nm, more preferably 2 to 15 nm, and even more preferably 3 to 10 nm.

So far, the compound, the composition, and the article of the present disclosure have been described in detail. The compound, the composition, the article, and the like of the present disclosure are not limited to those exemplified above.

### Examples

The present invention will now be further specifically described by way of the following Examples, but the present invention is not limited thereto.

### (Synthetic Example 1)

Compound 1 was obtained according to the method described in Example 1 of JP 2023-25695 A.

Compound (1) (CH₃)₃Si-(OSi(CH₃)₂)₁₉-(CH₂)₁₀-CONH-CH₂C{CH₂CH₂CH₂Si(OCH₃)₃}₃

### (Synthetic Example 2)

Compound 2 was obtained according to the method described in Example 2 of JP 2023-25695 A.

Compound (2) (CH₃)₃Si-(OSi(CH₃)₂)₁₉-(CH₂)₁₀-CON{CH₂CH₂CH₂Si(OCH₃)₃}₂

### (Synthetic Example 3)

Compound 3 was obtained according to the method described in Example 4 of JP 2023-25695 A.

Compound (3) (CH₃CH₂CH₂CH₂Si(CH₃)₂(OSi(CH₃)₂)₅₇-(CH₂)₃-OCH₂-CONH- CH₂C{CH₂CH₂CH₂Si(OCH₃)₃}₃

### (Synthetic Example 4)

Compound 4 was obtained according to the method described in Example 6 of JP 2023-25695 A.

Compound (4) (CH₃CH₂CH₂CH₂Si(CH₃)₂(OSi(CH₃)₂)₅₇- CH₂CH₂Si(CH₂CH₂CH₂Si(OCH₃)₃)₃

### (Synthetic Example 5)

Compound 5 was obtained according to the method described in Example 10 of JP 2023-25695 A.

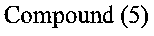

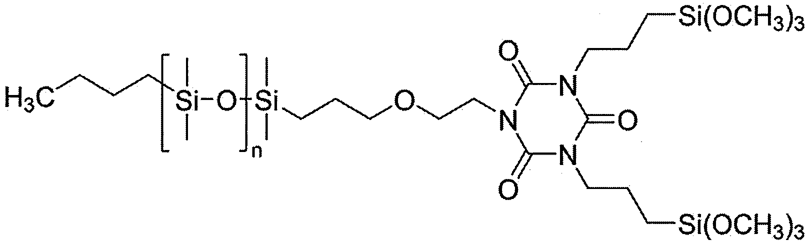

The average number n of repeating units is 78.

### (Synthetic Example 6)

Compound 6 was obtained according to the method described in Synthetic Example 2 of JP 2023-159887 A. The average number n of repeating units is 78.

Compound (6) CH₃CH₂CH₂CH₂(Si(CH₃)₂CH₂CH₂CH₂)ₙSi(CH₃)₂CH₂CH₂CH₂Si(CH₂CH₂CH ₂Si(OCH₃)₃)₃

### (Synthetic Example 7)

First, 5.0 g of CH₃CH₂CH₂CH₂Si(CH₃)₂O(Si(CH₃)₂O)ₙSi(CH₃)₂CH₂CH₂CH₂OCH₂COOH, 92 mg of 2-propen-1-amine, 31 mg of 1-(3-dimethylaminopropyl)-3-ethylcarbodiimide hydrochloride, 13 mg of 4-dimethylaminopyridine, and 20 mL of dichloromethane were mixed, and the mixture was stirred at room temperature for 16 hours. The reaction solution was washed with hydrochloric acid and water, and then concentrated under reduced pressure to give 5.28 g of compound (7) CH₃CH₂CH₂CH₂Si(CH₃)₂O(Si(CH₃)₂O)ₙSi(CH₃)₂CH₂CH₂CH₂OCH₂CONHCH₂CH= CH₂ (n ≈ 59).

¹H-NMR (400 MHz, CHLOROFORM-D) δ [ppm] 6.59-6.71 (br), 5.80-5.91 (m), 5.12-5.24 (m), 3.91-3.97 (m), 3.45-3.50 (t), 1.58-1.69 (m), 1.24-1.36 (m), 0.86-0.91 (t), 0.51-0.58 (m), -0.10-0.30 (m)

### (Synthetic Example 8)

First, 2.0 g of compound (7), 10 mL of toluene, 47 µL of a xylene solution comprising a 2% Pt complex of 1,3-divinyl-1,1,3,3-tetramethyldisiloxane, and 113 µL of aniline were each added, then 210 µL of trimethoxysilane was added, and the mixture was stirred at 40°C for 3 hours. Thereafter, the mixture was purified to give 1.74 g of compound (8) CH₃CH₂CH₂CH₂Si(CH₃)₂O(Si(CH₃)₂O)ₙSi(CH₃)₂CH₂CH₂CH₂OCH₂CONHCH₂CH₂ CH₂Si(OCH₃)₃ (n ≈ 59).

¹H-NMR (400 MHz, CHLOROFORM-D) δ [ppm] 6.62-6.70 (br), 3.92 (s), 3.53-3.62 (m), 3.43-3.49 (t), 3.27-3.33 (q), 1.58-1.72 (m), 1.24-1.35 (m), 0.85-0.92 (t), 0.63-0.69 (t), 0.50-0.57 (m), -0.13-0.32 (m)

### (Synthetic Example 9)

First, 0.50 g of methyl tricosenoate, 10.0 mL of toluene, 0.05 mL of pyridine, and 0.3 mL of a xylene solution comprising a 2% Pt complex of 1,3-divinyl-1,1,3,3-tetramethyldisiloxane were each added, and then 1.2 mL of 1,1,1,3,5,5,5-heptamethyltrisiloxane was added dropwise. After being stirred at room temperature for 17 hours, the mixture was purified to give 0.87 g of compound (9).

¹H NMR (CDCl₃, 400 MHz) δ [ppm]: 0.033-0.241 (m), 0.438-0.550 (m), 1.191-1.413 (m), 1.607-1.642 (m), 2.242-2.325 (m), 3.669 (s)

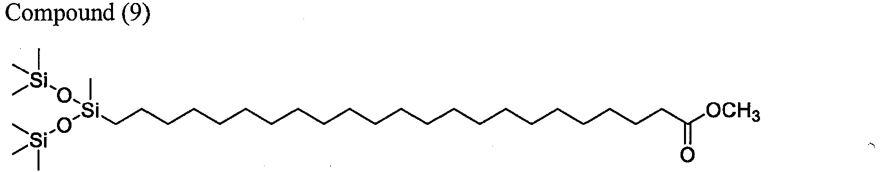

### (Synthetic Example 10)

First, 0.86 g of compound (9), 5.0 mL of allylamine, and 0.20 g of 1,5,7-triazabicyclo[4.4.0]deca-5-ene were each added, and then the mixture was stirred at 75°C for 3 hours. Thereafter, the mixture was washed with an aqueous hydrochloric acid solution, dehydrated over magnesium sulfate, and concentrated under reduced pressure to give 0.72 g of compound (10).

¹H NMR (CDCl₃, 400 MHz) δ [ppm]: 0.076-0.128 (m), 0.413-0.465 (t), 1.183-1.1.404 (m), 1.604-1.677 (m), 2.173-2.248 (t), 3.841-3.942 (m), 5.122-5.210 (m), 5.809-5.877 (m)

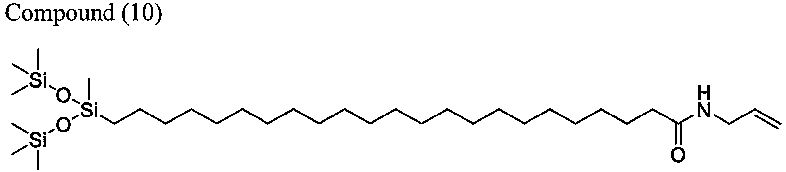

### (Synthetic Example 11)

First, 0.72 g of compound (10), 6.0 mL of toluene, 0.04 mL of pyridine, and 0.26 mL of a xylene solution comprising a 2% Pt complex of 1,3-divinyl-1,1,3,3-tetramethyldisiloxane were each added, then 1.4 mL of trimethoxysilane was added, and the mixture was stirred at room temperature for 16 hours. Thereafter, the mixture was purified to give 0.48 g of compound (11).

¹H NMR (CDCl₃, 400 MHz) δ [ppm]: 0.054-0.149 (m), 0.425-0.464 (t), 0.628-0.681 (m), 1.181-1.402 (m), 1.544-1.768 (m), 2.125-2.164 (t), 3.558-3.646 (m)

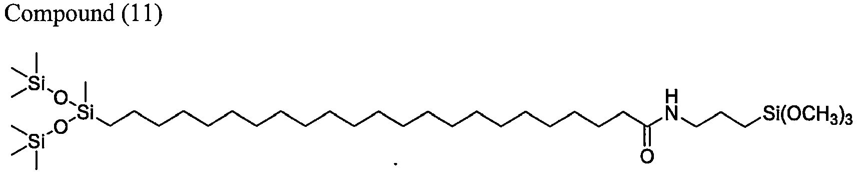

### (Synthetic Example 12)

First, 1.25 g of methyl tricosenoate, 20.0 mL of toluene, 0.1 mL of pyridine, and 0.65 mL of a xylene solution comprising a 2% Pt complex of 1,3-divinyl-1,1,3,3-tetramethyldisiloxane were each added, and then 1.01 g of tris(trimethylsilyloxy)silane was added dropwise. After being stirred at room temperature for 16 hours, the mixture was purified to give 1.36 g of compound (12).

¹H NMR (CDCl₃, 400 MHz) δ [ppm]: 0.013-0.142 (m), 0.408 (t), 1.137-1.378 (m), 1.591 (quin), 2.275 (t), 3.639 (s)

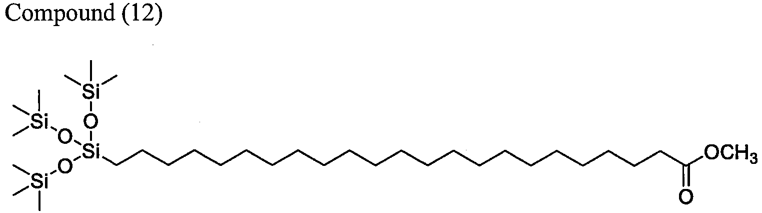

### (Synthetic Example 13)

First, 0.64 g of compound (12), 2.8 mL of allylamine, and 0.12 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 0.68 g of compound (13).

¹H NMR (CDCl₃, 400 MHz) δ [ppm]: 0.011-0.217 (m), 0.407 (t), 1.153-1.378 (m), 1.612 (quin), 2.163 (t), 3.865 (tt), 5.090-5.1.82 (m), 5.409 (br), 5.770-5.866 (m)

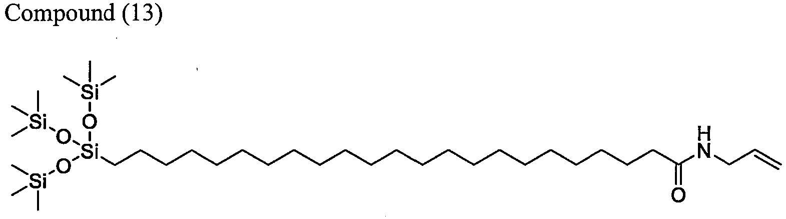

### (Synthetic Example 14)

First, 0.56 g of compound (13), 10.0 mL of toluene, 0.022 mL of aniline, and 0.46 mL of a xylene solution comprising a 2% Pt complex of 1,3-divinyl-1,1,3,3-tetramethyldisiloxane were each added, then 0.2 mL of trimethoxysilane was added, and the mixture was stirred at 45°C for 2 hours. Thereafter, the mixture was purified to give 0.57 g of compound (14).

¹H NMR (CDCl₃, 400 MHz) δ [ppm]: 0.010-0.141 (m), 0.408 (t), 0.629 (t), 1.150-1.376 (m), 1.519-1.652 (m), 2.121 (t), 3.172 (q), 3.516-3.589 (m), 5.607 (br)

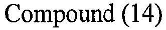

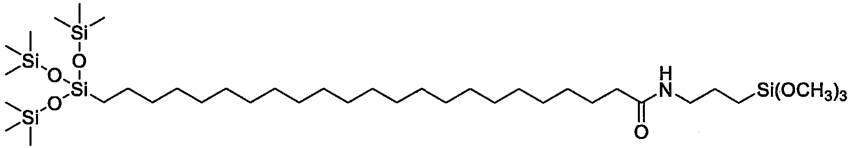

### (Synthetic Example 15)

First, 1.04 g of methyl tricosenoate, 15 mL of toluene, 0.08 mL of pyridine, and 0.6 mL of a xylene solution comprising a 2% Pt complex of 1,3-divinyl-1,1,3,3-tetramethyldisiloxane were each added, and then 4.0 g of MCR-H1 1 manufactured by Gelest, Inc. was added dropwise. After being stirred at room temperature for 2 days, the mixture was purified to give 4.36 g of compound (15) CH₃CH₂CH₂CH₂Si(CH₃)₂O(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂COOCH₃. The average number n of repeating units is 13.

¹H NMR (CDCl₃, 400 MHz) δ [ppm]: 0.019-0.115 (m), 0.490-0.530 (m), 0.858 (t), 1.200-1.378 (m), 1.592 (quin), 2.276-2.293 (m), 3.640 (s)

### (Synthetic Example 16)

First, 4.36 g of compound (15), 10 mL of allylamine, and 0.37 g of 1,5,7-triazabicyclo[4.4.0]deca-5-ene were each added, and then the mixture was stirred at 75°C for 3 hours. Thereafter, the mixture was washed with an aqueous hydrochloric acid solution, dehydrated over magnesium sulfate, and concentrated under reduced pressure to give 3.55 g of compound (16) CH₃CH₂CH₂CH₂Si(CH₃)₂O(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH=CH₂. The average number n of repeating units is 13.

¹H NMR (CDCl₃, 400 MHz) δ [ppm]: 0.018-0.131 (m), 0.490-0.528 (t), 0.858 (t), 1.182-1.377 (m), 1.613 (quin), 2.162 (t), 3.852-3.880 (m), 5.093-5.175 (m), 5.401 (br), 5.770-5.868 (m)

### (Synthetic Example 17)

First, 3.55 g of compound (16), 15 mL of toluene, 0.08 mL of pyridine, and 0.6 mL of a xylene solution comprising a 2% Pt complex of 1,3-divinyl-1,1,3,3-tetramethyldisiloxane were each added, then 3.0 mL of trimethoxysilane was added, and the mixture was stirred at room temperature for 16 hours. Thereafter, the mixture was purified to give 3.43 g of compound (17) CH₃CH₂CH₂CH₂Si(CH₃)₂O(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH₂CH₂Si(O CH₃)₃. The average number n of repeating units is 13.

¹H NMR (CDCl₃, 400 MHz) δ [ppm]: 0.019-0.100 (m), 0.491-0.531 (m), 0.626 (t), 0.859 (t), 1.184-1.327 (m), 1.578-1.653 (m), 2.122 (t), 3.225 (q), 3.520-3.626 (m), 5.600 (br)

### (Synthetic Example 18)

First, 1.8 g of compound (9) obtained in Synthetic Example 9, 2.01 mL of 2-allylpent-4-en-1-amine, and 0.43 g of 1,5,7-triazabicyclo[4.4.0]deca-5-ene were each added, and then the mixture was stirred at 75°C for 3 hours. Thereafter, the mixture was washed with an aqueous hydrochloric acid solution, dehydrated over magnesium sulfate, and concentrated under reduced pressure to give 1.92 g of compound (18).

¹H NMR (CDCl₃, 400 MHz) δ [ppm]: 0.076-0.128 (m), 0.413-0.465 (t), 1.183-1.1.404 (m), 1.604-1.677 (m), 1.704-1.769 (m), 1.994-2.093 (m), 2.103-2.285 (m), 3.161-3.328 (t), 4.997-5.195 (m), 5.397-5.595 (s), 5.708-5.975 (m)

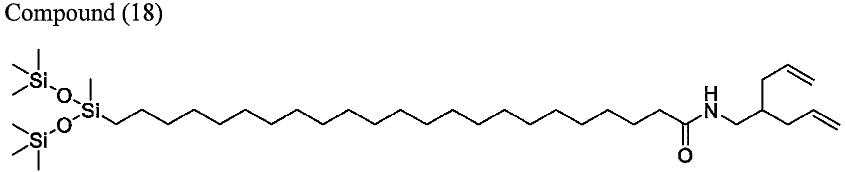

### (Synthetic Example 19)

First, 0.47 g of compound (18), 3.5 mL of toluene, 0.014 mL of pyridine, and 0.1 mL of a xylene solution comprising a 2% Pt complex of 1,3-divinyl-1,1,3,3-tetramethyldisiloxane were each added, then 0.52 mL of trimethoxysilane was added, and the mixture was stirred at room temperature for 3 hours. Thereafter, the mixture was purified to give 0.48 g of compound (19).

¹H NMR (CDCl₃, 400 MHz) δ [ppm]: 0.054-0.149 (m), 0.425-0.464 (t), 0.628-0.681 (t), 1.181-1.402 (m), 1.544-1.768 (m), 2.125-2.164 (t), 3.135-3.203 (t), 3.558-3.646 (m), 5.449-5.528 (s)

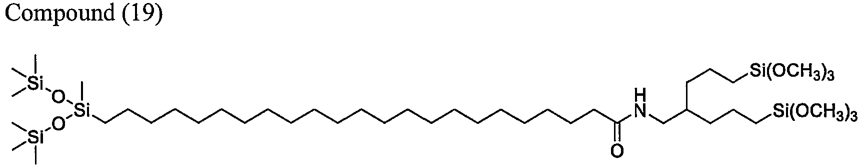

### (Synthetic Example 20)

First, 2.22 g of compound (9) obtained in Synthetic Example 9, 12.8 ml of toluene, 0.54 g of 1,5,7-triazabicyclo[4.4.0] deca-5-ene, and 0.66 ml of diallylamine were each added, and the mixture was stirred at 70°C for 2 hours. Thereafter, the mixture was purified to give 2.12 g of compound (20).

1H NMR (CDCl3, 400 MHz) δ [ppm]: -0.011 (s), 0.081 (s), 0.424-0.462 (t), 1.250 (brs), 1.600-1.672 (m), 2.281-2.319 (t), 3.862-3.873 (d), 3.976-3.990 (d), 5.088-5.210 (m), 5.710-5.806 (m)

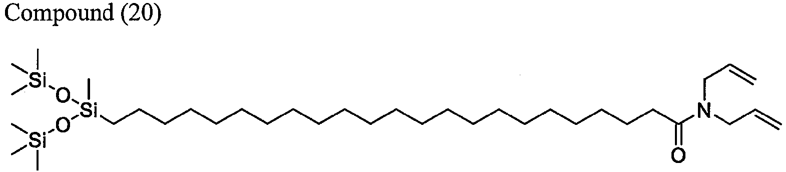

### (Synthetic Example 21)

First, 1.10 g of compound (21), 6.5 ml of toluene, 0.01 g of triacetoxymethylsilane, and 0.15 ml of a xylene solution comprising a 2% Pt complex of 1,3-divinyl-1,1,3,3-tetramethyldisiloxane were each added, then 0.64 mL of trimethoxysilane was added, and the mixture was heated to 40°C and stirred for 3 hours. Thereafter, the mixture was purified to give 1.15 g of compound (21).

1H NMR (CDCl3, 400 MHz) δ [ppm]: -0.014 (s), 0.077 (s), 0.420-0.458 (t), 0.558-0.610 (t), 1.247 (br s), 1.601-1.661 (m), 2.256-2.293 (t), 3.181-3.221 (t), 3.262-3.300 (t), 3.555 (s), 3.574 (s)

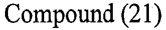

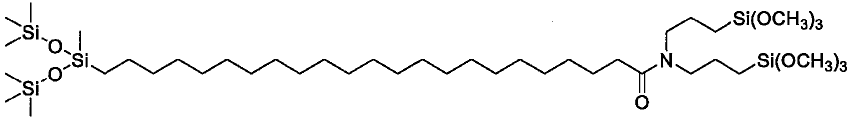

### (Synthetic Example 22)

First, 2.11 g of 22-tricosenoic acid CH₂=CH(CH₂)₂₀COOH, 95 ml of toluene, and 1.26 g of 1,1'-carbonyldiimidazole were each added, and the mixture was stirred at room temperature for 1 hour. Thereafter, the mixture was purified to give 2.22 g of compound (22) CH₂=CH(CH₂)₂₀CO(C₃H₄N₂).

¹H NMR (CDCl₃, 400 MHz) δ [ppm]: 1.250 (s), 1.333-1.426 (m), 1.761-1.836 (m), 2.007-2.061 (dd), 2.837-2.875 (t), 4.909-5.016 (m), 5.761-5.863 (m), 7.104 (s), 7.481 (s), 8.174 (s)

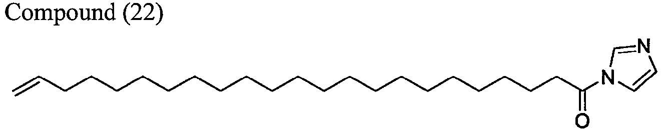

### (Synthetic Example 23)

First, 1.01 g of amide compound (22), 6.6 ml of toluene, 0.02 g of triacetoxymethylsilane, 0.11 ml of a xylene solution comprising a 2% Pt complex of 1,3-divinyl-1,1,3,3-tetramethyldisiloxane, and 6.6 ml of 1,1,1,3,5,5,5-heptamethyltrisiloxane were each added, and the mixture was stirred at room temperature for 3 hours. Thereafter, the mixture was purified to give 1.33 g of compound (23).

¹H NMR (CDCl₃, 400 MHz) δ [ppm]: -0.011 (s), 0.081 (s), 0.422-0.459 (dd), 1.250 (s), 1.370-1.426 (m), 1.761-1.836 (m), 2.836-2.873 (t), 7.102 (s), 7.480 (s), 8.167 (s)

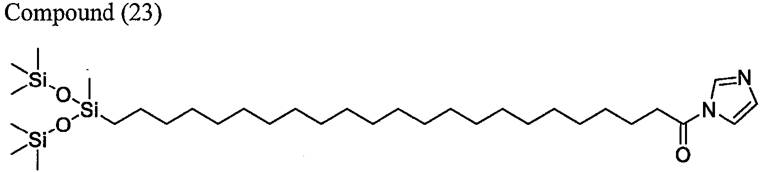

### (Synthetic Example 24)

First, 1.75 g of compound (23) and 10 ml of toluene were added, the mixture was stirred, 0.82 ml of 2,2-diallylpent-4-en-1-amine was added dropwise thereto, and the mixture was stirred at room temperature for 16 hours. Thereafter, the mixture was purified to give 1.2 g of compound (24).

¹H NMR (CDCl₃, 400 MHz) δ [ppm]: -0.069-0.133 (m), 0.422-0.461 (t), 1.248-1.427 (m), 1.569-1.650 (m), 2.020-2.039 (d), 2.139-2.177 (t), 3.186-3.201 (d), 5.068-5.114 (m), 5.520-5.580 (m), 5.810-5.916 (m),

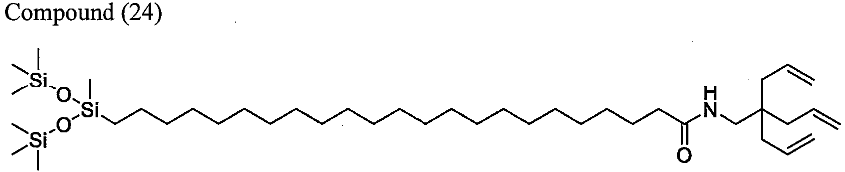

### (Synthetic Example 25)

First, 1.2 g of compound (24), 5 ml of toluene, 0.05 ml of a xylene solution comprising a 2% Pt complex of 1,3-divinyl-1,1,3,3-tetramethyldisiloxane, and 0.04 ml of aniline were added and stirred, 1.3 ml of trimethoxysilane was added dropwise, and then the mixture was heated to 60°C and stirred for 16 hours. Thereafter, volatile components were distilled off under reduced pressure, and the mixture was purified to give 1.8 g of compound (25).

¹H NMR (CDCl₃, 400 MHz) δ [ppm]: -0.075-0.128 (m), 0.417-0.455 (t), 0.575-0.613 (t), 1.092-1.394 (m), 1.583-1.634 (m), 2.107-2.170 (t), 3.092-3.108 (d), 3.472-3.611 (m), 5.696-5.726 (m)

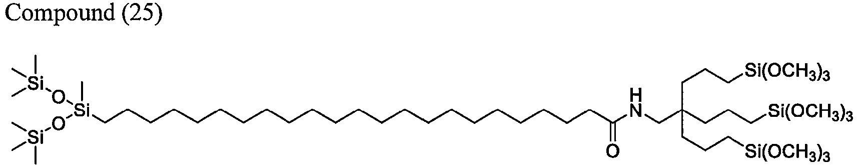

### (Synthetic Example 26)

First, 2.4 g of magnesium and 260 ml of tetrahydrofuran were added, a solution in which 25.1 g of 11-bromo-1-undecene was dissolved in 62 ml of tetrahydrofuran was added dropwise, and the mixture was stirred at 35 to 38°C for 1 hour to prepare a Grignard reagent (B). Subsequently, 29.1 g of 4-bromobenzyl bromide and 10 ml of tetrahydrofuran were stirred at -52°C, the Grignard reagent (B) obtained above and 10 ml of dilithium tetrachlorocopper(II) (about 2.5% tetrahydrofuran solution) were sequentially added dropwise, and the mixture was stirred for 16 hours with the temperature being gradually raised. Thereafter, the mixture was cooled to 5°C, an aqueous ammonium chloride solution was added to quench the reaction, tetrahydrofuran was distilled off by an evaporator, and then ethyl acetate and brine were added for separation. Magnesium sulfate was added to the resulting ethyl acetate layer to perform drying, and the mixture was concentrated by an evaporator and then purified by silica gel chromatography to give 7.9 g of compound (26).

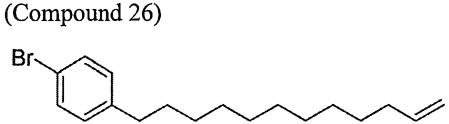

1H-NMR (400 MHz, CHLOROFORM-D) δ 7.37 (d, J = 20.1 Hz, 2H), 7.04 (d, 2H), 5.87-5.76 (m, 1H), 5.05-4.91 (m, 2H), 2.60-2.48 (m, 2H), 2.07-2.01 (m, 2H), 1.64-1.49 (m, 2H), 1.43-1.16 (m, 14H)

### (Synthetic Example 27)

First, 1.5 g of compound (26) 1-bromo-4-(4-dodecen-1-yl)benzene and 16 mL of tetrahydrofuran were added, then 2.9 mL of a hexane solution comprising 15% n-butyllithium was added dropwise at -78°C, and the mixture was stirred at -78°C for 1 hour. Thereafter, 21 mL of a tetrahydrofuran solution comprising 4.6 g of hexamethylcyclotrisiloxane was added dropwise, and the mixture was stirred at room temperature for 4 hours. Thereafter, 1.8 mL of chlorotrimethylsilane was added dropwise, and the mixture was stirred at room temperature for 16 hours. Thereafter, water and toluene were added to remove the aqueous layer, then the toluene layer was washed twice with water, and the toluene layer was concentrated to give 5.1 g of compound (27). The average number of repeating units is 14.

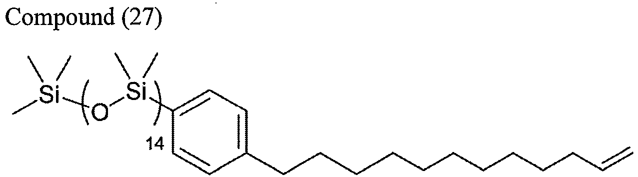

1H-NMR (400 MHz, CHLOROFORM-D) δ 7.50 (d, J = 7.8 Hz, 2H), 7.19 (d, J = 7.8 Hz, 2H), 5.87-5.79 (m, 1H), 5.04-4.94 (m, 2H), 2.62 (t, J = 7.8 Hz, 2H), 2.06 (q, J = 7.0 Hz, 2H), 1.65-1.60 (m, 2H), 1.42-1.30 (m, 14H), 0.36 (s, 6H), 0.27--0.04 (m)

### (Synthetic Example 28)

First, 2.0 g of compound (27), 6.0 mL of toluene, 17 µL of pyridine, and 117 µL of a xylene solution comprising a 2% Pt complex of 1,3-divinyl-1,1,3,3-tetramethyldisiloxane were each added, then 0.59 mL of trimethoxysilane was added, and the mixture was stirred at room temperature for 3 hours. Thereafter, the mixture was concentrated under reduced pressure to give 1.9 g of compound (28). The average number of repeating units is 14.

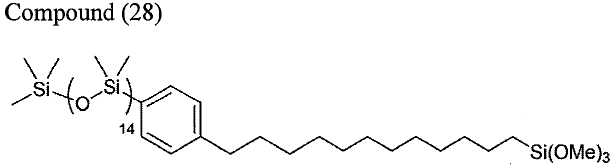

1H-NMR (400 MHz, CHLOROFORM-D) δ 7.48 (d, J = 7.8 Hz, 2H), 7.18 (d, J = 7.3 Hz, 2H), 3.65-3.54 (m, 9H), 2.60 (t, J = 7.8 Hz, 2H), 1.65-1.58 (m, 2H), 1.44-1.27 (m, 18H), 0.68-0.62 (m, 2H), 0.34 (s, 6H), 0.25--0.09 (m)

### (Synthetic Example 29)

First, 10.02 g of 1,1,1,3,5,5,5-heptamethyltrisiloxane, 89.66 g of dichloromethane, and 11.49 g of trichloroisocyanuric acid were each added, and the mixture was heated to 40°C and stirred for 1 hour. Thereafter, the mixture was distilled and purified to give 7.55 g of compound (29).

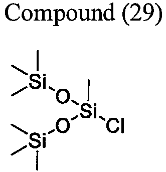

¹H NMR (CDCl₃, 400 MHz) δ [ppm]: 0.157 (br s), 0.376 (br s), ²⁹Si NMR (CDCl₃, 400 MHz) δ [ppm]: -44.484 (s), 11.683 (s)

### (Synthetic Example 30)

First, 0.6 g of compound (26) and 6.5 mL of tetrahydrofuran were added, then 1.16 mL of a hexane solution comprising 15% n-butyllithium was added dropwise at -78°C, and the mixture was stirred at -78°C for 1 hour. Thereafter, 6.5 mL of a tetrahydrofuran solution comprising 1.57 g of hexamethylcyclotrisiloxane was added dropwise, and the mixture was stirred at room temperature for 4 hours. Thereafter, 0.95 mg of compound (29) was added dropwise under ice-cooling, and the mixture was stirred at room temperature for 16 hours. Thereafter, the reaction solution was concentrated and the concentrated solution was washed with acetonitrile to give 1.70 g of compound (30). The average number of repeating units is 14.3.

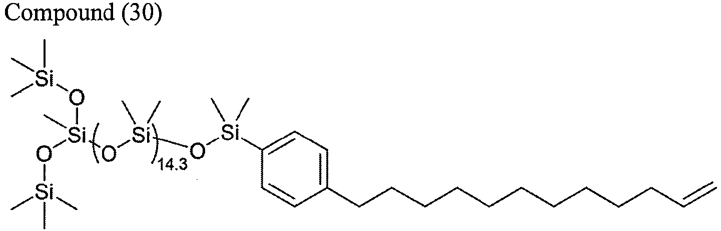

1H-NMR (400 MHz, CHLOROFORM-D) δ 7.46 (d, J = 7.8 Hz, 2H), 7.16 (d, J = 7.8 Hz, 2H), 5.84-5.77 (m, 1H), 5.01-4.90 (m, 2H), 2.60-2.56 (m, 2H), 2.05-2.00 (m, 2H), 1.61-1.26 (m, 18H), 0.31 (s, 6H), 0.14-0.03 (m), 0.02-0.00 (m, 3H)

### (Synthetic Example 31)

First, 1.0 g of compound (30), 7.0 mL of toluene, 8.2 µL of pyridine, and 58 µL of a xylene solution comprising a 2% Pt complex of 1,3-divinyl-1,1,3,3-tetramethyldisiloxane were each added, then 0.29 mL of trimethoxysilane was added, and the mixture was stirred at room temperature for 3 hours. Thereafter, the mixture was purified to give 1.52 g of compound (31). The average number of repeating units is 14.3.

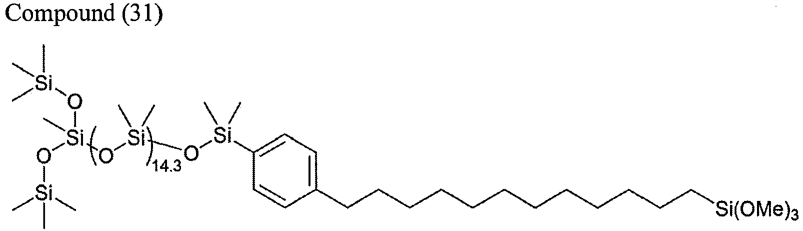

1H-NMR (400 MHz, CHLOROFORM-D) δ 7.46 (d, J = 7.8 Hz, 2H), 7.16 (d, J = 7.8 Hz, 2H), 3.59-3.53 (m, 9H), 2.58 (t, J = 8.0 Hz, 2H), 1.60-1.53 (m, 2H), 1.40-1.24 (m, 18H), 0.65-0.61 (m, 2H), 0.31 (s, 6H), 0.14-0.02 (m), 0.01 (s, 3H)

### (Synthetic Example 32)

First, 10.00 g of tris(trimethylsilyloxy)silane, 67.25 g of dichloromethane, and 8.62 g of trichloroisocyanuric acid were each added, and the mixture was heated to 40°C and stirred for 1 hour. Thereafter, the mixture was purified to give 8.51 g of compound (32).

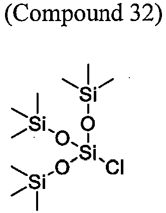

¹H NMR (CDCl₃, 400 MHz) δ [ppm]: 0.165 (br s), ²⁹Si NMR (CDCl₃, 400 MHz) δ [ppm]: -91.102 (s), 12.274 (s)

### (Synthetic Example 33)

First, 0.6 g of compound (26) and 6.5 mL of tetrahydrofuran were added, then 1.16 mL of a hexane solution comprising 15% n-butyllithium was added dropwise at -78°C, and the mixture was stirred at -78°C for 1 hour. Thereafter, 6.5 mL of a tetrahydrofuran solution comprising 1.57 g of hexamethylcyclotrisiloxane was added dropwise, and the mixture was stirred at room temperature for 4 hours. Thereafter, 0.95 mg of compound (32) was added dropwise under ice-cooling, and the mixture was stirred at room temperature for 16 hours. Thereafter, the reaction solution was concentrated and the concentrated solution was washed with acetonitrile to give 1.24 g of compound (33). The average number of repeating units is 18.5.

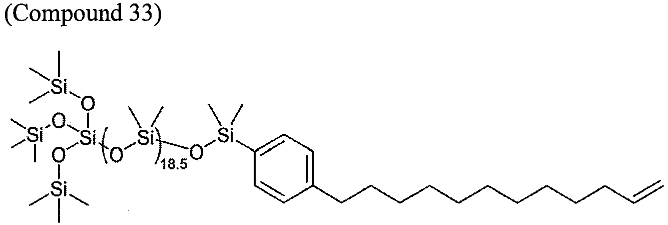

1H-NMR (400 MHz, CHLOROFORM-D) δ 7.46 (d, J = 7.8 Hz, 2H), 7.16 (d, J = 7.8 Hz, 2H), 5.84-5.77 (m, 1H), 5.00-4.90 (m, 2H), 2.58 (t, J = 7.8 Hz, 2H), 2.05-2.00 (m, 2H), 1.61-1.25 (m, 18H), 0.31 (s, 6H), 0.16-0.02 (m)

### (Synthetic Example 34)

First, 1.0 g of compound (33), 8.0 mL of toluene, 7.8 µL of pyridine, and 55 µL of a xylene solution comprising a 2% Pt complex of 1,3-divinyl-1,1,3,3-tetramethyldisiloxane were each added, then 0.28 mL of trimethoxysilane was added, and the mixture was stirred at room temperature for 3 hours. Thereafter, the mixture was purified to give 0.88 g of compound (34). The average number of repeating units is 18.5.

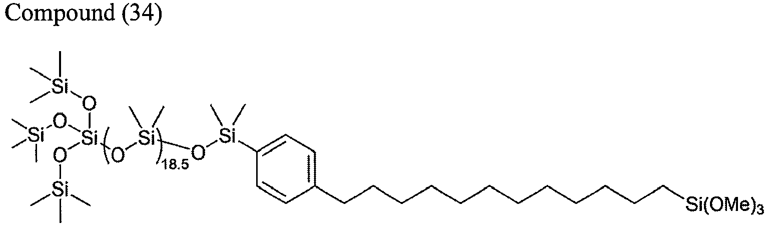

1H-NMR (400 MHz, CHLOROFORM-D) δ 7.46 (d, J = 8.2 Hz, 2H), 7.16 (d, J = 7.8 Hz, 2H), 3.60-3.54 (m, 9H), 2.58 (t, J = 7.8 Hz, 2H), 1.61-1.24 (m, 18H), 0.65-0.61 (m, 2H), 0.31 (s, 6H), 0.14-0.01 (m)

### (Synthetic Example 35)

First, 1.0 g of compound (26) and 10.0 mL of tetrahydrofuran were added, then 1.95 mL of a hexane solution comprising 15% n-butyllithium was added dropwise at -78°C, and the mixture was stirred at -78°C for 1 hour. Thereafter, 0.80 g of compound (29) was added dropwise under ice-cooling, and the mixture was stirred at room temperature for 2 hours. Thereafter, water and toluene were added to remove the aqueous layer, then the toluene layer was washed with water, and the toluene layer was concentrated to give 1.34 g of compound (35).

¹H NMR (400 MHz, CHLOROFORM-D) δ 7.46 (d, J = 7.8 Hz, 2H), 7.17 (d, J = 7.8 Hz, 2H), 5.85-5.78 (m, 1H), 5.02-4.92 (m, 2H), 2.61-2.57 (m, 2H), 2.07-2.02 (m, 2H), 1.63-1.55 (m, 2H), 1.44-1.27 (m, 14H), 0.26-0.25 (m, 3H), 0.14-0.03 (m, 18H)

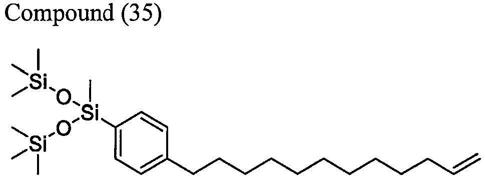

### (Synthetic Example 36)

First, 1.0 g of compound (35), 7.0 mL of toluene, 23 µL of pyridine, and 164 µL of a xylene solution comprising a 2% Pt complex of 1,3-divinyl-1,1,3,3-tetramethyldisiloxane were each added, then 0.82 mL of trimethoxysilane was added, and the mixture was stirred at room temperature for 3 hours. Thereafter, the mixture was purified to give 1.1 g of compound (36).

¹H NMR (400 MHz, CHLOROFORM-D) δ 7.44 (d, J = 7.8 Hz, 2H), 7.16 (d, J = 7.8 Hz, 2H), 3.60-3.56 (m, 9H), 2.60-2.56 (m, 2H), 1.61-1.55 (m, 2H), 1.42-1.24 (m, 18H), 0.66-0.62 (m, 2H), 0.25-0.24 (m, 3H), 0.10-0.04 (m, 18H)

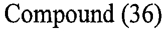

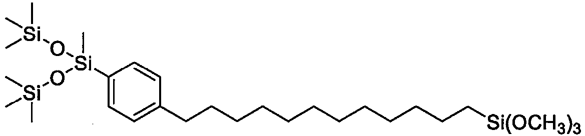

### (Synthetic Example 37)

First, 1.0 g of compound (26) and 10.0 mL of tetrahydrofuran were added, then 1.95 mL of a hexane solution comprising 15% n-butyllithium was added dropwise at -78°C, and the mixture was stirred at -78°C for 1 hour. Thereafter, 1.03 g of compound (30) was added dropwise under ice-cooling, and the mixture was stirred at room temperature for 2 hours. Thereafter, water and toluene were added to remove the aqueous layer, then the toluene layer was washed with water, and the toluene layer was concentrated to give 1.42 g of compound (37).

¹H NMR (400 MHz, CHLOROFORM-D) δ 7.44 (d, 2H), 7.15 (d, 2H), 5.84-5.77 (m, 1H), 5.01-4.90 (m, 2H), 2.61-2.56 (m, 2H), 2.06-2.00 (m, 2H), 1.62-1.53 (m, 2H), 1.43-1.26 (m, 14H), 0.16-0.05 (m, 27H)

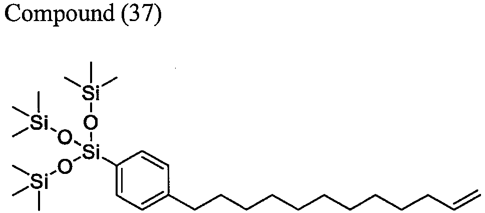

### (Synthetic Example 38)

First, 1.0 g of compound (37), 7.0 ml of toluene, 20 µL of pyridine, and 141 µL of a xylene solution comprising a 2% Pt complex of 1,3-divinyl-1,1,3,3-tetramethyldisiloxane were each added, then 0.70 mL of trimethoxysilane was added, and the mixture was stirred at room temperature for 3 hours. Thereafter, the mixture was purified to give 1.2 g of compound (38).

¹H NMR (400 MHz, CHLOROFORM-D) δ 7.44 (d, 2H), 7.16 (d, 2H), 3.61-3.55 (m, 9H), 2.61-2.57 (m, 2H), 1.62-1.52 (m, 2H), 1.43-1.25 (m, 14H), 0.67-0.63 (m, 2H), 0.15-0.05 (m, 27H)

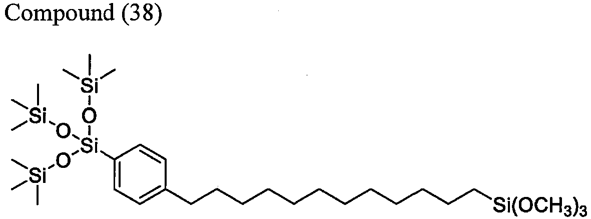

### (Synthetic Example 39)

First, 2.00 g of [(CH₃)₃SiO]₂CH₃SiO(Si(CH₃)₂O)ₙSi(CH₃)₂CH₂CH₂CH₂CH₂CH₂CH₂CH₂CH₂CH₂C H₂CH₂CH₂CH₂CH₂CH₂CH₂CH₂CH₂CH₂CH₂CH₂CH₂CONHCH₂CH(CH₂CH=CH₂)₂ (n≈26), 10 ml of toluene, 0.05 ml of a xylene solution comprising a 2% Pt complex of 1,3-divinyl-1,1,3,3-tetramethyldisiloxane, and 0.01 ml of aniline were added, the mixture was stirred, 0.24 ml of trimethoxysilane was added dropwise at room temperature, and then the mixture was heated to 45°C and stirred for 2 hours. Thereafter, volatile components were distilled off under reduced pressure, and the mixture was purified to give 2.0 g of compound (39): [(CH₃)₃SiO]₂CH₃SiO(Si(CH₃)₂O)ₙSi(CH₃)₂CH₂CH₂CH₂CH₂CH₂CH₂CH₂CH₂CH₂C H₂CH₂CH₂CH₂CH₂CH₂CH₂CH₂CH₂CH₂CH₂CH₂CH₂CONHCH₂CH[CH₂CH₂CH₂Si (OCH₃)₃]₂ (n≈26).

¹H-NMR (CDCl₃, 400MHz) δ [ppm]: -0.089-0.207 (m), 0.492-0.531 (m), 0.595-0.635 (t), 1.200-1.308 (m), 1.378-1.681 (m), 2.123-2.160 (t), 3.157-3.187 (t), 3.517-3.592 (m), 3.494-3.602 (m), 5.465-5.492 (m)

### (Synthetic Example 40)

First, 4.03 g of 22-tricosenoic acid perfluorophenol and 5.0 ml of THF were each added and stirred, 1.30 ml of dimethylchlorosilane and 0.080 ml of a xylene solution comprising a 2% Pt complex of 1,3-divinyl-1,1,3,3-tetramethyldisiloxane were added at room temperature, and the mixture was stirred at room temperature for 16 hours. Thereafter, volatile components were distilled off under reduced pressure, and the mixture was purified to give 4.6 g of compound (40-1), chlorodimethylsilyltricosenoic acid ester.

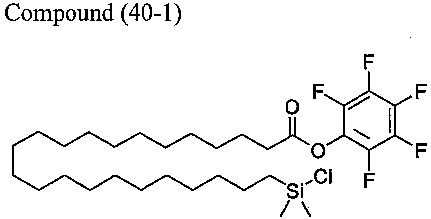

In another reactor, 1.33 g of hexamethyldisiloxane and 10 ml of THF were each added and stirred, and 2.57 ml of a hexane solution of 15% n-butyllithium was added in a warm-water bath at 30°C. After cooling in an ice bath, 17.79 g of hexamethylcyclotrisiloxane and 20 ml of THF were added in the form of a solution, and furthermore stirred for 8 hours. While being cooled in an ice bath, 2.3 g of compound (40-1) chlorodimethylsilyltricosenoic acid ester synthesized above and 10 ml of THF were added in the form of a solution, the solution was stirred for 1 hour, furthermore 1.50 g of 2-allylpent-4-ene-1-amine was added, and the mixture was stirred for 16 hours with being placed in an ice bath. Thereafter, the reaction solution was partially purified to give 2.8 g of compound (40-2) CH₃[Si(CH₃)₂O]ₙSi(CH₃)₂(CH₂)₂₂CONH-CH₂CH[CH₂CH=CH₂]₂. The average number n is 57.

¹H NMR (CDCl₃, 400 MHz) δ [ppm]: -0.089 - 0.211 (m), 0.494 - 0.533 (t), 1.242 - 1.335 (m), 1.586 - 1.623 (m), 1.692 - 1.758 (m), 2.000 - 2.160 (m), 3.193 - 3.224 (t), 5.023 - 5.077 (m), 5.455 (br), 5.728 - 5.832 (m)

### (Synthetic Example 41)

First, 2.74 g of compound (40-2), 5.5 mL of toluene, 14 µL of pyridine, and 70 µL of a xylene solution comprising a 2% Pt complex of 1,3-divinyl-1,1,3,3-tetramethyldisiloxane were each added, then 0.29 mL of trimethoxysilane was added, and the mixture was stirred at room temperature for 16 hours. Thereafter, the mixture was purified to give 2.63 g of compound (41) CH₃[Si(CH₃)₂O]ₙSi(CH₃)₂(CH₂)₂₂CONH-CH₂CH[CH₂CH₂CH₂Si(OCH₃)₃]₂. The average number of repeating units of dimethylsiloxane is 57.

¹H NMR (CDCl₃, 400 MHz) δ [ppm]: -0.104-0.196 (m), 0.498 (t), 0.604 (t), 1.226-1.339 (m), 1.404 (quin), 1.568-1.664 (m), 2.130 (t), 3.160 (t), 3.496-3.584 (m), 5.471 (br)

### (Synthetic Example 42)

First, 2.11 g of 22-tricosenoic acid, 95 ml of toluene, and 1.26 g of 1,1'-carbonyldiimidazole were each added, and the mixture was stirred at room temperature for 1 hour. Thereafter, the mixture was purified to give 2.22 g of compound (42) CH₂=CH(CH₂)₂₀CO(C₃H₄N₂).

¹H NMR (CDCl₃, 400 MHz) δ [ppm]: 1.250 (s), 1.333-1.426 (m), 1.761-1.836 (m), 2.007-2.061 (dd), 2.837-2.875 (t), 4.909-5.016 (m), 5.761-5.863 (m), 7.104 (s), 7.481 (s), 8.174 (s)

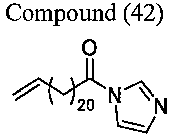

### (Synthetic Example 43)

First, 1.38 g of compound (42) CH₂=CH(CH₂)₂₀CO(C₃H₄N₂), 24.9 g of toluene, and 6.12 g of CH₃[Si(CH₃)₂O]ₙSi(CH₃)₂H were each added, then 0.56 ml of a xylene solution comprising a 2% Pt complex of 1,3-divinyl-1,1,3,3-tetramethyldisiloxane was added, and the mixture was heated to 60°C and stirred for 12 hours. Thereafter, the mixture was purified to give 6.86 g of compound (43) CH₃[Si(CH₃)₂O]ₙSi(CH₃)₂(CH₂)₂₂CO(C₃H₄N₂). The average number n is 26.

¹H NMR (CDCl₃, 400 MHz) δ [ppm]: -0.076-0.223 (m), 0.505-0.543 (t), 1.253 (br s), 1.767-1.841 (m), 2.857-2.894 (t), 7.124 (s), 7.497 (s), 8.273 (s)

### (Synthetic Example 44)

First, 6.86 g of compound (43) CH₃[Si(CH₃)₂O]ₙSi(CH₃)₂(CH₂)₂₂CO(C₃H₄N₂), 6.86 g of heptane, and 1.48 g of bis[3-(trimethoxysilyl)propyl]amine were each added, and the mixture was stirred at 60°C for 3 hours. Thereafter, the mixture was purified to give 6.71 g of compound (44) CH₃[Si(CH₃)₂O]ₙSi(CH₃)₂(CH₂)₂₂CON[CH₂CH₂CH₂Si(OCH₃)₃]₂. The average number n is 26.

¹H NMR (CDCl₃, 400 MHz) δ [ppm]: -0.109-0.216 (m), 0.499-0.537 (t), 0.559-0.612 (m), 1.245 (br s), 1.570-1.630 (m), 2.256-2.295 (t), 3.182-3.221 (t), 3.264-3.301 (t), 3.556 (br s), 3.575 (br s)

### (Synthetic Example 45)

Compound (45) CH₃(Si(CH₃)₂O)ₙSi(CH₃)₂(CH₂)₂₂CON[CH₂CH₂CH₂Si(OCH₃)₃]₂ was obtained in the same manner as in Synthetic Examples 43 to 44 except that the raw material was changed to use CH₃(Si(CH₃)₂O)ₙSi(CH₃)₂H. The average number n is 34.

¹H NMR (CDCl₃, 400 MHz) δ [ppm]: -0.109-0.216 (m), 0.499-0.537 (t), 0.559-0.612 (m), 1.245 (br s), 1.570-1.630 (m), 2.256-2.295 (t), 3.182-3.221 (t), 3.264-3.301 (t), 3.556 (br s), 3.575 (br s)

### (Synthetic Example 46)

Compound (46) CH₃(Si(CH₃)₂O)₄₈Si(CH₃)₂(CH₂)₂₂ON((CH₂)₃Si(OCH₃)₃)₂ was obtained in the same manner as in Synthetic Examples 43 to 44 except that the raw material was changed to use CH₃(Si(CH₃)₂O)₄₈Si(CH₃)₂H. The average number n is 48.

### <Preparation of surface-treating agent>

The compound as the component (A), the compound comprising a transition metal atom, as the component (B), and the solvent were combined as shown in Table 1 below to prepare a surface-treating agent. The total concentration of the components (A) and (B) relative to the solvent was 20 wt%.
Each surface-treating agent comprises a trace of xylene, besides the component (A), the component (B), and the solvent, because of use of a xylene solution of a 2% platinum(0)-1,3-divinyl-1,1,3,3-tetramethyldisiloxane complex manufactured by Sigma Aldrich, as the Karstedt's catalyst. In order to sufficiently admix the components (A) and (B), the mixture was stirred at room temperature for 30 minutes and was allowed to stand still for 12 hours.

**[Table 1]**

| Surface-treating agent name | Component (A) | Component (B) | Content of component (B) based on 100 of component (A) | Solvent |
|---|---|---|---|---|
| | Compound No. | Compound containing transition metal | mol% | |
| Surface-treating agent 1 | Compound 1 | Karstedt's catalyst | 0.1 | Hexamethyldisiloxane |
| Surface-treating agent 2 | Compound 2 | Karstedt's catalyst | 0.1 | Hexamethyldisiloxane |
| Surface-treating agent 3 | Compound 3 | Karstedt's catalyst | 0.01 | Hexamethyldisiloxane |
| Surface-treating agent 4 | Compound 3 | Karstedt's catalyst | 0.1 | Hexamethyldisiloxane |
| Surface-treating agent 5 | Compound 3 | Karstedt's catalyst | 1 | Hexamethyldisiloxane |
| Surface-treating agent 6 | Compound 3 | Karstedt's catalyst | 4 | Hexamethyldisiloxane |
| Surface-treating agent 7 | Compound 4 | Karstedt's catalyst | 0.1 | Hexamethyldisiloxane |
| Surface-treating agent 8 | Compound 5 | Karstedt's catalyst | 0.1 | Hexamethyldisiloxane |
| Surface-treating agent 9 | Compound 6 | Karstedt's catalyst | 0.1 | Hexamethyldisiloxane |
| Surface-treating agent 10 | Compound 11 | Karstedt's catalyst | 0.01 | Hexamethyldisiloxane |
| Surface-treating agent 11 | Compound 11 | Karstedt's catalyst | 0.1 | Hexamethyldisiloxane |
| Surface-treating agent 12 | Compound 11 | Karstedt's catalyst | 1 | Hexamethyldisiloxane |
| Surface-treating agent 13 | Compound 11 | Karstedt's catalyst | 4 | Heptane |
| Surface-treating agent 14 | Compound 14 | Karstedt's catalyst | 0.01 | Heptane |
| Surface-treating agent 15 | Compound 14 | Karstedt's catalyst | 0.1 | Heptane |
| Surface-treating agent 16 | Compound 14 | Karstedt's catalyst | 1 | Heptane |
| Surface-treating agent 17 | Compound 14 | Karstedt's catalyst | 4 | Heptane |
| Surface-treating agent 18 | Compound 17 | Karstedt's catalyst | 0.1 | Heptane |
| Surface-treating agent 19 | Compound 19 | Karstedt's catalyst | 0.1 | Heptane |
| Surface-treating agent 20 | Compound 21 | Karstedt's catalyst | 0.1 | Heptane |
| Surface-treating agent 21 | Compound 25 | Karstedt's catalyst | 0.1 | Heptane |
| Surface-treating agent 22 | Compound 28 | Karstedt's catalyst | 0.1 | Heptane |
| Surface-treating agent 23 | Compound 31 | Karstedt's catalyst | 0.01 | Heptane |
| Surface-treating agent 24 | Compound 31 | Karstedt's catalyst | 0.1 | Heptane |
| Surface-treating agent 25 | Compound 31 | Karstedt's catalyst | 1 | Heptane |
| Surface-treating agent 26 | Compound 31 | Karstedt's catalyst | 4 | Heptane |
| Surface-treating agent 27 | Compound 34 | Karstedt's catalyst | 0.1 | Heptane |
| Surface-treating agent 28 | Compound 36 | Karstedt's catalyst | 0.1 | Heptane |
| Surface-treating agent 29 | Compound 38 | Karstedt's catalyst | 0.1 | Heptane |
| Surface-treating agent 30 | Compound 41 | Karstedt's catalyst | 0.1 | Heptane |
| Surface-treating agent 31 | Compound 3 | - | - | Hexamethyldisiloxane |
| Surface-treating agent 32 | Compound 11 | - | - | Hexamethyldisiloxane |
| Surface-treating agent 33 | Compound 14 | - | - | Heptane |
| Surface-treating agent 34 | Compound 17 | - | - | Heptane |
| Surface-treating agent 35 | Compound 31 | - | - | Heptane |
| Surface-treating agent 36 | Compound 34 | - | - | Heptane |
| Surface-treating agent 37 | Compound 39 | Karstedt's catalyst | 0.1 | Heptane |
| Surface-treating agent 38 | Compound 41 | Karstedt's catalyst | 0.1 | Heptane |
| Surface-treating agent 39 | Compound 45 | Karstedt's catalyst | 0.1 | Heptane |
| Surface-treating agent 40 | Compound 46 | Karstedt's catalyst | 0.1 | Heptane |

### <Na-containing intermediate layer forming material>

First, 2.2 g of sodium hydroxide (manufactured by FUJIFILM Wako Pure Chemical Corporation) was dissolved in 24 g of distilled water to give a 8.4% by mass aqueous sodium hydroxide solution. Then, 24 g of this 8.4% by mass aqueous sodium hydroxide solution and 20 g of MS gel (M.S. GEL D-100-60A (manufactured by AGC Si-Tech Co., Ltd.)) were mixed so that the aqueous sodium hydroxide solution was absorbed into the MS gel. The MS gel that had absorbed the aqueous sodium hydroxide solution was dried at 25°C for 8 hours, then molded with a tableting machine (4 MPa for 1 minute), and fired at 1,000°C for 1 hour to give a formed article 1 (pellets).

### <Formation of surface-treating layer>

### (SiO₂ intermediate layer)

The surface-treating agents prepared above were vacuum-deposited onto chemically tempered glass (Gorilla Glass, manufactured by Corning Incorporated, thickness 0.7 mm). Specifically, a molybdenum boat in a vacuum deposition system was filled with 0.1 g of a surface-treating agent, and the vacuum deposition system was evacuated to a pressure of 3.0 × 10⁻³ Pa or lower. Thereafter, a silicon dioxide film having a thickness of 7 nm was formed, followed by heating the boat by the resistance heating scheme to form a surface-treating layer. Thereafter, heat treatment was performed in an oven at 150°C for 2 hours to give a surface-treating layer.

### (Na-containing SiO₂ intermediate layer)

The surface-treating agents prepared above were vacuum-deposited onto chemically tempered glass (Gorilla Glass, manufactured by Corning Incorporated, thickness 0.7 mm). Specifically, a molybdenum boat in a vacuum deposition system was filled with 0.1 g of a surface-treating agent, and the vacuum deposition system was evacuated to a pressure of 3.0 × 10⁻³ Pa or lower. Thereafter, vapor deposition by the electron beam deposition scheme was performed using the formed article 1 to form a Na-containing silicon dioxide film having a thickness of 7 nm, followed by heating the boat by the resistance heating scheme to form a surface-treating layer. Thereafter, heat treatment was performed in an oven at 150°C for 2 hours to give a surface-treating layer.

### <Evaluation>

### [Abrasion resistance evaluation]

### (Abrasion method)

A friction block as described below was brought into contact with the formed surface-treating layer, a 5 N load was applied thereto, and the friction block was moved back and forth at a speed of 40 mm/sec, with the load being applied. The water static contact angle (°) was measured before the abrasion test and at the time point of 100 times of abrasion.

### - Friction block

The surfaces of an article obtained by processing silicone rubber as described below were covered with cotton soaked with artificial sweat having the following composition, and the article was used as a friction block.

Composition of artificial sweat:
Anhydrous disodium hydrogen phosphate: 2 g
Sodium chloride: 20 g
85% Lactic acid: 2 g
Histidine hydrochloride: 5 g
Distilled water: 1 kg
Article obtained by processing silicone rubber:
Obtained by processing Silicone Rubber Stopper SR-51 manufactured by Tigers Polymer Corporation into a cylinder having a diameter of 1 cm and a thickness of 1 cm.

### (Contact angle measurement)

For contact angle measurement, a fully automatic contact angle meter DropMaster 700 (manufactured by Kyowa Interface Science Co., Ltd.) was used under an environment of 25°C. Specifically, the substrate having the measurement target, i.e., the surface-treating layer, was placed horizontally, 2 µL of water was dripped from a microsyringe onto the surface, and a static image was taken with a video microscope one second after the dropwise addition to thereby measure the static contact angle. The static contact angle was measured at five different points on the surface-treating layer of the substrate, and the average value calculated therefrom was used.

The determination criteria of water contact angle measurement are shown below.

### (Before abrasion test)

103° or more: Good (circle)
less than 103°: Poor (cross mark)

### (After abrasion test)

90° or more: Excellent (double circle)
75° or more and less than 90°: Good (circle)
60° or more and less than 75°: Fair (triangle)
less than 60°: Poor (cross mark)

The results of abrasion resistance evaluation are shown in Table 2 and Table 3 below.

**[Table 2]**

| Example / Comparative Example No. | Surface-treating agent No. | Intermediate layer | Before abrasion test | Before abrasion test |
|---|---|---|---|---|
| Example 1 | Surface-treating agent 1 | Na-containing silicon dioxide film | Good | Fair |
| Example 2 | Surface-treating agent 2 | Na-containing silicon dioxide film | Good | Fair |
| Example 3 | Surface-treating agent 3 | Na-containing silicon dioxide film | Good | Good |
| Example 4 | Surface-treating agent 4 | Na-containing silicon dioxide film | Good | Fair |
| Example 5 | Surface-treating agent 5 | Na-containing silicon dioxide film | Good | Fair |
| Example 6 | Surface-treating agent 6 | Na-containing silicon dioxide film | Poor | Good |
| Example 7 | Surface-treating agent 7 | Na-containing silicon dioxide film | Good | Fair |
| Example 8 | Surface-treating agent 8 | Na-containing silicon dioxide film | Good | Fair |
| Example 9 | Surface-treating agent 9 | Na-containing silicon dioxide film | Good | Fair |
| Example 14 | Surface-treating agent 10 | Na-containing silicon dioxide film | Good | Good |
| Example 15 | Surface-treating agent 11 | Na-containing silicon dioxide film | Good | Fair |
| Example 16 | Surface-treating agent 12 | Na-containing silicon dioxide film | Good | Fair |
| Example 17 | Surface-treating agent 13 | Na-containing silicon dioxide film | Poor | Good |
| Example 18 | Surface-treating agent 14 | Na-containing silicon dioxide film | Good | Good |
| Example 19 | Surface-treating agent 15 | Na-containing silicon dioxide film | Good | Good |
| Example 20 | Surface-treating agent 16 | Na-containing silicon dioxide film | Good | Good |
| Example 21 | Surface-treating agent 17 | Na-containing silicon dioxide film | Poor | Good |
| Example 22 | Surface-treating agent 18 | Na-containing silicon dioxide film | Good | Fair |
| Example 23 | Surface-treating agent 19 | Na-containing silicon dioxide film | Good | Good |
| Example 24 | Surface-treating agent 20 | Na-containing silicon dioxide film | Good | Good |
| Example 25 | Surface-treating agent 21 | Na-containing silicon dioxide film | Good | Good |
| Example 26 | Surface-treating agent 22 | Na-containing silicon dioxide film | Good | Good |
| Example 27 | Surface-treating agent 23 | Na-containing silicon dioxide film | Good | Excellent |
| Example 28 | Surface-treating agent 24 | Na-containing silicon dioxide film | Good | Excellent |
| Example 29 | Surface-treating agent 25 | Na-containing silicon dioxide film | Good | Excellent |
| Example 30 | Surface-treating agent 26 | Na-containing silicon dioxide film | Poor | Excellent |
| Example 31 | Surface-treating agent 27 | Na-containing silicon dioxide film | Good | Good |
| Example 32 | Surface-treating agent 28 | Na-containing silicon dioxide film | Good | Good |
| Example 33 | Surface-treating agent 29 | Na-containing silicon dioxide film | Good | Good |
| Example 34 | Surface-treating agent 30 | Na-containing silicon dioxide film | Good | Good |
| Comparative Example 1 | Surface-treating agent 31 | Na-containing silicon dioxide film | Good | Poor |
| Comparative Example 2 | Surface-treating agent 32 | Na-containing silicon dioxide film | Good | Poor |
| Comparative Example 3 | Surface-treating agent 33 | Na-containing silicon dioxide film | Good | Fair |
| Comparative Example 4 | Surface-treating agent 34 | Na-containing silicon dioxide film | Good | Poor |
| Comparative Example 5 | Surface-treating agent 35 | Na-containing silicon dioxide film | Good | Good |
| Comparative Example 6 | Surface-treating agent 36 | Na-containing silicon dioxide film | Good | Fair |

**[Table 3]**

| Example / Comparative Example No. | Surface-treating agent No. | Intermediate layer | Before abrasion test | Before abrasion test |
|---|---|---|---|---|
| Example 35 | Surface-treating agent 1 | Silicon dioxide film | Good | Fair |
| Example 36 | Surface-treating agent 2 | Silicon dioxide film | Good | Fair |
| Example 37 | Surface-treating agent 3 | Silicon dioxide film | Good | Good |
| Example 38 | Surface-treating agent 4 | Silicon dioxide film | Good | Fair |
| Example 39 | Surface-treating agent 5 | Silicon dioxide film | Good | Fair |
| Example 40 | Surface-treating agent 6 | Silicon dioxide film | Poor | Good |
| Example 41 | Surface-treating agent 7 | Silicon dioxide film | Good | Fair |
| Example 42 | Surface-treating agent 8 | Silicon dioxide film | Good | Fair |
| Example 43 | Surface-treating agent 9 | Silicon dioxide film | Good | Fair |
| Example 44 | Surface-treating agent 10 | Silicon dioxide film | Good | Good |
| Example 45 | Surface-treating agent 11 | Silicon dioxide film | Good | Fair |
| Example 46 | Surface-treating agent 12 | Silicon dioxide film | Good | Fair |
| Example 47 | Surface-treating agent 13 | Silicon dioxide film | Poor | Good |
| Example 48 | Surface-treating agent 14 | Silicon dioxide film | Good | Good |
| Example 49 | Surface-treating agent 15 | Silicon dioxide film | Good | Good |
| Example 50 | Surface-treating agent 16 | Silicon dioxide film | Good | Good |
| Example 51 | Surface-treating agent 17 | Silicon dioxide film | Poor | Good |
| Example 52 | Surface-treating agent 18 | Silicon dioxide film | Good | Fair |
| Example 53 | Surface-treating agent 19 | Silicon dioxide film | Good | Good |
| Example 54 | Surface-treating agent 20 | Silicon dioxide film | Good | Good |
| Example 55 | Surface-treating agent 21 | Silicon dioxide film | Good | Good |
| Example 56 | Surface-treating agent 22 | Silicon dioxide film | Good | Good |
| Example 57 | Surface-treating agent 23 | Silicon dioxide film | Good | Excellent |
| Example 58 | Surface-treating agent 24 | Silicon dioxide film | Good | Excellent |
| Example 59 | Surface-treating agent 25 | Silicon dioxide film | Good | Excellent |
| Example 60 | Surface-treating agent 26 | Silicon dioxide film | Poor | Excellent |
| Example 61 | Surface-treating agent 27 | Silicon dioxide film | Good | Good |
| Example 62 | Surface-treating agent 28 | Silicon dioxide film | Good | Good |
| Example 63 | Surface-treating agent 29 | Silicon dioxide film | Good | Good |
| Example 64 | Surface-treating agent 30 | Silicon dioxide film | Good | Good |
| Comparative Example 7 | Surface-treating agent 31 | Silicon dioxide film | Good | Poor |
| Comparative Example 8 | Surface-treating agent 32 | Silicon dioxide film | Good | Poor |
| Comparative Example 9 | Surface-treating agent 33 | Silicon dioxide film | Good | Fair |
| Comparative Example 10 | Surface-treating agent 34 | Silicon dioxide film | Good | Poor |
| Comparative Example 11 | Surface-treating agent 35 | Silicon dioxide film | Good | Good |
| Comparative Example 12 | Surface-treating agent 36 | Silicon dioxide film | Good | Fair |
| Example 65 | Surface-treating agent 37 | Na-containing silicon dioxide film | Excellent | Good |
| Example 66 | Surface-treating agent 38 | Na-containing silicon dioxide film | Excellent | Good |
| Example 67 | Surface-treating agent 39 | Na-containing silicon dioxide film | Excellent | Good |
| Example 68 | Surface-treating agent 40 | Na-containing silicon dioxide film | Excellent | Good |
| Example 69 | Surface-treating agent 37 | Silicon dioxide film | Good | Good |
| Example 70 | Surface-treating agent 38 | Silicon dioxide film | Good | Good |
| Example 71 | Surface-treating agent 39 | Silicon dioxide film | Good | Good |
| Example 72 | Surface-treating agent 40 | Silicon dioxide film | Good | Good |

The composition of the present disclosure can allow a surface-treating layer favorable in abrasion durability to be formed. Therefore, the composition of the present disclosure can be suitably utilized in a variety of applications.

## Claims

1. A composition comprising a silane compound and a transition metal, wherein
the silane compound comprises one, or two or more of compounds selected from the following formula (1) or (2):
R^{A1}_{α}-X^{A}-R^{Si}_{β} (1)
R^{Si}_{γ}-X^{A}-R^{A2}-X^{A}-R^{Si}_{γ} (2)
wherein
R^{A1} represents a monovalent group comprising one or more Si atoms to which neither a hydroxyl group nor a hydrolyzable group is directly bonded, or a hydrocarbon group,
R^{A2} each independently represents a divalent group comprising one or more Si atoms to which neither a hydroxyl group nor a hydrolyzable group is directly bonded,
R^{Si} represents a monovalent group comprising a Si atom to which a hydroxyl group or a hydrolyzable group is bonded,
X^{A} represents a single bond, or a di- to decavalent group,
α represents an integer of 1 to 9,
β represents an integer of 1 to 9, and
γ represents an integer of 1 to 9; and
a content of the transition metal is 0.001 mol or more and 2.00 mol or less based on 100 mol of the silane compound.

2. The composition according to claim 1, wherein the silane compound comprises a compound in which R^{A1} is a group represented by the following formula (A1), (A2), (A3), (A4), (A5) or (A6):
R^{1a}-R^{S}-SiR^{2a}₂- (A1)
R^{3a}-X^{1a}- (A2)
R^{7a}-[(SiR^{8a}₂O)ₙ-SiR^{8a}₂]ₙₐ- (A3)
R^{11a}-(R^{S})_{γ1}-(SiR^{12a}₂)_{γ2}-R^{Ar}- (A4)
R^{13a}-(SiR^{14a}₂O)ₙ-SiR^{14a}₂- (A5)
R^{17a}-R^{S}-(SiR^{18a}₂)ₛ- (A6)
wherein, in the formula (A1),
R^{1a} represents a hydrocarbon group,
R^{2a} represents a hydrocarbon group,
R^{S} is each independently a group represented by the following formula: 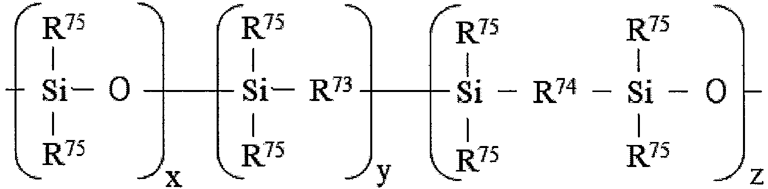 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁶ is each independently a C₁₋₆ alkylene group,
R⁷⁷ is each independently an optionally substituted arylene group,
R⁷⁸ is each independently a single bond or a C₁₋₆ alkylene group,
R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula);
in the formula (A2),
R^{3a} represents R^{4a}-O-CO-, R^{4a}-CO-O-, R^{4a}-O-C(=O)-O-, R^{4a}-NR-CO-, R^{4a}-CO-NR-, R^{4a}-OCO-NR^{5a}-, R^{4a}-NR^{5a}-COO-, R^{4a}-NR^{5a}-CO-NR^{5a}-, CH₂=CH-, NHR^{5a}-, CR^{5a}₃-, CHR^{6a}- or a halogen atom,
R^{4a} represents a hydrogen atom, a C₁₋₆ alkyl group, or an oxyalkylene-containing group having 1 to 30 carbon atoms,
R^{5a} represents a hydrogen atom or a C₁₋₆ alkyl group,
R^{6a} represents a halogen atom, and
X^{1a} represents an alkylene group having 12 or more carbon atoms;
in the formula (A3),
R^{7a} each independently represents a C₁₋₁₂ alkyl group, or the following group A or group B,
the group A and the group B are each a group represented by the following formula:
R⁵¹ₙₐR⁵²₃₋ₙₐSi-(O)_{z}- (A) 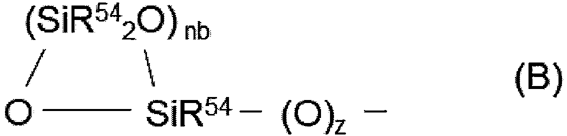
wherein
R⁵¹ is each independently a group represented by -(R⁶¹-SiR⁵³₂)ₘₐ-R⁵³,
R⁶¹ is each independently an oxygen atom or a C₁₋₆ alkylene group,
R⁵³ is each independently a hydrocarbon group or R^{51'},
R^{51'} has the same meaning as R⁵¹,
ma is each independently an integer of 1 to 5,
provided that the number of R^{51'} in R⁵¹ is 20 or less,
R⁵² is each independently a hydrocarbon group,
na is an integer of 1 to 3,
R⁵⁴ is each independently a hydrocarbon group,
nb is an integer of 1 to 5, and
z is 0 or 1;
R^{8a} is each independently a C₁₋₁₂ alkyl group,
n is 1 to 1,500, and
na is each independently 0 or 1;
in the formula (A4),
R^{11a} represents a monovalent group comprising one or more Si atoms to which neither a hydroxyl group nor a hydrolyzable group is directly bonded, or a hydrocarbon group,
R^{S} has the same meaning as above,
R^{12a} represents a hydrocarbon group,
R^{Ar} represents a divalent aromatic hydrocarbon group,
γ1 is 0 or 1, and
γ2 is 0 or 1;
in the formula (A5),
R^{13a} represents a C₁₋₁₂ alkyl group,
R^{14a} each independently represents a C₁₋₁₂ alkyl group, and
n is an integer of 1 to 1,500; and
in the formula (A6),
R^{17a} is a hydrocarbon group, or R^{18a}ₙₐ₁R^{19a}₃₋ₙₐ₁Si-(O)_{z}-,
R^{18a} is a group represented by R^{21a}-(SiR^{21a}₂-R^{20a})ₘₐ₁-,
R^{20a} is an oxygen atom, or a C₁₋₆ alkylene group,
R^{21a} is a hydrocarbon group or R^{18a'},
R^{18a'} has the same meaning as R^{18a},
mal is each independently an integer of 1 to 5,
provided that the number of R^{18a'} in R^{18a} is 20 or less,
R^{19a} is each independently a hydrocarbon group,
nal is an integer of 1 to 3,
z is 0 or 1,
s is 0 or 1, and
R^{S} has the same meaning as above.

3. The composition according to claim 1 or 2, wherein the silane compound comprises a compound in which R^{A1} is an alkyl group having 7 or more carbon atoms.

4. The composition according to any one of claims 1 to 3, wherein
X^{A} is a di- to decavalent group comprising a partial structure selected from a single bond, a C₁₋₆₀ alkylene group, -CO-, -COO-, -OCO-, -NR⁴¹-, -CONR⁴¹-, - NR⁴¹CO-, -OCONR⁴¹-, -NR⁴¹COO-, -NR⁴¹-CO-NR⁴¹-, -O-, -S-, -CON= or R^{S},
R⁴¹ is a hydrogen atom, an oxyalkylene-containing group or a C₁₋₆ alkyl group, and
R^{S} is a group represented by the following formula: 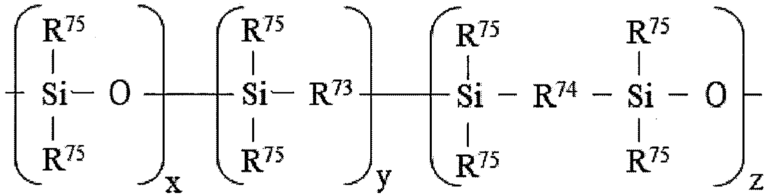 wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁶ is each independently a C₁₋₆ alkylene group,
R⁷⁷ is each independently an optionally substituted arylene group,
R⁷⁸ is each independently a single bond or a C₁₋₆ alkylene group,
R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula.

5. The composition according to any one of claims 1 to 4, wherein X^{A} is a group represented by the following formula:
-(X¹²¹)ₐ₀-X¹¹⁰-[(X¹¹¹)ₐ₁-(X¹¹²)ₐ₂]-
wherein
X¹²¹ is -R¹⁶¹_{b1}R⁶²_{3-b1}C-, -R¹⁶³_{b2}R¹⁶⁴_{3-b2}Si-, or -R¹⁶⁵N-,
R¹⁶¹ is each independently a single bond or a divalent organic group,
R¹⁶² is a hydrogen atom, or a monovalent organic group,
R¹⁶³ is each independently a single bond or a divalent organic group,
R¹⁶⁴ is a hydrogen atom, or a monovalent organic group,
R¹⁶⁵ is each independently a single bond or a divalent organic group,
b1 is 2 or 3,
b2 is 2 or 3,
X¹¹⁰ is a single bond or an alkylene group having 1 or more carbon atoms,
X¹¹¹ is a single bond or a divalent organic group,
X¹¹² is -CO-, -COO-, -OCO-, -NR⁴¹-, -CONR⁴¹-, -NR⁴¹CO-, -OCONR⁴¹-, - NR⁴¹COO-, -NR⁴¹-CO-NR⁴¹-, -O-, -S-, -CON= or R^{S},
R⁴¹ is a hydrogen atom, an oxyalkylene-containing group or a C₁₋₆ alkyl group,
R^{S} is a group represented by the following formula: 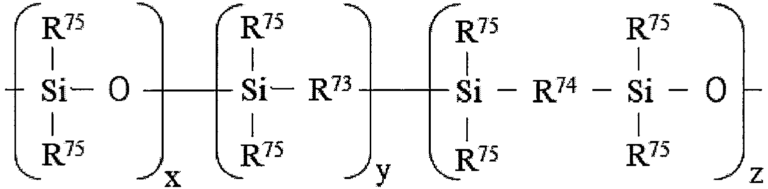 (wherein
R⁷³ is each independently a single bond, a C₁₋₁₂ alkylene group, -R⁷⁶-O-R⁷⁶-, - R⁷⁸-R⁷⁷-R⁷⁸-, -R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁴ is each independently a C₁₋₁₂ alkylene group, -R⁷⁶-O-R⁷⁶-, -R⁷⁸-R⁷⁷-R⁷⁸-, - R⁷⁸-R⁷⁷-R⁷⁹-R⁷⁷-R⁷⁸-, -R⁷⁸-R⁷⁷-R⁷⁹-R⁷⁶-R⁷⁹-R⁷⁷-R⁷⁸-, or -R⁷⁹-R⁷⁶-R⁷⁹-R⁷⁷-R⁷⁹-R⁷⁶-R⁷⁹-,
R⁷⁶ is each independently a C₁₋₆ alkylene group,
R⁷⁷ is each independently an optionally substituted arylene group,
R⁷⁸ is each independently a single bond or a C₁₋₆ alkylene group,
R⁷⁹ is each independently a single bond or an oxygen atom,
R⁷⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula),
a0 is 0 or 1,
al is an integer of 1 to 5,
a2 is an integer of 0 to 5, and
the occurrence order of the respective repeating units enclosed in parentheses provided with al or a2 is not limited in the formula; or
a group represented by formula (X^{A1}): 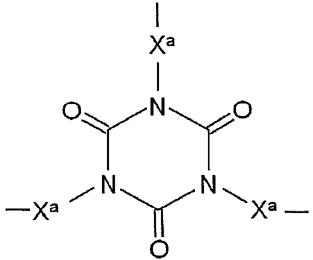 wherein X^{a} is each independently a single bond or a divalent linking group.

6. The composition according to any one of claims 1 to 5, wherein R^{Si} is a group represented by the following formula (S1), (S2), (S3), (S4) or (S5): 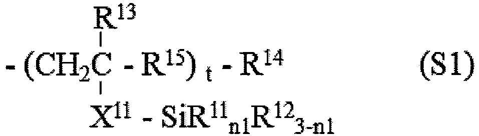
- SiR¹¹ₙ₁R¹²₃₋ₙ₁ (S2)
- SiR^{a1}ₖ₁R^{b1}ₗ₁R^{c1}ₘ₁ (S3)
- CR^{d1}ₖ₂R^{e1}ₗ₂R^{f1}ₘ₂ (S4)
- NR^{g1}R^{h1} (S5)
wherein
R¹¹ is each independently a hydroxyl group or a hydrolyzable group,
R¹² is each independently a monovalent organic group,
n1 is each independently an integer of 0 to 3 for each (SiR¹¹ₙ₁R¹²₃₋ₙ₁) unit,
X¹¹ is each independently a single bond or a divalent organic group,
R¹³ is each independently a hydrogen atom or a monovalent organic group,
t is each independently an integer of 2 or more,
R¹⁴ is each independently a hydrogen atom, a halogen atom or -X¹¹-SiR¹¹ₙ₁R¹²₃₋ₙ₁,
R¹⁵ is each independently a single bond, an oxygen atom, an alkylene group having 1 to 6 carbon atoms or an alkyleneoxy group having 1 to 6 carbon atoms,
R^{a1} is each independently -Z¹-SiR²¹ₚ₁R²²_{q1}R²³ᵣ₁;
Z¹ is each independently a divalent organic group,
R²¹ is each independently -Z^{1'}-SiR^{21'}_{p1'}R^{22'}_{q1'}R^{23'}_{r1'};
R²² is each independently a hydroxyl group or a hydrolyzable group,
R²³ is each independently a monovalent organic group,
p1 is each independently an integer of 0 to 3,
q1 is each independently an integer of 0 to 3,
rl is each independently an integer of 0 to 3,
Z^{1'} is each independently a divalent organic group,
R^{21'} is each independently -Z^{1"}-SiR^{22"}_{q1"}R^{23"}_{r1"};
R^{22'} is each independently a hydroxyl group or a hydrolyzable group,
R^{23'} is each independently a monovalent organic group,
p1' is each independently an integer of 0 to 3,
q1' is each independently an integer of 0 to 3,
r1' is each independently an integer of 0 to 3,
Z^{1"} is each independently a divalent organic group,
R^{22"} is each independently a hydroxyl group or a hydrolyzable group,
R^{23"} is each independently a monovalent organic group,
q1" is each independently an integer of 0 to 3,
r1" is each independently an integer of 0 to 3,
R^{b1} is each independently a hydroxyl group or a hydrolyzable group,
R^{c1} is each independently a monovalent organic group,
k1 is each independently an integer of 0 to 3,
l1 is each independently an integer of 0 to 3,
ml is each independently an integer of 0 to 3,
provided that, in the formula (S3), at least two Si atoms to which a hydroxyl group or a hydrolyzable group is bonded are present,
R^{d1} is each independently -Z²-CR³¹ₚ₂R³²_{q2}R³³ᵣ₂,
Z² is each independently a single bond, an oxygen atom or a divalent organic group,
R³¹ is each independently -Z^{2'}-CR^{32'}_{q2'}R^{33'}_{r2'},
R³² is each independently -Z³-SiR³⁴ₙ₂R³⁵₃₋ₙ₂,
R³³ is each independently a hydrogen atom, a hydroxyl group or a monovalent organic group,
p2 is each independently an integer of 0 to 3,
q2 is each independently an integer of 0 to 3,
r2 is each independently an integer of 0 to 3,
Z^{2'} is each independently a single bond, an oxygen atom or a divalent organic group,
R^{32'} is each independently -Z³-SiR³⁴ₙ₂R³⁵₃₋ₙ₂,
R^{33'} is each independently a hydrogen atom, a hydroxyl group or a monovalent organic group,
q2' is each independently an integer of 0 to 3,
r2' is each independently an integer of 0 to 3,
Z³ is each independently a single bond, an oxygen atom or a divalent organic group;
R³⁴ is each independently a hydroxyl group or a hydrolyzable group,
R³⁵ is each independently a monovalent organic group,
n2 is each independently an integer of 0 to 3,
R^{e1} is each independently -Z³-SiR³⁴ₙ₂R³⁵₃₋ₙ₂,
R^{f1} is each independently a hydrogen atom, a hydroxyl group or a monovalent organic group,
k2 is each independently an integer of 0 to 3,
l2 is each independently an integer of 0 to 3,
m2 is each independently an integer of 0 to 3,
provided that, in the formula (S4), at least two Si atoms to which a hydroxyl group or a hydrolyzable group is bonded are present,
R^{g1} and R^{h1} are each independently -Z⁴-SiR¹¹ₙ₁R¹²₃₋ₙ₁, -Z⁴-SiR^{a1}ₖ₁R^{b1}₁₁R^{c1}ₘ₁, or -Z⁴-CR^{d1}ₖ₂R^{e1}ₗ₂R^{f1}ₘ₂, and
Z⁴ is each independently a single bond, an oxygen atom or a divalent organic group,
provided that, in the formula (S5), at least two Si atoms to which a hydroxyl group or a hydrolyzable group is bonded are present.

7. The composition according to any one of claims 1 to 6, wherein the transition metal is comprised as a transition metal catalyst acting as a catalyst for hydrosilylation.

8. The composition according to claim 7, wherein the transition metal is comprised as one or more selected from a nickel compound, a palladium compound, a platinum compound, a rhodium compound, a ruthenium compound, a cobalt compound and an iron compound.

9. The composition according to any one of claims 1 to 8, wherein the transition metal is comprised as a platinum compound.

10. The composition according to any one of claims 1 to 9, wherein the silane compound comprises a compound selected from the following group:
CH₃-[Si(CH₃)₂O]ₙ₁Si(CH₃)₂-(CH₂)_{H1}-C(=O)NHCH₂CH₂CH₂Si(OCH₃)₃
CH₃CH₂CH₂CH₂-[Si(CH₃)₂O]ₙ₁Si(CH₃)₂-(CH₂)_{H1}-C(=O)NHCH₂CH₂CH₂Si(OCH₃)₃
[(CH₃)₃SiO)]₂(CH₃)Si-O-[Si(CH₃)₂O]ₙ₁Si(CH₃)₂-(CH₂)_{H1}-
C(=O)NHCH₂CH₂CH₂Si(OCH₃)₃
[(CH₃)₃SiO)]₃Si-O-[Si(CH₃)₂O]ₙ₁Si(CH₃)₂-(CH₂)_{H1}- C(=O)NHCH₂CH₂CH₂Si(OCH₃)₃
CH₃-[SiCCH₃)₂O]ₙ₁Si(CH₃)₂-(CH₂)_{H1}-O-(CH₂)_{H2}-C(=O)NHCH₂CH₂CH₂Si(OCH₃)₃
CH₃CH₂CH₂CH₂-[Si(CH₃)₂O]ₙ₁Si(CH₃)₂-(CH₂)_{H1}-O-(CH₂)_{H2}- C(=O)NHCH₂CH₂CH₂Si(OCH₃)₃
CH₃-[Si(CH₃)₂O]ₙ₁Si(CH₃)₂-(CH₂)_{H1}-Si(OCH₃)₃
CH₃CH₂CH₂CH₂-[Si(CH₃)₂O]ₙ₁Si(CH₃)₂-(CH₂)_{H1}-Si(OCH₃)₃
[(CH₃)₃SiO)]₂(CH₃)Si-O-[Si(CH₃)₂O]ₙ₁Si(CH₃)₂-(CH₂)_{H1}-Si(OCH₃)₃
[(CH₃)₃SiO)]₃Si-O-[Si(CH₃)₂O]ₙ₁Si(CH₃)₂-(CH₂)_{H1}-Si(OCH₃)₃
CH₃-[Si(CH₃)₂O]ₙ₁Si(CH₃)₂-(CH₂)_{H1}-C(=O)NHCH₂CH[CH₂CH₂CH₂Si(OCH₃)₃]₂
CH₃CH₂CH₂CH₂-[Si(CH₃)₂O]ₙ₁Si(CH₃)₂-(CH₂)_{H1}- C(=O)NHCH₂CH[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}- C(=O)NHCH₂CH[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}- C(=O)NHCH₂CH[CH₂CH₂CH₂Si(OCH₃)₃]₂
CH₃-[Si(CH₃)₂O]ₙ₁Si(CH₃)₂-(CH₂)_{H1}-O-(CH₂)_{H2}-v C(=O)NHCH₂CH[CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-v C(=O)NHCH₂CH[CH₂CH₂CH₂Si(OCH₃)₃]₂
CH₃-[Si(CH₃)₂O]ₙ₁Si(CH₃)₂-(CH₂)_{H1}-CH[CH₂CH₂CH₂Si(OCH₃)₃]₂
CH₃CH₂CH₂CH₂-[Si(CH₃)₂O]ₙ₁Si(CH₃)₂-(CH₂)_{H1}-CH[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}- CH[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-CH[CH₂CH₂CH₂Si(OCH₃)₃]₂
CH₃-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂
CH₃CH₂CH₂CH₂-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂
[(CH₃)₃SiO)]₃Si-O-[Si(CH₃)₂O]ₙ₁Si(CH₃)₂-(CH₂)_{H1}- C(=O)NHCH₂CH[CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}-O-(CH₂)_{H2}- C(=O)NHCH₂CH[CH₂CH₂CH₂CH₂CH₂CH₂CH₂CH₂CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}- C(=O)NHCH₂CH[CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂
CH₃CH₂CH₂CH₂-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂
[(CH₃)₃SiO)]₃Si-O-[Si(CH₃)₂O]ₙ₁Si(CH₃)₂-(CH₂)_{H1}- CH[CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}-C(=O)N[CH₂CH₂CH₂Si(OCH₃)₃]₂
CH₃CH₂CH₂CH₂-[Si(CH₃)₂O]ₙ₁Si(CH₃)₂-(CH₂)_{H1}-C(=O)N[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}- C(=O)N[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}- C(=O)N[CH₂CH₂CH₂Si(OCH₃)₃]₂
CH₃-[Si(CH₃)₂O]ₙ₁Si(CH₃)₂-(CH₂)_{H1}-O(CH₂)_{H2}-C(=ON[CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}- C(=O)N[CH₂CH₂CH₂Si(OCH₃)₃]₂
CH₃-[Si(CH₃)₂O]ₙ₁Si(CH₃)₂-(CH₂)_{H1}-N[CH₂CH₂CH₂Si(OCH₃)₃]₂
CH₃CH₂CH₂CH₂-[Si(CH₃)₂O]ₙ₁Si(CH₃)₂-(CH₂)_{H1}-N[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}- N[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-N[CH₂CH₂CH₂Si(OCH₃)₃]₂
CH₃-[Si(CH₃)₂O]ₙ₁Si(CH₃)₂-(CH₂)_{H1}-C(=O)NHCH₂C[CH₂CH₂CH₂Si(OCH₃)₃]₃
CH₃CH₂CH₂CH₂-[Si(CH₃)₂O]ₙ₁Si(CH₃)₂-(CH₂)_{H1}- C(=O)NHCH₂C[CH₂CH₂CH₂Si(OCH₃)₃]₃
[(CH₃)₃SiO)]₂(CH₃)Si-O-[Si(CH₃)₂O]ₙ₁Si(CH₃)₂-(CH₂)_{H1}- C(=O)NHCH₂C[CH₂CH₂CH₂Si(OCH₃)₃]₃
[(CH₃)₃SiO)]₃Si-O-[Si(CH₃)₂O]ₙ₁Si(CH₃)₂-(CH₂)_{H1}- C(=O)NHCH₂C[CH₂CH₂CH₂Si(OCH₃)₃]₃
CH₃-[Si(CH₃)₂O]ₙ₁Si(CH₃)₂-(CH₂)_{H1}-O-(CH₂)_{H2}- C(=O)NHCH₂C[CH₂CH₂CH₂Si(OCH₃)₃]₃
CH₃CH₂CH₂CH₂-[Si(CH₃)₂O]ₙ₁Si(CH₃)₂-(CH₂)_{H1}-O-(CH₂)_{H2}- C(=O)NHCH₂C[CH₂CH₂CH₂Si(OCH₃)₃]₃
CH₃-[Si(CH₃)₂O]ₙ₁Si(CH₃)₂-(CH₂)_{H1}-C[CH₂CH₂CH₂Si(OCH₃)₃]₃
CH₃CH₂CH₂CH₂-[Si(CH₃)₂O]ₙ₁Si(CH₃)₂-(CH₂)_{H1}-C[CH₂CH₂CH₂Si(OCH₃)₃]₃
[(CH₃)₃SiO)]₂(CH₃)Si-O-[Si(CH₃)₂O]ₙ₁Si(CH₃)₂-(CH₂)_{H1}- C[CH₂CH₂CH₂Si(OCH₃)₃]₃
[(CH₃)₃SiO)]₃Si-O-[Si(CH₃)₂O]ₙ₁Si(CH₃)₂-(CH₂)_{H1}-C[CH₂CH₂CH₂Si(OCH₃)₃]₃
[(CH₃)₃SiO)]₂(CH₃)Si-(CH₂)_{H1}-C(=O)NHCH₂CH₂CH₂Si(OCH₃)₃
[(CH₃)₃SiO)]₃Si-(CH₂)_{H1}-C(=O)NHCH₂CH₂CH₂Si(OCH₃)₃
[(CH₃)₃SiO)]₂(CH₃)Si-(CH₂)_{H1}-Si(OCH₃)₃
[(CH₃)₃SiO)]₃Si-(CH₂)_{H1}-Si(OCH₃)₃
[(CH₃)₃SiO)]₂(CH₃)Si-(CH₂)_{H1}-C(=O)NHCH₂CH[CH₂CH₂CH₂Si(OCH₃)₃]₂
[(CH₃)₃SiO)]₃Si-(CH₂)_{H1}-C(=O)NHCH₂CH[CH₂CH₂CH₂Si(OCH₃)₃]₂
[(CH₃)₃SiO)]₂(CH₃)Si-(CH₂)_{H1}-CH[CH₂CH₂CH₂Si(OCH₃)₃]₂
[(CH₃)₃SiO)]₃Si-(CH₂)_{H1}-CH[CH₂CH₂CH₂Si(OCH₃)₃]₂
[(CH₃)₃SiO)]₂(CH₃)Si-(CH₂)_{H1}- C(=O)NHCH₂CH[CH₂CH₂CH₂CH₂CH₂CH₂CH₂CH₂CH₂CH₂CH₂Si(OCH₃)₃]₂
[(CH₃)₃SiO)]₃Si-(CH₂)_{H1}- C(=O)NHCH₂CH[CH₂CH₂CH₂CH₂CH₂CH₂CH₂CH₂CH₂CH₂CH₂Si(OCH₃)₃]₂
[(CH₃)₃SiO)]₂(CH₃)Si-(CH₂)_{H1}- CH[CH₂CH₂CH₂CH₂CH₂CH₂CH₂CH₂CH₂CH₂CH₂Si(OCH₃)₃]₂
[(CH₃)₃SiO)]₃Si-(CH₂)_{H1}- CH[CH₂CH₂CH₂CH₂CH₂CH₂CH₂CH₂CH₂CH₂CH₂Si(OCH₃)₃]₂
[(CH₃)₃SiO)]₂(CH₃)Si-(CH₂)_{H1}-C(=O)N[CH₂CH₂CH₂Si(OCH₃)₃]₂
[(CH₃)₃SiO)]₃Si-(CH₂)_{H1}-C(=O)N[CH₂CH₂CH₂Si(OCH₃)₃]₂
[(CH₃)₃SiO)]₂(CH₃)Si-(CH₂)_{H1}-N[CH₂CH₂CH₂Si(OCH₃)₃]₂
[(CH₃)₃SiO)]₃Si-(CH₂)_{H1}-N[CH₂CH₂CH₂Si(OCH₃)₃]₂
[(CH₃)₃SiO)]₂(CH₃)Si-(CH₂)_{H1}-C(=O)NHCH₂C[CH₂CH₂CH₂Si(OCH₃)₃]₃
[(CH₃)₃SiO)]₃Si-(CH₂)_{H1}-C(=O)NHCH₂C[CH₂CH₂CH₂Si(OCH₃)₃]₃
[(CH₃)₃SiO)]₂(CH₃)Si-(CH₂)_{H1}-C[CH₂CH₂CH₂Si(OCH₃)₃]₃
[(CH₃)₃SiO)]₃Si-(CH₂)_{H1}-C[CH₂CH₂CH₂Si(OCH₃)₃]₃ 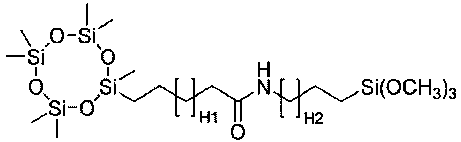 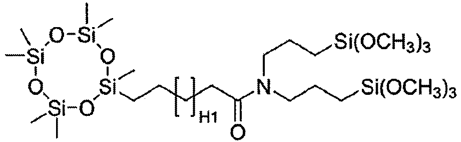 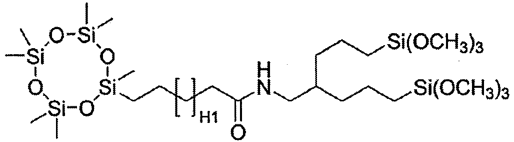 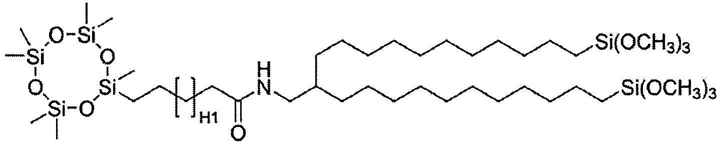 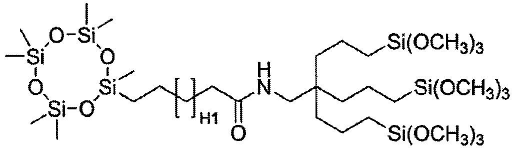
CH₃CH₂CH₂CH₂-[Si(CH₃)₂O]ₙ₁Si(CH₃)₂-(CH₂)_{H1}-O-(CH₂)_{H2}- C(CH₂CH₃)[CH₂OC(=O)NHCH₂CH₂CH₂Si(OCH₃)₃]₂
CH₃-[Si(CH₃)₂O]ₙ₁Si(CH₃)₂-(CH₂)_{H1}-O-(CH₂)_{H2}- C(CH₂CH₃)[CH₂OC(=O)NHCH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}- C(CH₂CH₃)[CH₂OC(=O)NHCH₂CH₂OC(=O)CH(CH₃)CH₂Si(OCH₃)₃]₂
CH₃-[Si(CH₃)₂O]ₙ₁Si(CH₃)₂-(CH₂)_{H1}-O-(CH₂)_{H2}- C(CH₂CH₃)[CH₂OC(=O)NHCH₂CH₂OC(=O)CH(CH₃)CH₂Si(OCH₃)₃]₂
CH₃CH₂CH₂CH₂-[Si(CH₃)₂O]ₙ₁Si(CH₃)₂--(CH₂)_{H1}-O-(CH₂)_{H2}- C[CH₂OC(=O)NHCH₂CH₂CH₂Si(OCH₃)₃]₃
CH₃-[(Si(CH₃)₂O)]ₙ₁Si(CH₃)₂-(CH₂)_{H1}-O-(CH₂)_{H2}- C[CH₂OC(=O)NHCH₂CH₂CH₂Si(OCH₃)₃]₃
[CH₃CH₂CH₂CH₂-[(Si(CH₃)₂O)]ₙ₁Si(CH₃)₂-(CH₂)_{H1}-O-(CH₂)_{H2}-]₂- C[CH₂OC(=O)NHCH₂CH₂CH₂Si(OCH₃)₃]₂
[CH₃-[(Si(CH₃)₂O)]ₙ₁Si(CH₃)₂-(CH₂)_{H1}-O-(CH₂)_{H2}-]₂- C[CH₂OC(=O)NHCH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}- OC(=O)NHCH₂CH₂CH₂Si(OCH₃)₃
CH₃-[Si(CH₃)₂O]ₙ₁Si(CH₃)₂-(CH₂)_{H1}-O-(CH₂)_{H2}-OC(=O)NHCH₂CH₂CH₂Si(OCH₃)₃
CH₃CH₂CH₂CH₂-[Si(CH₃)₂O]ₙ₁Si(CH₃)₂-(CH₂)_{H1}-O-(CH₂)_{H2}- OC(=O)NHCH₂CH₂OC(=O)CH(CH₃)CH₂Si(OCH₃)₃
CH₃-[Si(CH₃)₂O]ₙ₁Si(CH₃)₂-(CH₂)_{H1}-O-(CH₂)_{H2}- OC(=O)NHCH₂CH₂OC(=O)CH(CH₃)CH₂Si(OCH₃)₃
[CH₃CH₂CH₂CH₂-[Si(CH₃)₂O]ₙ₁Si(CH₃)₂-(CH₂)_{H1}-O-(CH₂)_{H2}-]₃C- CH₂OC(=O)NHCH₂CH₂CH₂Si(OCH₃)₃
[CH₃-[Si(CH₃)₂O]ₙ₁Si(CH₃)₂-(CH₂)_{H1}-O-(CH₂)_{H2}-]₃C- CH₂OC(=O)NHCH₂CH₂CH₂Si(OCH₃)₃
[CH₃CH₂CH₂CH₂-[(Si(CH₃)₂O)]ₙ₁Si(CH₃)₂-(CH₂)_{H1}-O- (CH₂)_{H2}-]₂C(CH₂CH₃)[CH₂OC(=O)NHCH₂CH₂CH₂Si(OCH₃)₃]
[CH₃-[(Si(CH₃)₂O)]ₙ₁Si(CH₃)₂-(CH₂)_{H1}-O- (CH₂)_{H2}-]₂C(CH₂CH₃)[CH₂OC(=O)NHCH₂CH₂CH₂Si(OCH₃)₃] 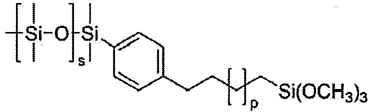 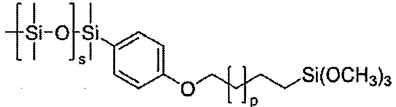 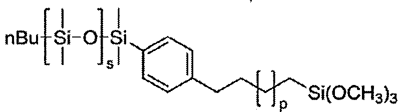 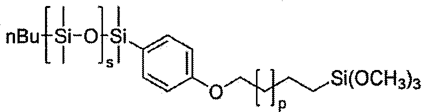 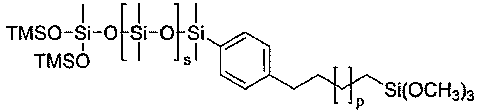 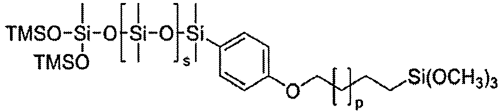 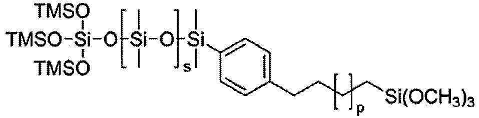 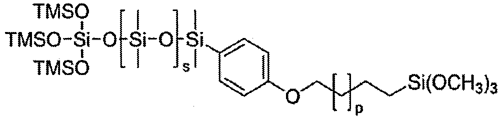 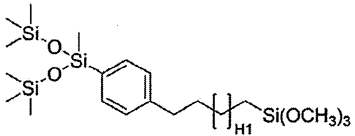 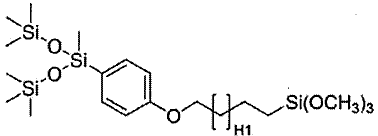 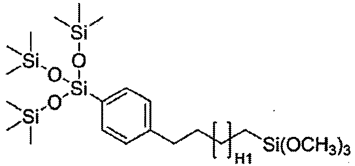 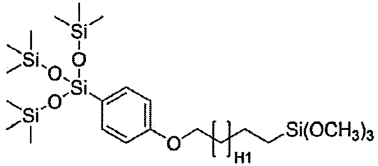 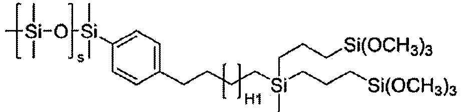 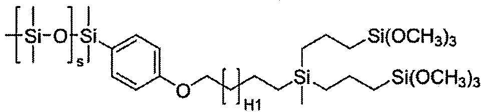 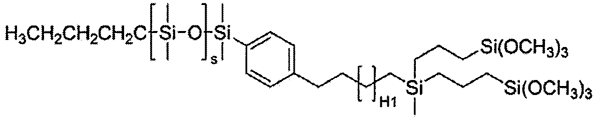 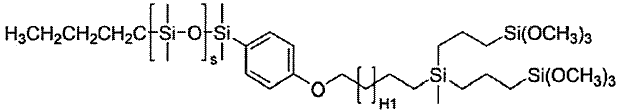 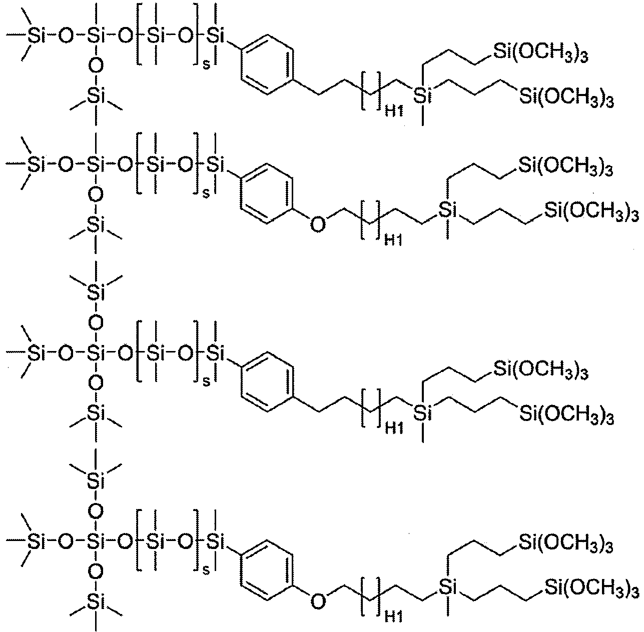 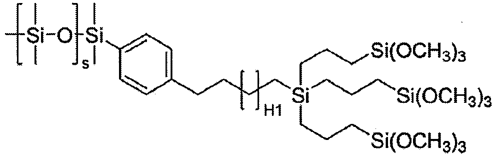 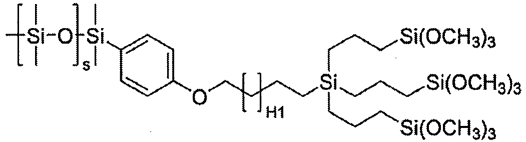 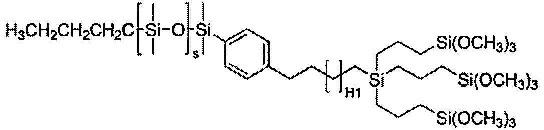 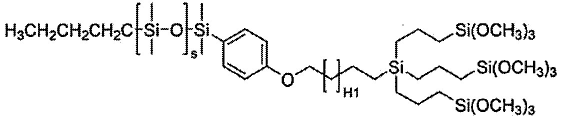 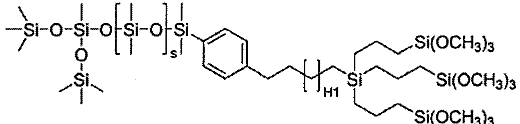 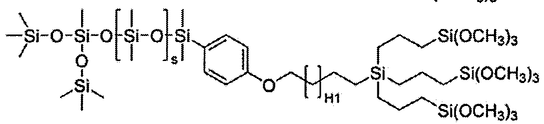 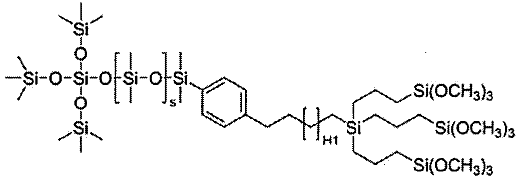 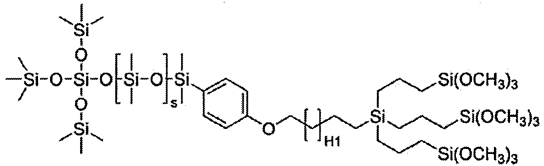
wherein TMS represents a trimethylsilyl group, n1 and s are each independently an integer of 0 to 150, and p, H1 and H2 are each independently an integer of 1 to 50.

11. The composition according to claim 10, wherein
n1 and s are each independently 0 or 1,
p and H1 are each independently 8 to 40, and
H2 is each independently an integer of 1 to 10.

12. The composition according to claim 10, wherein
n1 and s are each independently 5 to 100,
p and H1 are each independently 8 to 40, and
H2 is each independently an integer of 1 to 10.

13. The composition according to any one of claims 1 to 12, wherein the silane compound comprises a compound selected from the following group, wherein n is each independently 10 to 80:
(CH₃CH₂CH₂CH₂Si(CH₃)₂-(OSi(CH₃)₂)ₙ-CH₂CH₂Si(CH₂CH₂CH₂Si(OCH₃)₃)₃
(CH₃)₃Si-(OSi(CH₃)₂)ₙ-(CH₂)₁₀-CONH-CH₂C{CH₂CH₂CH₂Si(OCH₃)₃}₃
(CH₃)₃Si-(OSi(CH₃)₂)ₙ-(CH₂)₂₂-CONH-CH₂CH[CH₂CH₂CH₂Si(OCH₃)₃]₂
(CH₃CH₂CH₂CH₂Si(CH₃)₂-(OSi(CH₃)₂)ₙ-(CH₂)₃-OCH₂-CONH- CH₂C{CH₂CH₂CH₂Si(OCH₃)₃}₃
CH₃CH₂CH₂CH₂Si(CH₃)₂-(OSi(CH₃)₂)ₙ-(CH₂)₂₂-CONH-CH₂CH₂CH₂Si(OCH₃)₃
(CH₃)₃Si-(OSi(CH₃)₂)ₙ-(CH₂)₁₀-CON{CH₂CH₂CH₂Si(OCH₃)₃}₂
(CH₃)₃Si-(OSi(CH₃)₂)ₙ-(CH₂)₂₂-CON[CH₂CH₂CH₂Si(OCH₃)₃]₂
(CH₃)₃Si-(OSi(CH₃)₂)ₙ-(CH₂)₂₂-CON[CH₂CH₂CH₂Si(OCH₃)₃]₂
(CH₃)₃Si-(OSi(CH₃)₂)ₙ-(CH₂)₂₂-CON((CH₂)₃Si(OCH₃)₃)₂
CH₃CH₂CH₂CH₂Si(CH₃)₂-(CH₂CH₂CH₂Si(CH₃)₂)ₙ-CH₂CH₂CH₂- Si(CH₂CH₂CH₂Si(OCH₃)₃)₃
[(CH₃)₃SiO]₂CH₃Si-(OSi(CH₃)₂)ₙ-(CH₂)₂₂-CONH-CH₂CH[CH₂CH₂CH₂Si(OCH₃)₃]₂

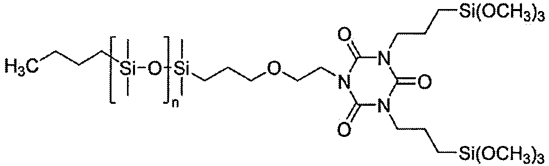

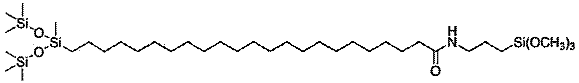

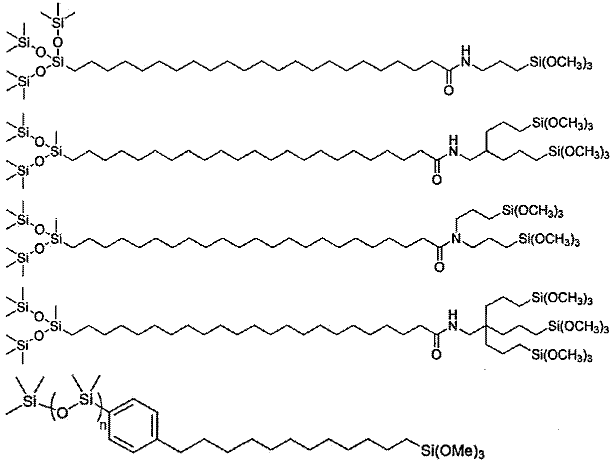

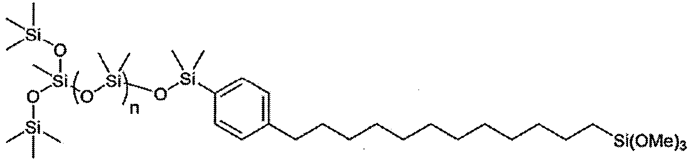

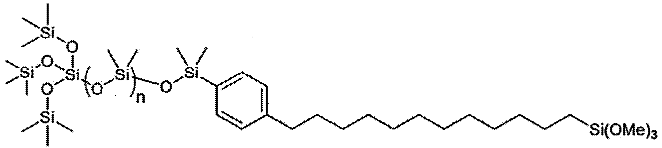

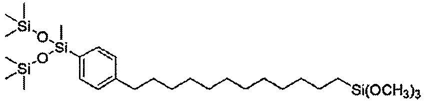

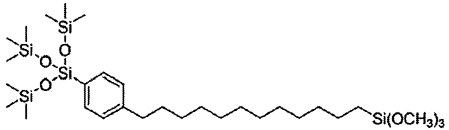

14. The composition according to any one of claims 1 to 13, wherein the transition metal is comprised as a platinum(0)-1,3-divinyl-1,1,3,3-tetramethyldisiloxane complex.

15. A surface-treating agent comprising the composition according to any one of claims 1 to 14.

16. The surface-treating agent according to claim 15, comprising a condensate of the silane compound comprised in the composition according to any one of claims 1 to 14.

17. The surface-treating agent according to claim 15 or 16, which is for vacuum deposition.

18. The surface-treating agent according to claim 15 or 16, which is for wet coating.

19. A pellet comprising the surface-treating agent according to any one of claims 15 to 18.
[Claim 20]

20. An article comprising a substrate and a layer on the substrate, wherein the layer is formed from the surface-treating agent according to any one of claims 15 to 19.

21. The article according to claim 20, comprising, between the substrate and the aforementioned layer, a silicon oxide-containing intermediate layer.

22. The article according to claim 21, wherein the intermediate layer comprises an alkali metal atom.

23. The article according to claim 20, wherein the alkali metal atom is at least partially a sodium atom.

24. The article according to any one of claims 20 to 23, which is an optical member.

25. The article according to any one of claims 20 to 24, which is a display.
